# EUROPEAN PATENT APPLICATION

(11) **EP 2 891 892 A2**
(43) Date of publication of application: **08.07.2015**
(21) Application number: 14199233.9
(22) Date of filing: 19.12.2014
(51) Int. Cl.: G01R 33/00, G01R 33/09, G01R 15/20, G01R 22/06

(54) **Current sesnor, current measuring module, and smart meter**

(30) Priority: 25.12.2013 JP 2013268065
(71) Applicant: Kabushiki Kaisha Toshiba, Tokyo 105-8001 (JP)
(72) Inventor: Fuji, Yoshihiko, Tokyo 105-8001 (JP); Fukuzawa, Hideaki, Tokyo 105-8001 (JP); Higashi, Yoshihiro, Tokyo 105-8001 (JP); Wamura, Tetsuro, Tokyo 105-8001 (JP); Shibano, Motomichi, Tokyo 105-8001 (JP)
(74) Representative: Hoffmann Eitle

(57) **Abstract**

A current sensor comprises a plurality of magneotresistance elements and a first magnetic body. The plurality of magneotresistance elements each have their resistance value change by being applied with an current-induced magnetic field from a current to be measured. The first magnetic body applies a first offset magnetic field substantially parallel to the current-induced magnetic field applied to a first magneotresistance element of the plurality of magneotresistance elements. Moreover, a smart meter according to an embodiment of the present invention has, for example, the current sensor according to the present embodiment installed therein.

## Description

### CROSS REFERENCE TO RELATED APPLICATIONS

This application is based on and claims the benefit of priority from prior Japanese prior Patent Application NO. 2013-268065, filed on December 25, 2013, the entire contents of which are incorporated herein by reference.

### FIELD

The present embodiments relate to a current sensor, a current measuring module, and a smart meter in which these are installed.

### BACKGROUND

In recent years, the introduction of smart meters which are next-generation watt-hour meters that measure electric power digitally and are provided with a communications function within the meter, has continued to be promoted with the object of stability, efficiency, and so on, of electric power supply and demand. There is a need for a current sensor that achieves the broad dynamic range and high resolution that are required in a smart meter, with low power consumption.

In order to achieve a high resolution current sensor, it is effective to employ a magneotresistance element having high sensitivity to a magnetic field. Moreover, in order to obtain both high resolution and broad dynamic range, a magnetic balance system current sensor employing a magneotresistance element has been proposed. However, in the magnetic balance system, when a current to be measured becomes large, it is necessary to generate in a coil a cancelling magnetic field of the same magnitude as a large current-induced magnetic field generated by the current to be measured. In this case, a current passed through the coil to generate the cancelling magnetic field increases proportionately to a magnitude of the current to be measured, hence there is a problem that in the case of a large current to be measured, power consumption of the current sensor itself ends up increasing.

### BRIEF DESCRIPTION OF THE DRAWINGS

Fig. 1A and 1B are a schematic view showing an example of configuration of a current sensor according to a first embodiment.
Fig. 2 is a schematic perspective view illustrating a schematic configuration of a magneotresistance element according to the same embodiment.
Fig. 3A to 3D are a schematic view for explaining a function of the magneotresistance element according to the same embodiment.
Fig. 4A and 4B are a schematic view explaining achievement of high resolution and broad dynamic range by the current sensor according to the same embodiment.
Fig. 5A to 5D are a schematic perspective view illustrating the magneotresistance element according to the same embodiment.
Fig. 6 is a schematic perspective view illustrating a first magneotresistance element 100E according to another configuration of the same embodiment.
Fig. 7A to 7E are a schematic perspective view and a characteristics of a first magneotresistance element 100F according to another configuration of the same embodiment.
Fig. 8A to 8C are a schematic view of a first magneotresistance element 100 and a first offset magnetic body 150A according to the same embodiment.
Fig. 9A to 9C are a schematic view of the first magneotresistance element 100 and a first offset magnetic body 150B according to the same embodiment.
Fig. 10A to 10C are a schematic view showing an example of configuration of the current sensor according to the same embodiment.
Fig. 11A to 11C are a schematic view showing another example of configuration of the current sensor according to the same embodiment.
Fig. 12 is a schematic view showing another example of configuration of the current sensor according to the same embodiment.
Fig. 13A to 13C are a schematic view showing another example of configuration of the current sensor according to the same embodiment.
Fig. 14A to 14B are a schematic view showing another example of configuration of the current sensor according to the same embodiment.
Fig. 15A and 15B are a schematic view showing an example of configuration of the current sensor according to the same embodiment.
Fig. 16A and 16B show a schematic view of the first magneotresistance element 100 and a first offset magnetic body 150G according to the same embodiment.
Fig. 17A to 17J are a schematic perspective view illustrating a manufacturing method of the current sensor according to the same embodiment.
Fig. 18A to 18J are a schematic perspective view illustrating another manufacturing method of the current sensor according to the same embodiment.
Fig. 19A to 19C are a schematic view showing another example of configuration of the current sensor according to the same embodiment.
Fig. 20A and 20B are a schematic view showing a configuration of a current sensor according to a second embodiment.
Fig. 21A and 21B are a schematic view showing a configuration of a current sensor according to another configuration of the same embodiment.
Fig. 22A and 22B are a schematic view showing a configuration of a current sensor according to another configuration of the same embodiment.
Fig. 23A and 23B are a schematic view showing a configuration of a current sensor according to a third embodiment.
Fig. 24 is a schematic view showing a configuration of a current sensor according to a fourth embodiment.
Fig. 25 is a circuit block diagram showing a configuration of a current sensor according to a fifth embodiment.
Fig. 26 is a circuit diagram showing a configuration of a comparator 630 of the current sensor according to the same embodiment.
Fig. 27 is a graph showing characteristics of a plurality of measurement-dedicated magneotresistance elements 610 and a reference magneotresistance element 620 of the current sensor according to the same embodiment.
Fig. 28 is a truth table of control signals of the current sensor according to the same embodiment.
Fig. 29 is a circuit block diagram for explaining operation of a memory 680 of the current sensor according to the same embodiment.
Fig. 30 is a circuit block diagram showing a configuration of a current sensor according to a sixth embodiment.
Fig. 31 is a circuit diagram showing a configuration of a comparator 639 of the current sensor according to the same embodiment.
Fig. 32 is a graph showing characteristics of a plurality of measurement-dedicated magneotresistance elements 610 of the current sensor according to the same embodiment.
Fig. 33A to 33D are a circuit diagram showing an example of configuration of the measurement-dedicated magneotresistance element 610 of the same current sensor.
Fig. 34 is a schematic view showing outer appearance of a smart meter 700 according to an embodiment.
Fig. 35 is a functional block diagram showing a schematic configuration of the same smart meter 700.
Fig. 36 is a schematic view showing an example of arrangement of a current sensor 600 inside a housing 710 of the same smart meter 700.
Fig. 37A and 37B is a schematic view showing the same example of arrangement.
Fig. 38 is a schematic view showing another example of arrangement of the current sensor 600 inside the housing 710 of the same smart meter 700.
Fig. 39 is a schematic view showing the same example of arrangement.
Fig. 40A and 40B are a schematic view showing another example of arrangement of the current sensor 600 inside the housing 710 of the same smart meter 700.
Fig. 41A and 41B are a schematic view showing the same example of arrangement.
Fig. 42 is a schematic view showing another example of arrangement of the current sensor 600 inside the housing 710 of the same smart meter 700.
Fig. 43 is a schematic view showing the same example of arrangement.
Fig. 44 is a schematic view of a household electrical appliance in which the current sensor according to any of the above-described embodiments is installed.

### DETAILED DESCRIPTION

A current sensor according to an embodiment comprises a plurality of magneotresistance elements and a first magnetic body. The plurality of magneotresistance elements each have their resistance value change by being applied with an current-induced magnetic field from a current to be measured. The first magnetic body applies a first offset magnetic field substantially parallel to the current-induced magnetic field applied to a first magneotresistance element of the plurality of magneotresistance elements. Moreover, a smart meter according to an embodiment has, for example, the current sensor according to the present embodiment installed therein.

Next, a nonvolatile semiconductor memory device according to embodiments will be described based on the drawings.

### [FIRST EMBODIMENT]

### [1. Current Sensor according to First Embodiment]

### [1-1. Overall Configuration]

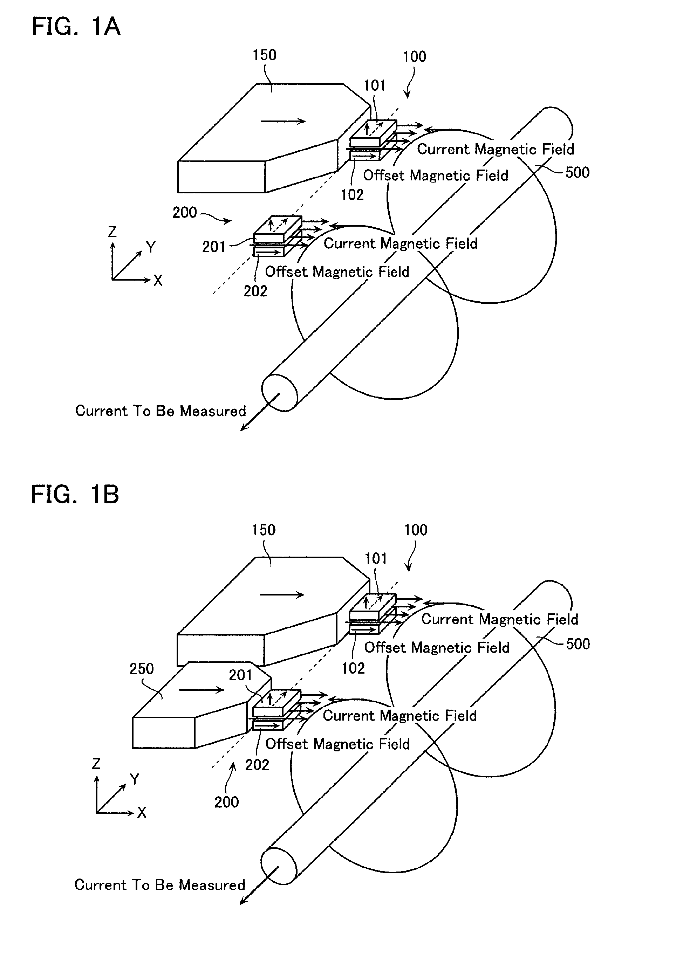

Figs. 1A and 1B are schematic views showing examples of configuration of a current sensor according to a first embodiment. The current sensor shown in Fig. 1A includes: a first magneotresistance element 100 that is disposed close to a wiring line 500 and that has a resistance value that changes by application of an current-induced magnetic field from a measurement current flowing in this wiring line 500; a second magneotresistance element 200; and a first offset magnetic body 150. The first magneotresistance element 100 and second magneotresistance element 200 respectively include: first magnetic layers 101 and 201 acting as magnetization free layers; and magnetization fixed layers 102 and 202. The first offset magnetic body 150 applies a first offset magnetic field to the first magneotresistance element 100 from a direction substantially parallel to the current-induced magnetic field from the measurement current. Employing such a form of current sensor makes it possible to achieve high-precision measurement of a wide range of current values, with low power consumption.

In addition, the current sensor shown in Fig. 1B includes: the first magneotresistance element 100 that is disposed close to the wiring line 500 and that has a resistance value that changes by application of the current-induced magnetic field from the measurement current flowing in this wiring line 500; the second magneotresistance element 200; the first offset magnetic body 150; and a second offset magnetic body 250. The first offset magnetic body 150 applies the first offset magnetic field to the first magneotresistance element 100 from the direction substantially parallel to the current-induced magnetic field from the measurement current. The second offset magnetic body 250 applies a second offset magnetic field to the second magneotresistance element 200 from a direction substantially parallel to the current-induced magnetic field from the measurement current. The first offset magnetic field applied to the first magneotresistance element 100 and the second offset magnetic field applied to the second magneotresistance element 200 have different intensities. Employing such a form of current sensor makes it possible to achieve high-precision measurement of a wide range of current values, with low power consumption.

In the current sensors of Figs. 1A and 1B, the magneotresistance elements 100 and 200 applied with two different offset magnetic fields were illustrated, but magneotresistance elements applied with a plurality of three or more different offset magnetic fields may be employed. The number of magneotresistance elements whose offset magnetic fields are changed may be appropriately adjusted according to current range of a measurement target and required measurement resolution.

Moreover, a current sensor combining Figs. 1A and 1B may be employed. That is, a magneotresistance element not applied with an offset magnetic field and magneotresistance elements applied with two or more different offset magnetic fields may be employed. Note that in Figs. 1A and 1B, current detection circuits, and so on, are not illustrated, but such circuits may be changed appropriately.

### [1-2. Operating Principle]

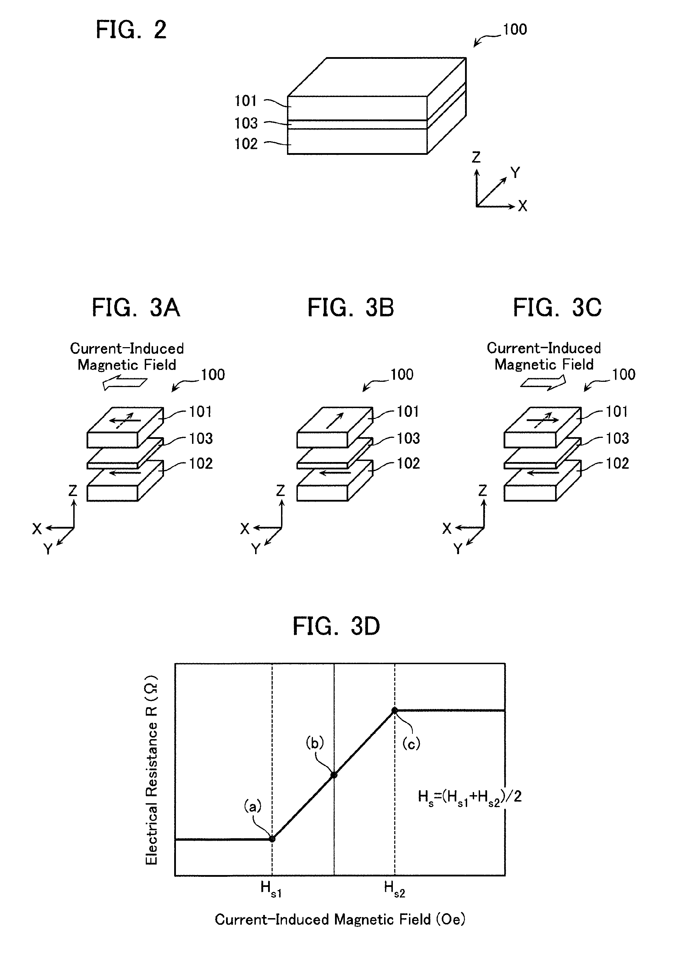

Fig. 2 is a schematic perspective view illustrating a schematic configuration of the magneotresistance element used in the present embodiment. For example, the first magneotresistance element 100 includes: a first magnetic layer 101; a second magnetic layer 102; an intermediate layer 103 provided between the first magnetic layer and the second magnetic layer; and an electrode layer not illustrated. Note that the second magneotresistance element 200 is configured substantially similarly to the first magneotresistance element 100.

The intermediate layer 103 is a non-magnetic layer. The first magnetic layer 101 is, for example, a magnetization free layer whose magnetization freely changes. The second magnetic layer 102 is, for example, a magnetization fixed layer whose magnetization is fixed.

The first magneotresistance element 100 is a GMR (Giant Magneto Resistance) element if the intermediate layer 103 is formed by a conductive material, and is a TMR (Tunneling Magneto Resistance) element if the intermediate layer 103 is formed by an insulating material. In the case of being a GMR element, the first magneotresistance element 100 may be a CPP-GMR element where current flows in a direction perpendicular to a film surface, and may be a CIP-GMR element where current flows in a direction along a film surface. In the case that the first magneotresistance element 100 is a TMR element, current flows in a direction perpendicular to a film surface. Moreover, the first magneotresistance element 100 may be an AMR element.

Fig. 3A to 3B are a schematic view explaining a function of a magnetic field being detected by the magneotresistance element used in the present embodiment. Description hereafter exemplifies the case where the first magnetic layer 101 is a magnetization free layer, and the second magnetic layer 102 is a magnetization fixed layer.

The function of detecting a magnetic field by the magneotresistance element is based on the "MR effect". The "MR effect" appears in a stacked film of the first magnetic layer 101, the intermediate layer 103, and the second magnetic layer 102. The "MR effect" is a phenomenon that when an external magnetic field is applied in a stacked film including a magnetic body, a value of electrical resistance of the stacked film changes due to a change in magnetization of the magnetic body.

As shown in Fig. 3B, in an initial state when the current-induced magnetic field is not applied to the first magneotresistance element 100, magnetization directions of the first magnetic layer 101 and the second magnetic layer 102 have certain angles. The magnetization direction of the second magnetic layer 102 is fixed by the likes of an antiferromagnetic layer adjacent in a stacking direction as will be described later, and the magnetization direction of the first magnetic layer 101 is set to a certain inclination by, for example, a later-described linear response magnetic body, and so on, or a direction of a magnetic field during annealing.

As shown in Figs. 3A and 3C, the magnetization direction of the first magnetic layer 101 changes by the current-induced magnetic field being applied to the first magneotresistance element 100. As a result, a relative angle of the magnetization directions of the first magnetic layer 101 and the second magnetic layer 102 changes.

When a current is passed through the first magneotresistance element 100, the change in the relative angle of the magnetization directions appears as a resistance change. When resistance of a low-resistance state is assumed to be R, and an amount of change in electrical resistance changing by the MR effect is assumed to be ΔR, then ΔR/R is referred to as "MR ratio". When a positive magneotresistance effect occurs due to the combination of materials of the first magnetic layer 101, the intermediate layer 103, and the second magnetic layer 102, the electrical resistance decreases with decrease in the relative angle of the magnetization directions of the first magnetic layer 101 and the second magnetic layer 102. On the other hand, when a negative magneotresistance effect occurs due to the combination of materials of the first magnetic layer 101, the intermediate layer 103, and the second magnetic layer 102, the electrical resistance increases with decrease in the relative angle of the magnetization directions of the first magnetic layer 101 and the second magnetic layer 102.

In the example shown in Fig. 3D, a positive magneotresistance effect is exemplified. In a magneotresistance element such as a GMR element or a TMR element, the "MR ratio" is extremely large, hence sensitivity to a magnetic field is high compared to in a Hall element. Moreover, as illustrated in Fig. 3D, the magneotresistance element has a dynamic range with respect to the magnetic field that assumes a minimum value of resistance when the magnetization free layer and magnetization fixed layer are parallel and a maximum value of resistance when the magnetization free layer and magnetization fixed layer are antiparallel. As shown in Fig. 3D, the dynamic range of the magneotresistance element is defined by 2Hs.

### [1-3. Advantages]

In the current sensor according to the present embodiment, high resolution and a broad dynamic range can be achieved by using a plurality of magneotresistance elements 100 and 200 whose offset magnetic fields are changed. Moreover, the offset magnetic field is applied statically by employing a permanent magnetic material as the first offset magnetic body 150, hence does not require electric power. Therefore, achievement is made possible with low power consumption.

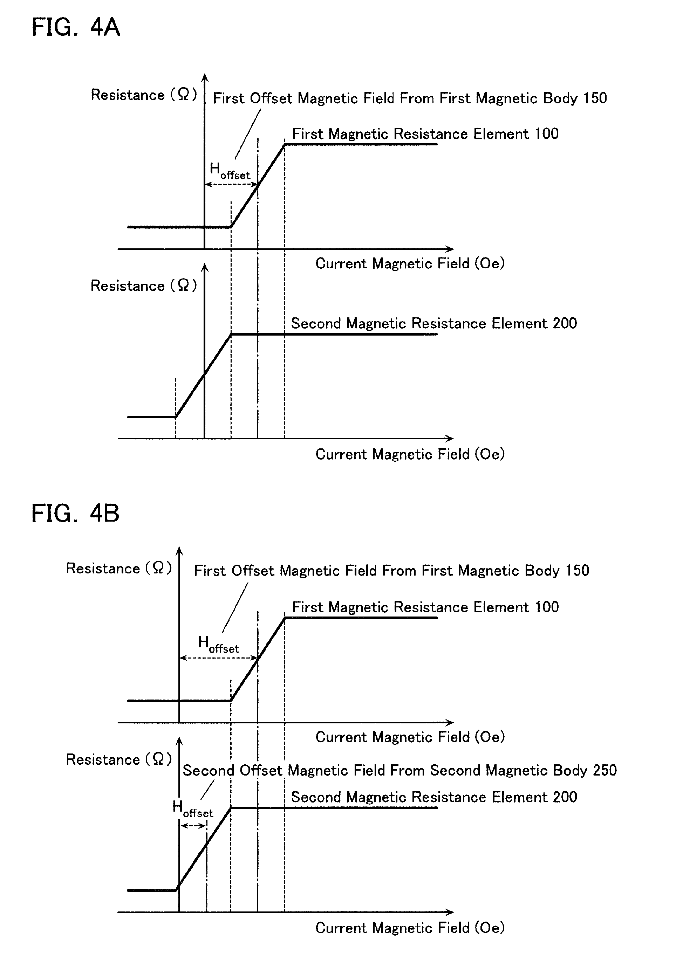

Fig. 4A and 4B are a schematic view explaining achievement of high resolution and broad dynamic range by the current sensor according to the present embodiment. Fig. 4A shows change in electrical resistance of the first magneotresistance element 100 and the second magneotresistance element 200 shown in Fig. 1A when applied with the current-induced magnetic field due to the current to be measured of the current sensor. The second magneotresistance element 200 shows linear change of electrical resistance with respect to a positive/negative current-induced magnetic field applied from external by the principle shown in Fig. 3D, and has high sensitivity. A range of an external magnetic field of the kind where electrical resistance changes with respect to change in the external magnetic field in this way is referred to below as measurement range of the magneotresistance element. On the other hand, in the first magneotresistance element 100, the current-induced magnetic field that changes the electrical resistance is offset (for example, canceled out) caused by the offset magnetic field due to the first offset magnetic body 150. Combining two or more such magneotresistance elements makes it possible to provide magneotresistance elements responsive to different ranges of current-induced magnetic fields and raise sensitivity of the respective magneotresistance elements to match a required resolution of the current sensor. Hence, by detecting the responsive range of the current-induced magnetic field separately by a plurality of magneotresistance elements, a broad dynamic range and high resolution can be achieved for a required dynamic range of the induced current. Moreover, by employing a permanent magnetic material such as a hard magnetic layer (hard ferromagnetic material) for the first offset magnetic body 150 applying the offset magnetic field to the first magneotresistance element 100, the offset magnetic field is applied statically, hence there is no increase in a consumed amount of electric power due to using this mechanism, and low power consumption can be achieved.

Fig. 4B shows change in electrical resistance of the first magneotresistance element 100 and the second magneotresistance element 200 shown in Fig. 1B when applied with the current-induced magnetic field due to the current to be measured of the current sensor. In the first and second magneotresistance elements 100 and 200, the current-induced magnetic field that changes the electrical resistance is offset caused by the offset magnetic field due to the first offset magnetic body 150 and the second offset magnetic body 250. Moreover, setting the first offset magnetic field and the second offset magnetic field to be different and combining two or more of these magneotresistance elements makes it possible to provide magneotresistance elements responsive to different current-induced magnetic fields and raise sensitivity of the respective magneotresistance elements to match a required resolution of the current sensor. Hence, by detecting the responsive range of the current-induced magnetic field separately by a plurality of magneotresistance elements, a broad dynamic range and high resolution can be achieved for a required dynamic range of the induced current. Moreover, by employing a permanent magnetic material such as a hard magnetic layer (hard ferromagnetic material) for the first and second offset magnetic bodies 150 and 250 applying the offset magnetic field to the first and second magneotresistance elements 100 and 200, the offset magnetic field is applied statically, hence there is no increase in a consumed amount of electric power due to using this mechanism, and low power consumption can be achieved.

Employing the structures shown in Figs. 1A, 1B and 4A, 4B makes it possible to provide a current sensor that comprises the first magneotresistance element 100 and the second magneotresistance element 200 whose resistance values change due to application of the current-induced magnetic field from a current to be measured. In this current sensor, an intermediate value of the range of the current-induced magnetic field sensed by the first magneotresistance element 100is different from an intermediate value of the range of the current-induced magnetic field sensed by the second magneotresistance element 200.

Employing the structures shown in Figs. 1A, 1B and 4A, 4B makes it possible to provide a current sensor that comprises a plurality of magneotresistance elements whose resistance values change due to application of the current-induced magnetic field from a current to be measured, in which current sensor the current-induced magnetic fields at which the resistance values of the magneotresistance elements attain intermediate values differ according to the magneotresistance elements.

### [Example of Configuration of Magneotresistance Element]

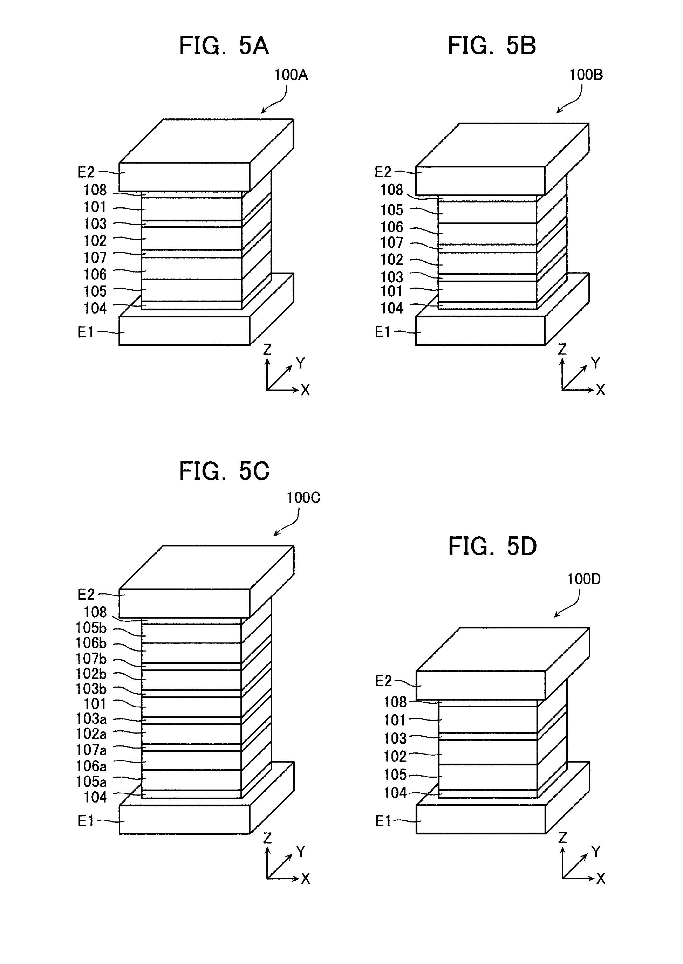

An example of configuration of the magneotresistance element according to the present embodiment will be described below. Figs. 5A to 5D are schematic perspective views illustrating the magneotresistance element used in the current sensor according to the present embodiment. Note that below, a description of "material A/material B" indicates a state where a layer of material B is provided on a layer of material A. Note that in the description below, the first magneotresistance element 100 will be taken as an example, but the second magneotresistance element 200 may also be similarly configured, and when magneotresistance elements are further provided, these may also be similarly configured.

Fig. 5A is a schematic perspective view illustrating a first magneotresistance element 100A used in a certain embodiment. As indicated in Fig. 5A, the first magneotresistance element 100A includes, aligned sequentially therein: a lower electrode E1; a under-layer 104; a pinning layer 105; a second magnetization fixed layer 106; a magnetic coupling layer 107; the second magnetic layer 102; the intermediate layer 103; the first magnetic layer 101; a cap layer 108; and an upper electrode E2.

In this example, the first magnetic layer 101 functions as a magnetization free layer, and the second magnetic layer 102 functions as a first magnetization fixed layer. The first magneotresistance element 100A of Fig. 5A is called a bottom spin valve type.

Employed in the under-layer 104 is, for example, Ta/Ru. A thickness (length in a Z axis direction) of a Ta layer thereof is, for example, 3 nm. A thickness of a Ru layer thereof is, for example, 2 nm. Employed in the pinning layer 105 is, for example, an IrMn layer having a thickness of 7 nm. Employed in the second magnetization fixed layer 106 is, for example, a Co₇₅Fe₂₅ layer having a thickness of 2.5 nm. Employed in the magnetic coupling layer 107 is, for example, a Ru layer having a thickness of 0.9 nm. Employed in the first magnetization fixed layer 102 is, for example, a C0₄₀Fe₄₀B₂₀ layer having a thickness of 3 nm. Employed in the intermediate layer 103 is, for example, a MgO layer having a thickness of 1.6 nm. Employed in the first magnetic layer 101 is, for example, Co₄₀Fe₄₀B₂₀/Ni₈₀Fe₂₀. A stacked body of C0₄₀Fe₄₀B₂₀ having a thickness of 2 nm and Ni₈₀Fe₂₀ having a thickness of 8 nm is employed. Employed in the cap layer 108 is, for example, Ta/Ru. A thickness of a Ta layer thereof is, for example, 1 nm. A thickness of a Ru layer thereof is, for example, 5 nm.

Employed in the lower electrode E1 and the upper electrode E2 is, for example, at least one of aluminum (Al), an aluminum copper alloy (Al-Cu), copper (Cu), silver (Ag), and gold (Au). Employing such materials having a comparatively small electrical resistance as the lower electrode E1 and the upper electrode E2 makes it possible to pass a current efficiently through the first magneotresistance element 100A.

The lower electrode E1 may have a structure in which a layer of at least one of Al, Al-Cu, Cu, Ag, and Au is provided between a lower electrode E1-dedicated under-layer (not illustrated) and cap layer (not illustrated). For example, employed in the lower electrode E1 is the likes of tantalum (Ta)/copper (Cu)/tantalum (Ta). Employing Ta as the lower electrode E1-dedicated under-layer makes it possible to improve adhesion between layers configuring the lower electrode E1, for example. Titanium (Ti) or titanium nitride (TiN) may be employed as the lower electrode E1-dedicated under-layer. Employing tantalum Ta as the lower electrode E1-dedicated cap layer makes it possible to avoid oxidation of the likes of copper (Cu) below that cap layer. Titanium (Ti) or titanium nitride (TiN) may be employed as the lower electrode E1-dedicated cap layer.

A stacked structure of a buffer layer (not illustrated) and a seed layer (not illustrated) may be employed in the under-layer 104. This buffer layer eases surface roughness of the lower electrode E1 and improves crystallinity of a layer stacked on the buffer layer, for example. Employed as the buffer layer is, for example, at least one selected from the group configured from tantalum (Ta), titanium (Ti), vanadium (V), tungsten (W), zirconium (Zr), hafnium (Hf), and chrome (Cr). An alloy including at least one material selected from these materials may be employed as the buffer layer.

A thickness of the buffer layer is preferably not less than 1 nm and not more than 10 nm. The thickness of the buffer layer is more preferably not less than 1 nm and not more than 5 nm. If the buffer layer is too thin, a buffer effect is lost. If the buffer layer is too thick, the first magneotresistance element 100A becomes excessively thick. The seed layer is formed on the buffer layer, and that seed layer may have a buffer effect. The buffer layer may be omitted. Employed in the buffer layer is, for example, a Ta layer having a thickness of 3 nm.

The seed layer not illustrated controls crystalline orientation of a layer stacked on the seed layer. The seed layer controls grain size of the layer stacked on the seed layer. Employed as the seed layer are the likes of a metal of fcc structure (Face-Centered Cubic Structure), hcp structure (Hexagonal Close-Packed Structure), or bcc structure (Body-Centered Cubic Structure).

Employing ruthenium (Ru) of hcp structure, NiFe of fcc structure, or Cu of fcc structure as the seed layer makes it possible to set the crystalline orientation of a spin valve film on the seed layer to an fcc (111) orientation. Employed in the seed layer is, for example, a Cu layer having a thickness of 2 nm, or a Ru layer having a thickness of 2 nm. When raising crystalline orientation of the layer formed on the seed layer, a thickness of the seed layer is preferably not less than 1 nm and not more than 5 nm. The thickness of the seed layer is more preferably not less than 1 nm and not more than 3 nm. As a result, a function as a seed layer of improving crystalline orientation is sufficiently displayed. On the other hand, when, for example, there is no need to cause crystalline orientation of the layer formed on the seed layer (when, for example, forming an amorphous magnetization free layer, and so on), the seed layer may be omitted. Employed as the seed layer is, for example, a Ru layer having a thickness of 2 nm.

The pinning layer 105 gives unidirectional anisotropy to a ferromagnetic layer formed on the pinning layer 105, and thereby fixes magnetization of the ferromagnetic layer. In the example shown in Fig. 5A, the pinning layer 105 gives unidirectional anisotropy to a ferromagnetic layer of the second magnetization fixed layer 106 formed on the pinning layer 105, and thereby fixes magnetization of the ferromagnetic layer. Employed in the pinning layer 105 is, for example, an antiferromagnetic layer. Employed in the pinning layer 105 is, for example, at least one selected from the group configured from Ir-Mn, Pt-Mn, Pd-Pt-Mn, Ru-Mn, Rh-Mn, Ru-Rh-Mn, Fe-Mn, Ni-Mn, Cr-Mn-Pt, and Ni-O. It is also possible to employ an alloy having an additional element further added to the Ir-Mn, Pt-Mn, Pd-Pt-Mn, Ru-Mn, Rh-Mn, Ru-Rh-Mn, Fe-Mn, Ni-Mn, Cr-Mn-Pt, and Ni-O. A thickness of the pinning layer 105 is appropriately set to give sufficiently strong unidirectional anisotropy.

In order to perform fixing of magnetization of the ferromagnetic layer contacting the pinning layer 105, heat treatment during magnetic field application is performed. Magnetization of the ferromagnetic layer contacting the pinning layer 105 is fixed in a direction of the magnetic field applied during the heat treatment. Annealing temperature is set to, for example, a temperature higher than a magnetization fixing temperature of an antiferromagnetic material employed in the pinning layer 105. Moreover, when an antiferromagnetic layer including Mn is employed, Mn sometimes diffuses to a layer other than the pinning layer 105 to lower the MR ratio. Hence, the annealing temperature is preferably set to not more than a temperature at which diffusion of Mn occurs. The annealing temperature may be set to, for example, not less than 200°C and not more than 500°C. Preferably, it may be set to, for example, not less than 250°C and not more than 400°C.

When Pt-Mn or Pd-Pt-Mn are employed as the pinning layer 105, the thickness of the pinning layer 105 is preferably not less than 8 nm and not more than 20 nm. The thickness of the pinning layer 105 is more preferably not less than 10 nm and not more than 15 nm. When IrMn is employed as the pinning layer 105, unidirectional anisotropy may be given by a pinning layer 105 which is thinner than when PtMn is employed as the pinning layer 105. In this case, the thickness of the pinning layer 105 is preferably not less than 4 nm and not more than 18 nm. The thickness of the pinning layer 105 is more preferably not less than 5 nm and not more than 15 nm. Employed in the pinning layer 105 is, for example, an Ir₂₂Mn₇₈ layer having a thickness of 7 nm. When the Ir₂₂Mn₇₈ layer is employed, heat treatment may be performed for one hour at 320°C while applying a magnetic field of 10 kOe, as a condition of heat treatment in a magnetic field. When a Pt₅₀Mn₅₀ layer is employed, heat treatment may be performed for 10 hours at 320°C while applying a magnetic field of 10 kOe, as a condition of heat treatment in a magnetic field.

Configurable as the second magnetization fixed layer 106 is, for example, at least one of Fe, Co, and Ni, or an alloy including at least one kind thereof. Moreover, a material having an additional element added to these materials may also be configured as the second magnetization fixed layer 106.

Employed in the second magnetization fixed layer 106 is, for example, a CoₓFe₁₀₀₋ₓ alloy (where x is not less than 0 at. % and not more than 100 at. %), a NiₓFe₁₀₀₋ₓ alloy (where x is not less than 0 at. % and not more than 100 at. %), or a material having a nonmagnetic element added to these alloys. Employed in the second magnetization fixed layer 106 is, for example, at least one selected from the group configured from Co, Fe, and Ni. It is also possible to employ as the second magnetization fixed layer 106 an alloy including at least one material selected from these materials.

A thickness of the second magnetization fixed layer 106 is preferably not less than 1.5 nm and not more than 5 nm, for example. As a result, for example, intensity of the unidirectional anisotropic magnetic field due to the pinning layer 105 can be more greatly strengthened. For example, intensity of an antiferromagnetic coupling magnetic field between the second magnetization fixed layer 106 and the first magnetization fixed layer 102 can be more greatly strengthened, via the magnetic coupling layer 107 formed on the second magnetization fixed layer 106. Magnetic film thickness (product (Bs·t) of saturation magnetization Bs and thickness t) of the second magnetization fixed layer 106 is preferably substantively equal to magnetic film thickness of the first magnetization fixed layer 102.

Saturation magnetization of Co₄₀Fe₄₀B₂₀ with a thin film is approximately 1.9 T (tesla). For example, when a Co₄₀Fe₄₀B₂₀ layer having a thickness of 3 nm is employed as the first magnetization fixed layer 102, the magnetic film thickness of the first magnetization fixed layer 102 is 1.9 T x 3 nm, that is, 5.7 Tnm. On the other hand, saturation magnetization of Co₇₅Fe₂₅ is approximately 2.1 T. The thickness of the second magnetization fixed layer 106 at which a magnetic film thickness equal to that described above can be obtained is 5.7 Tnm/2.1 T, that is, 2.7 nm. In this case, Co₇₅Fe₂₅ having a thickness of approximately 2.7 nm is preferably employed in the second magnetization fixed layer 106. Employed as the second magnetization fixed layer 106 is, for example, a Co₇₅Fe₂₅ layer having a thickness of 2.5 nm.

In the first magneotresistance element 100A shown in Fig. 5A, a synthetic pin structure of the second magnetization fixed layer 106, the magnetic coupling layer 107, and the first magnetization fixed layer 102 is employed. Instead, a single pin structure configured from a single-layer magnetization fixed layer may be employed. When the single pin structure is employed, a Co₄₀Fe₄₀B₂₀ layer having a thickness of 3 nm, for example, is employed as the magnetization fixed layer. The same material as that of the later-described first magnetization fixed layer 102 may be employed as the ferromagnetic layer employed in magnetization fixed layer having a single pin structure.

The magnetic coupling layer 107 generates antiferromagnetic coupling between the second magnetization fixed layer 106 and the first magnetization fixed layer 102. The magnetic coupling layer 107 forms a synthetic pin structure. Employed as the magnetic coupling layer 107 is, for example, Ru. A thickness of the magnetic coupling layer 107 is preferably not less than 0.8 nm and not more than 1 nm. A material other than Ru may be employed as the magnetic coupling layer 107, provided it is a material generating sufficient antiferromagnetic coupling between the second magnetization fixed layer 106 and the first magnetization fixed layer 102. The thickness of the magnetic coupling layer 107 may be set to a thickness of not less than 0.8 nm and not more than 1 nm corresponding to a second peak of RKKY (Ruderman-Kittel-Kasuya-Yosida) coupling. Furthermore, the thickness of the magnetic coupling layer 107 may be set to a thickness of not less than 0.3 nm and not more than 0.6 nm corresponding to a first peak of RKKY coupling. Employed as the magnetic coupling layer 107 is, for example, Ru having a thickness of 0.9 nm. As a result, highly reliable coupling can be more stably obtained.

Configurable as the first magnetization fixed layer is, for example, at least one of Fe, Co, and Ni, or an alloy including at least one kind thereof. Moreover, a material having an additional element added to these materials may also be configured as the first magnetization fixed layer.

A magnetic layer employed in the first magnetization fixed layer 102 contributes directly to the MR effect. Employed as the first magnetization fixed layer 102 is, for example, a Co-Fe-B alloy. Specifically, a (CoₓFe₁₀₀₋ₓ)_{100-y}B_{y} alloy (where x is not less than 0 at. % and not more than 100 at. %, and y is not less than 0 at. % and not more than 30 at. %) may be employed as the first magnetic fixed layer 102. When an amorphous alloy of (CoₓFe₁₀₀₋ₓ)_{100-y}B_{y} is employed as the first magnetization fixed layer 102, variation between elements due to crystal grains can be suppressed even when size of the magneotresistance elements is small. When an amorphous alloy is employed as the first magnetization fixed layer 102, a layer formed on the first magnetization fixed layer 102 (for example, a tunnel insulating layer) can be planarized. Planarization of the tunnel insulating layer makes it possible to reduce defect density of the tunnel insulating layer. For example, when MgO is employed as a material of the tunnel insulating layer, employing an amorphous alloy of (CoₓFe₁₀₀₋ₓ)_{100-y}b_{y} makes it possible to strengthen (100) orientation of an MgO layer formed on the tunnel insulating layer. More greatly raising the (100) orientation of the MgO layer enables an even larger MR ratio to be obtained. The (CoₓFe₁₀₀₋ₓ) _{100-y}B_{y} alloy crystallizes adopting a (100) surface of the MgO layer as a template during annealing. Therefore, good crystal conformity can be obtained between the MgO and the (CoₓFe₁₀₀₋ₓ)_{100-y}B_{y} alloy. Obtaining good crystal conformity enables an even larger MR ratio to be obtained. An Fe-Co alloy, for example, may be employed as the first magnetization fixed layer 102, besides the Co-Fe-B alloy.

If the first magnetization fixed layer 102 is thicker, a larger MR ratio is obtained. In order to obtain a larger fixed magnetic field, it is more preferable for the first magnetization fixed layer 102 to be thin. There is a tradeoff relationship in the thickness of the first magnetization fixed layer 102 between the MR ratio and the fixed magnetic field. When a Co-Fe-B alloy is employed as the first magnetization fixed layer 102, the thickness of the first magnetization fixed layer 102 is preferably not less than 1.5 nm and not more than 5 nm. The thickness of the first magnetization fixed layer 102 is more preferably not less than 2.0 nm and not more than 4 nm.

Employed in the first magnetization fixed layer 102 (second magnetic layer 20), besides the above-mentioned materials, is a Co₉₀Fe₁₀ alloy of fcc structure, or Co of hcp structure, or a Co alloy of hcp structure. Employed as the first magnetization fixed layer 102 is at least one selected from the group configured from Co, Fe, and Ni. Employed as the first magnetization fixed layer 102 is an alloy including at least one material selected from these materials. Employing a bcc structure FeCo alloy material, a Co alloy including a cobalt composition of 50 at. % or more, or a material having a Ni composition of 50 at. % or more as the first magnetization fixed layer 102 results in, for example, a larger MR ratio being obtained. It is also possible to employ as the first magnetization fixed layer 102 a Heusler magnetic alloy layer of the likes of Co₂MnGe, Co₂FeGe, Co₂MnSi, Co₂FeSi, Co₂MnAl, Co₂FeAl, Co₂MnGa_{0.5}Ge_{0.5}, and Co₂FeGa_{0.5}Ge_{0.5}. For example, employed as the first magnetization fixed layer 102 is a Co₄₀Fe₄₀B₂₀ layer having a thickness of 3 nm.

The intermediate layer 103 decouples magnetic coupling between the first magnetization fixed layer 102 and the first magnetic layer 101. Employed in the intermediate layer 103 is a metal or an insulator or a semiconductor. When a metal is employed as the intermediate layer 103, the likes of Cu, Au, or Ag are employed, for example. In this case, a thickness of the intermediate layer 103 is, for example, about not less than 1 nm and not more than 7 nm. When an insulator or semiconductor is employed as the intermediate layer 103, the likes of a magnesium oxide (Mg-O, and so on), an aluminum oxide (Al₂O₃, and so on), a titanium oxide (Ti-O, and so on), a zinc oxide (Zn-O, and so on), or gallium oxide (Ga-O) are employed. In this case, the thickness of the intermediate layer 103 is, for example, about not less than 0.6 nm and not more than 5 nm.

Configurable as a material of the first magnetic layer 101 is, for example, at least one of Fe, Co, and Ni, or an alloy including at least one kind thereof. Moreover, a material having an additional element added to these materials may also be configured as the material of the first magnetic layer 101. The first magnetic layer is a layer including a ferromagnetic body whose magnetization direction changes due to an external magnetic field. Moreover, B, Al, Si, Mg, C, Ti, V, Cr, Mn, Cu, Zn, Ga, Zr, Hf, and so on, can be added to these metals and alloys as an additional element or ultra-thin layer. In addition, it is also possible to employ an amorphous magnetic layer, not only a crystalline magnetic layer.

Moreover, it is also possible to employ a magnetic layer of an oxide or nitride. For example, it is possible to employ a two-layer configuration of Co₉₀Fe₁₀ [1 nm]/Ni₈₀Fe₂₀ [3.5 nm] that employs NiFe, forming CoFe at a boundary thereof. Note that when a NiFe layer is not employed, a Co₉₀Fe₁₀ [4 nm] single layer can be employed. Moreover, a three-layer configuration such as CoFe/NiFe/CoFe may also be adopted as the first magnetic layer 101.

Co₉₀Fe₁₀ is preferable in the first magnetic layer 101, since among CoFe alloys, Co₉₀Fe₁₀ has stable soft magnetic characteristics. When employing a CoFe alloy close to Co₉₀Fe₁₀, a film thickness of the first magnetic layer 101 is preferably set to not less than 0.5 nm and not more than 4 nm. In addition, CoₓFe₁₀₀₋ₓ (where x = 70 at. % to 90 at. %) may also be employed.

Moreover, in a TMR element employing MgO in the intermediate layer, it is preferable to employ a (CoₓFe₁₀₀₋ₓ)_{100-y}B_{y} alloy (where x = 0 at. % to 100 at. %, and y = 0 at. % to 30 at. %) as a material of the first magnetic layer. The (CoₓFe₁₀₀₋ₓ) _{100-y}B_{y} alloy crystallizes adopting an MgO (100) surface as a template during annealing, hence good crystal conformity of the MgO and the (CoₓFe₁₀₀₋ₓ)_{100-y}B_{y} alloy can be obtained. Such good crystal conformity is important in terms of obtaining a high MR ratio. On the other hand, when a Co-Fe-B alloy is employed in the first magnetic layer, it is preferable to configure a stacked body with a Ni-Fe alloy in terms of improving soft magnetic characteristics. For example, Co₄₀Fe₄₀B₂₀ [2 nm]/Ni₈₀Fe₂₀ [8 nm], and so on, can be employed. Now, the Co-Fe-B layer is preferably disposed on an intermediate layer side in terms of obtaining a high MR ratio. In addition, when crystal conformity between the Co₄₀Fe₄₀B₂₀ layer and the Ni₈₀Fe₂₀ layer is cut, the Co₄₀Fe₄₀B₂₀ layer can obtain good orientation adopting the MgO intermediate layer as a template, hence a nonmagnetic metal of the likes of Ta or Ti may be inserted between the Co₄₀Fe₄₀B₂₀ and Ni₈₀Fe₂₀ layers. Moreover, a stacked body of a Co-Fe-B layer and a Ni-Fe-B layer may be configured.

The cap layer 108 protects a layer provided below the cap layer 108. Employed in the cap layer 108 are, for example, a plurality of metal layers. A nonmagnetic metal may be employed in the cap layer 108, for example. Employed in the cap layer 108 is, for example, a two-layer structure (Ta/Ru) of a Ta layer and a Ru layer. A thickness of this Ta layer is, for example, 1 nm, and a thickness of this Ru layer is, for example, 5 nm. Another metal layer may be provided instead of the Ta layer or Ru layer, as the cap layer 108. There may be any configuration of the cap layer 108. For example, a nonmagnetic material may be employed in the cap layer 108. Another material may be employed as the cap layer 108, provided the material is capable of protecting the layer provided below the cap layer 108.

Fig. 5B is a schematic perspective view illustrating a first magneotresistance element 100B used in another embodiment. As indicated in Fig. 5B, the first magneotresistance element 100B includes, aligned sequentially therein: the lower electrode E1; the under-layer 104; the first magnetic layer 101; the intermediate layer 103; the second magnetic layer 102; the magnetic coupling layer 107; the second magnetization fixed layer 106; the pinning layer 105; the cap layer 108; and the upper electrode E2.

In this example, the first magnetic layer 101 functions as a magnetization free layer, and the second magnetic layer 102 functions as a first magnetization fixed layer. The first magneotresistance element 100B of Fig. 5B is called a top spin valve type. The materials described for the magneotresistance element shown in Fig. 5A, for example, may be employed in each of the layers included in the first magneotresistance element 100B.

Fig. 5C is a schematic perspective view illustrating a first magneotresistance element 100C used in another embodiment. As indicated in Fig. 5C, the first magneotresistance element 100C includes, aligned sequentially therein: the lower electrode E1; the under-layer 104; a lower pinning layer 105a; a lower second magnetization fixed layer 106a; a lower magnetic coupling layer 107a; a lower second magnetic layer 102a; a lower intermediate layer 103a; the first magnetic layer 101; an upper intermediate layer 103b; an upper second magnetic layer 102b; an upper magnetic coupling layer 107b; an upper second magnetization fixed layer 106b; an upper pinning layer 105b; the cap layer 108; and the upper electrode E2.

In this example, the first magnetic layer 101 functions as a magnetization free layer, the lower second magnetic layer 102a functions as a lower first magnetization fixed layer 102a, and the upper second magnetic layer 102b functions as an upper first magnetization fixed layer. In the first magneotresistance element 100A shown in Fig. 5A and the first magneotresistance element 100B shown in Fig. 5B already described, the second magnetic layer 102 which is a magnetization fixed layer is disposed on a side of one surface of the first magnetic layer 101 which is a magnetization free layer. On the other hand, in the magneotresistance element 100C shown in Fig. 5C, a magnetization free layer is disposed between two magnetization fixed layers. The first magneotresistance element 100C shown in Fig. 5C is called a dual spin valve type. The materials described for the first magneotresistance element 100A shown in Fig. 5A, for example, may be employed in each of the layers included in the first magneotresistance element 100C shown in Fig. 5C.

Fig. 5D is a schematic perspective view illustrating a first magneotresistance element 100D used in another embodiment. As indicated in Fig. 5D, the first magneotresistance element 100D includes, aligned sequentially therein: the lower electrode E1; the under-layer 104; the pinning layer 105; the second magnetic layer 102; the intermediate layer 103; the first magnetic layer 101; the cap layer 108; and the upper electrode E2.

In this example, the first magnetic layer 101 functions as a magnetization free layer, and the second magnetic layer 102 functions as a magnetization fixed layer. The first magneotresistance element 100A shown in Fig. 5A and the first magneotresistance element 100B shown in Fig. 5B already described adopt a structure employing the second magnetization fixed layer 106, the magnetic coupling layer 107, and the second magnetic layer 102 functioning as the first magnetization fixed layer. On the other hand, the first magneotresistance element 100D shown in Fig. 5D adopts a single pin structure employing a single magnetization fixed layer 24. The materials described for the first magneotresistance element 100A shown in Fig. 5A, for example, may be employed in each of the layers included in the first magneotresistance element 100D shown in Fig. 5D.

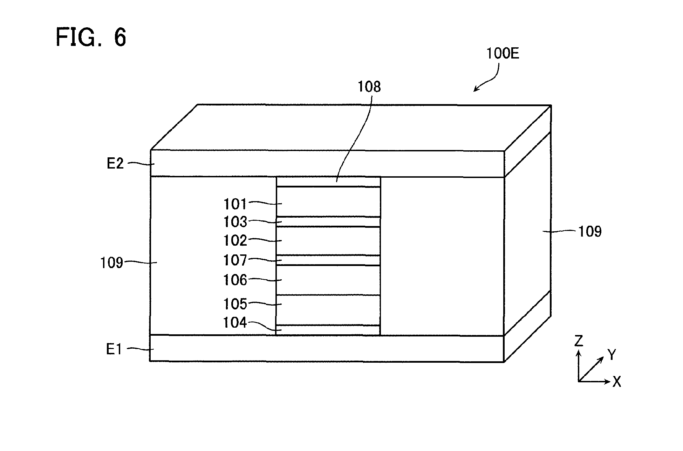

Fig. 6 is a schematic perspective view illustrating a first magneotresistance element 100E according to another configuration. As indicated in Fig. 6, an insulating layer 109 is provided in the first magneotresistance element 100E. That is, provided between the lower electrode E1 and the upper electrode E2 are two insulating layers (insulating portions) 109 that are separated from each other, and provided between these two insulating layers 109 is a stacked body configured from the under-layer 104, the pinning layer 105, the second magnetization fixed layer 106, the magnetic coupling layer 107, the second magnetic layer 102, the intermediate layer 103, the magnetization free layer 101, and the cap layer 108.

In this example, the first magnetic layer 101 functions as a magnetization free layer, and the second magnetic layer 102 functions as a first magnetization fixed layer. The materials described for the magneotresistance element shown in Fig. 5A, for example, may be employed in each of the layers included in the first magneotresistance element 100E. Moreover, employable in the insulating layer 109 is, for example, an aluminum oxide (for example, Al₂O₃) or a silicon oxide (for example, SiO₂), and so on. Leak current in a periphery of the above-described stacked body can be suppressed by the insulating layer 109. The above-described insulating layer 109 may be applied also to any of the magneotresistance elements shown in Figs. 1A to 1D.

### [1-5. Other Example of Configuration of Magneotresistance Element]

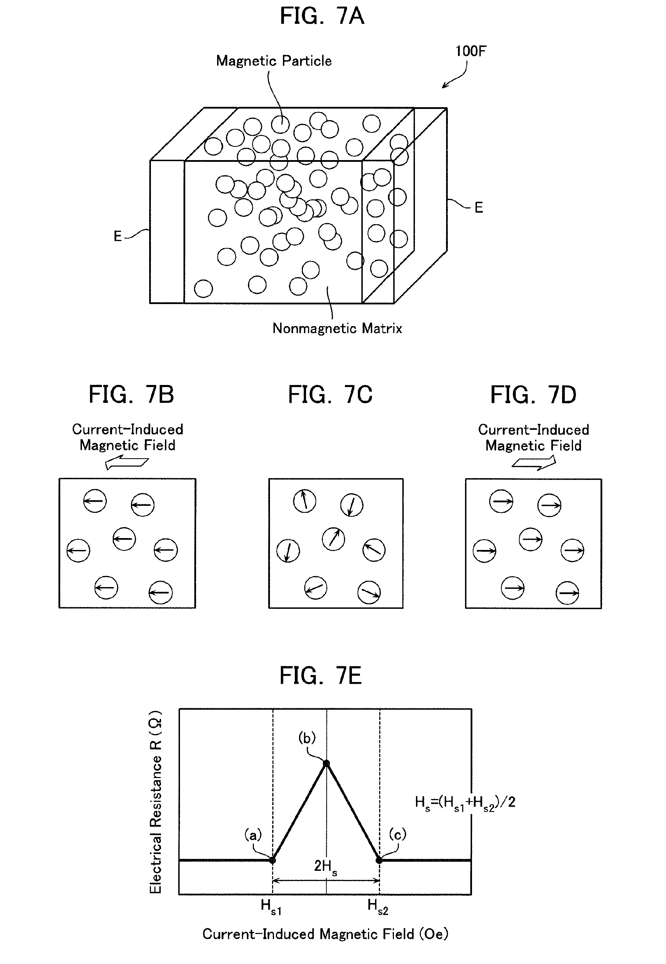

Fig. 7A is a schematic perspective view showing a first magneotresistance element 100F according to another configuration. The first magneotresistance element 100F shown in Fig. 7A is called a granular type magneotresistance element, and includes: a structure in which fine particles of a magnetic body are three-dimensionally dispersed in a matrix layer (matrix); and a pair of electrodes E disposed at side portions of this structure. The first magneotresistance element 100F is called a granular type GMR element when the matrix layer is a conductor, and is called a granular type TMR element when the matrix layer is an insulator.

As shown in Fig. 7C, inclination of magnetization of the three-dimensionally dispersed magnetic particles is three-dimensionally random in a state where there is no external magnetic field, and, as shown in Figs. 7B and 7D, is aligned in one direction when an external magnetic field is applied. As shown in Fig. 7E, electrical resistance changes according to relative angle of the dispersed magnetic particles. This MR phenomenon is based on the same principle as for the previously mentioned stacked type GMR element or TMR element. The first magneotresistance element 100F has an advantage that production is easier compared to a stacked type, and so on.

The magnetic particles employed in the first magneotresistance element 100F correspond to the magnetization free layer in the previously mentioned stacked type magneotresistance element. Configurable as a material employed in the magnetic particles is, for example, at least one of Fe, Co, and Ni, or an alloy including at least one type thereof. Moreover, it is also possible to add to these metals and alloys, as additional elements, the likes of B, Al, Si, Mg, C, Ti, V, Cr, Mn, Cu, Zn, Ga, Zr, and Hf. For example, magnetic particles configured from Co₉₀Fe₁₀ may be employed.

Employed as an insulating material or semiconductor material of the matrix of the first magneotresistance element 100F in the case of a granular type TMR element acting as a matrix of the first magneotresistance element 100F are the likes of a magnesium oxide (Mg-O, and so on), an aluminum oxide (Al₂O₃, and so on), a titanium oxide (Ti-O, and so on), a zinc oxide (Zn-O, and so on), or gallium oxide (Ga-O). On the other hand, employable as a conductor material in the case of a granular type GMR element are metals such as Cu, Ag, Au, Al, Cr, and Ru.

Note that the first magneotresistance element 100F is formed as a CIP element having the electrodes E provided on its sidewalls and passing a current in a direction within a film surface, but may also be configured as a CPP element that passes a current in a direction perpendicular to a film surface via the lower electrode E1 and the upper electrode E2.

### [1-6. Horizontally-Positioned Offset Magnetic Body]

Next, a relationship between the magneotresistance element and the offset magnetic body when the offset magnetic body is disposed adjacent to the magneotresistance element will be described. The description below takes as an example the first magneotresistance element 100 and the first offset magnetic body 150, but the likes of the second magneotresistance element 200 or second offset magnetic body 250, and so on, may also be similarly configured.

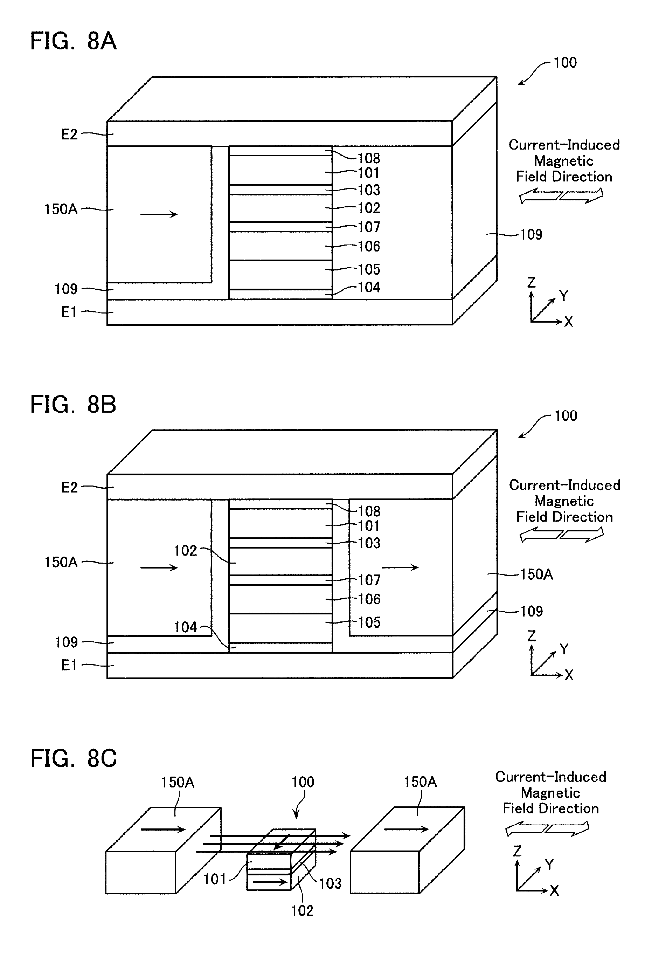

Fig. 8 shows a schematic view of the first magneotresistance element 100 and a first offset magnetic body 150A. The first offset magnetic body 150A is one mode of the first offset magnetic body 150.

The first offset magnetic body 150A is disposed adjacent to the first magnetic layer 101, the second magnetic layer 102, and the intermediate layer 103 in the first magneotresistance element 100, and applies an offset magnetic field to the first magnetic layer 101, the second magnetic layer 102, and the intermediate layer 103. In addition, the first offset magnetic body 150A is provided between the lower electrode E1 and the upper electrode E2. Furthermore, disposed, for example, between the first offset magnetic body 150A and the first magneotresistance element 100 is the insulating layer 109. In this example, the insulating layer 109 extends between the first offset magnetic body 150A and the lower electrode E1.

In Fig. 8A, one first offset magnetic body 150A is provided to one first magneotresistance element 100. On the other hand, a pair of first offset magnetic bodies 150A may be provided sandwiching one first magneotresistance element 100 as in Fig. 8B. The specific examples described hereafter also have a pair of first offset magnetic bodies 150A provided, but may also be configured on one side only.

As shown in Fig. 8C, an offset magnetic field can be applied substantially parallel to the current-induced magnetic field applied to the first magneotresistance element 100, by the magnetic field of the first offset magnetic body 150. As a result, the current-induced magnetic field causing resistance change of the first magneotresistance element 100 can be offset. For example, by setting magnetization of the first offset magnetic body 150 in a substantially parallel direction to the current-induced magnetic field generated from the current to be measured, the current-induced magnetic field causing resistance change of the first magneotresistance element 100 can be offset as shown in Fig. 4A and 4B.

Employed in the first offset magnetic body 150A is, for example, a hard magnetic material (hard ferromagnetic material) of comparatively high magnetic anisotropy and coercivity such as Co-Pt, Fe-Pt, Co-Pd, Fe-Pd, and so on. Moreover, an alloy having an additional element further added to Co-Pt, Fe-Pt, Co-Pd, and Fe-Pd may be employed. For example, CoPt (where a percentage of Co is not less than 50 at. % and not more than 85 at. %), (CoₓPt₁₀₀₋ₓ) _{100-y}Cr_{y} (where x is not less than 50 at. % and not more than 85 at. %, and y is not less than 0 at. % and not more than 40 at. %), or FePt (where a percentage of Pt is not less than 40 at. % and not more than 60 at. %), and so on, may be employed.

When such materials are employed, applying an external magnetic field larger than the coercivity of the first offset magnetic body 150A makes it possible to set (fix) the direction of magnetization of the first offset magnetic body 150A to the direction in which the external magnetic field is applied. A thickness of the first offset magnetic body 150A (for example, a length along a direction from the lower electrode E1 toward the upper electrode E2) is, for example, not less than 5nm and not more than 50 nm.

When the insulating layer 109 is disposed between the first offset magnetic body 150A and the lower electrode E1 as shown in Fig. 8A, SiOₓ or AlOₓ may be employed as the material of the insulating layer 109. Furthermore, an offset magnetic body under-layer not illustrated may be provided between the insulating layer 109 and the first offset magnetic body 150A. When a hard ferromagnetic material of comparatively high magnetic anisotropy and coercivity such as Co-Pt, Fe-Pt, Co-Pd, Fe-Pd, and so on, is employed in the first offset magnetic body 150A, Cr or Fe-Co and the like may be employed as a material of the offset magnetic body under-layer. The above-described first offset magnetic body 150A may also be applied to any of the above-described and below-described first magneotresistance elements 100.

The first offset magnetic body 150A may have a structure of being stacked on an offset pinning layer not illustrated. In this case, the direction of magnetization of the first offset magnetic body 150A can be set (fixed) by exchange coupling between the first offset magnetic body 150A and the offset pinning layer. In this case, employable in the first offset magnetic body 150A is a ferromagnetic material configured from at least one of Fe, Co, and Ni, or an alloy including at least one kind thereof. In this case, employable in the first offset magnetic body 150A is, for example, a Co,Fe₁₀₀₋ₓ alloy (where x is not less than 0 at. % and not more than 100 at. %), a NiₓFe₁₀₀₋ₓ alloy (where x is not less than 0 at. % and not more than 100 at. %), or a material having a nonmagnetic element added to these. A material similar to that of the previously mentioned second magnetic layer 102 may be employed as the first offset magnetic body 150A. Moreover, a material similar to that of the previously mentioned pinning layer 105 of the magneotresistance layer may be employed as the offset pinning layer. In addition, when the offset pinning layer is provided, a under-layer of the same material as described in the under-layer 104 may be provided below the offset pinning layer. Moreover, the offset pinning layer may be provided in a lower portion or an upper portion of the first offset magnetic body 150A. A magnetization direction of the first offset magnetic body 150A in this case can be set by heat treatment in a magnetic field, as described in the pinning layer of the magneotresistance element.

The above-described first offset magnetic body 150A may also be applied to any of the above-described first magneotresistance elements 100 and the first magneotresistance elements 100 to be described below. When employing the above-described kind of stacked structure of the first offset magnetic body 150A and the offset pinning layer, the inclination of magnetization of the first offset magnetic body 150A can be easily maintained even when a large current flows instantaneously as the current to be measured and a large current-induced magnetic field is applied to the first offset magnetic body 150A.

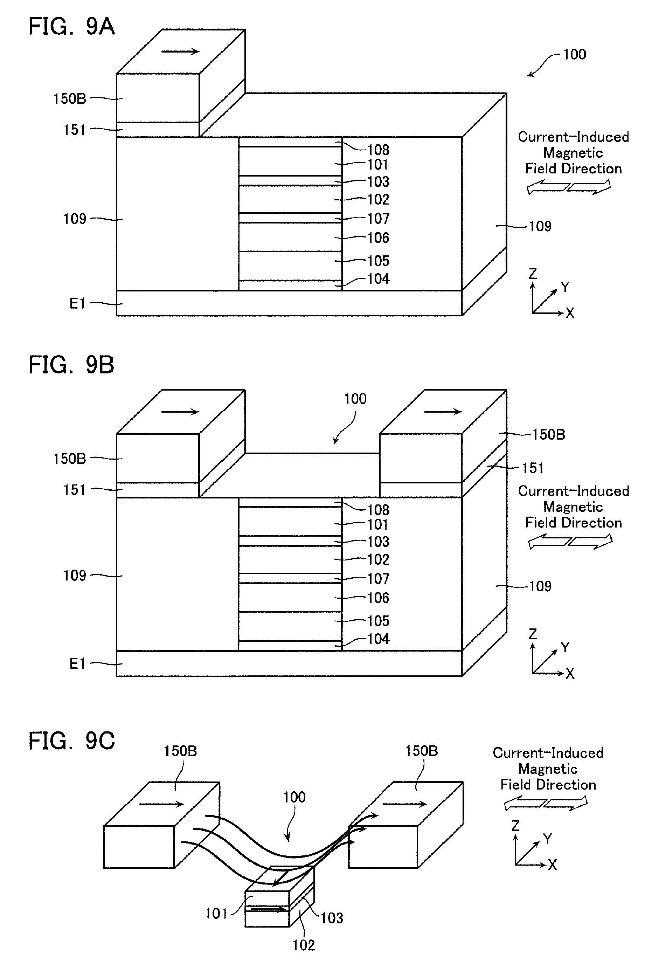

Fig. 9A and 9B show a schematic view of the first magneotresistance element 100 and a first offset magnetic body 150B. The first offset magnetic body 150B is another mode of the first offset magnetic body 150.

In Fig. 8A and 8B, the first offset magnetic body 150A was disposed laterally adjacent to the first magneotresistance element 100, but as shown in Fig. 9A and 9B, the first offset magnetic body 150B may be provided diagonally above the first magneotresistance element 100. In this case also, one first offset magnetic body 150B may be provided to one first magneotresistance element 100 as shown in Fig. 9A, or a pair of first offset magnetic bodies 150B may be provided sandwiching one first magneotresistance element 100 as shown in Fig. 9B. Even when the first offset magnetic body 150B is provided diagonally above as in Fig. 9A and 9B, a leakage magnetic field from the offset magnet leaks having a certain degree of distribution and not only directly sideways, hence an offset magnetic field can be applied to the first magneotresistance element 100 as shown in Fig. 9C.

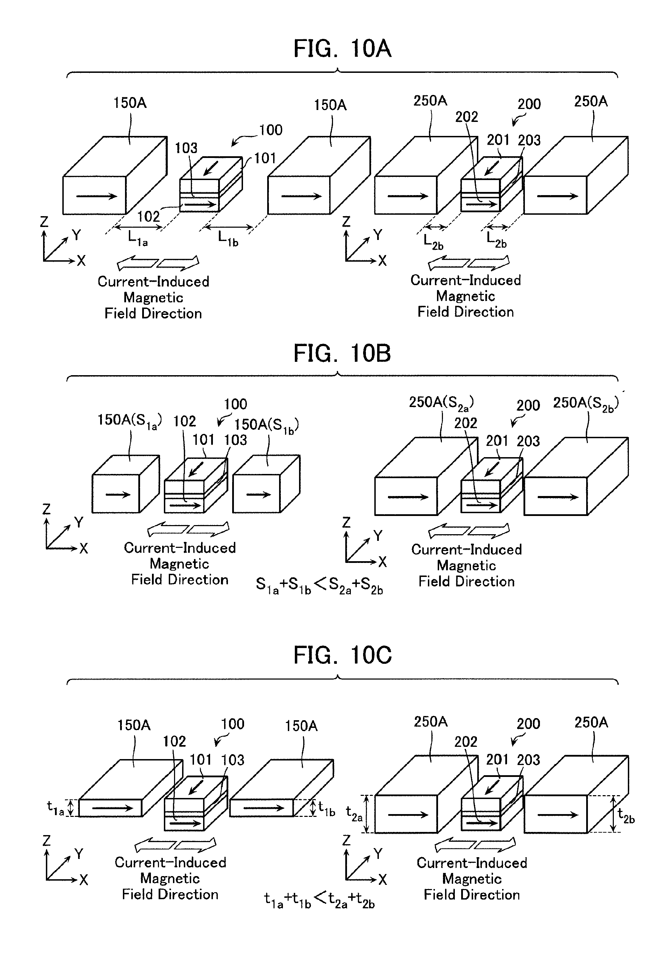

Now, an offset magnetic field H_{offset} of the magneotresistance element can be adjusted by configurations of the first offset magnetic body 150A, and so on. Figs. 10A to 10C show examples where a difference in configurations of the first offset magnetic body 150 and the second offset magnetic body 250 is provided to obtain different offset magnetic fields for two magneotresistance elements. Note that in Figs. 10A to 10C, two magneotresistance elements are taken as an example, but three or more magneotresistance elements may be adopted. In addition, Figs. 10A to 10C are described taking as an example the case where the first or second offset magnetic bodies 150A and 250A of the kind shown in Fig. 8A and 8B are provided laterally adjacent to the magneotresistance element, but similarly different offset magnetic fields can be obtained even when the first or second offset magnetic bodies 150B and 250B of the kind shown in Fig. 9A to 9B are provided diagonally to the side of the magneotresistance element.

As shown in Fig. 10A, it is possible to change the offset magnetic field by changing a distance between the magneotresistance element and the first and second offset magnetic bodies 150A and 250A. The sum L₁ₐ + L_{1b} of the distances between the first magneotresistance element 100 and each of the pair of first offset magnetic bodies 150A shown in Fig. 10A is set larger than the sum L₂ₐ + L_{2b} of the distances between the second magneotresistance element 200 and each of the pair of second offset magnetic bodies 250A shown in Fig. 10A. In this case, the larger the distance from the first or second offset magnetic bodies 150A and 250A, the smaller becomes the magnetic field applied to the first or second magneotresistance elements 100 and 200. Accordingly, the offset magnetic field H_{offset} of the first and second magneotresistance elements 100 and 200 becomes smaller.

As shown in Fig. 10B, it is possible to change the offset magnetic field by changing area in a substrate planar surface of the first offset magnetic body 150A and area in a second substrate planar surface of the second offset magnetic body 250A. The sum S₁ₐ + S_{1b} of each of areas of the pair of first offset magnetic bodies 150A shown in Fig. 10B is set smaller than the sum S₂ₐ + S_{2b} of each of areas of the pair of second offset magnetic bodies 250A shown in Fig. 10B. In this case, the larger the area of the first or second offset magnetic bodies 150A and 250A, the larger becomes the magnetic volume of the first or second offset magnetic bodies 150A and 250A. Accordingly, the magnetic field applied to the first or second magneotresistance elements 100 and 200 becomes larger, and the offset magnetic field of the first or second magneotresistance elements 100 and 200 becomes larger.

As shown in Fig. 10C, it is possible to change the offset magnetic field by changing film thickness of the first and second offset magnetic bodies 150A and 250A. The sum t₁ₐ + t_{1b} of film thicknesses of the pair of first offset magnetic bodies 150A shown in Fig. 10C is set smaller than the sum t₂ₐ + t_{2b} of film thicknesses of the pair of second offset magnetic bodies 250A shown in Fig. 10C. In this case, the larger the film thickness of the first and second offset magnetic bodies 150A and 250A, the larger becomes the magnetic volume of the first and second offset magnetic bodies 150A and 250A. Accordingly, the magnetic field applied to the first and second magneotresistance elements 100 and 200 becomes larger, and the offset magnetic field of the first and second magneotresistance elements 100 and 200 becomes larger.

The above-mentioned Figs. 10B and 10C described the case where magnetic volume is changed by changing area or film thickness of the first and second offset magnetic bodies 150A and 250A, but magnetic volume can be changed also by changing a type of magnetic material employed in the first and second offset magnetic bodies 150A and 250A. For example, it is also possible to change magnetic volume and change the offset magnetic field of the first and second magneotresistance elements 100 and 200 by employing magnetic materials having a different saturation magnetization in the first offset magnetic body 150A and the second offset magnetic body 250A, respectively.

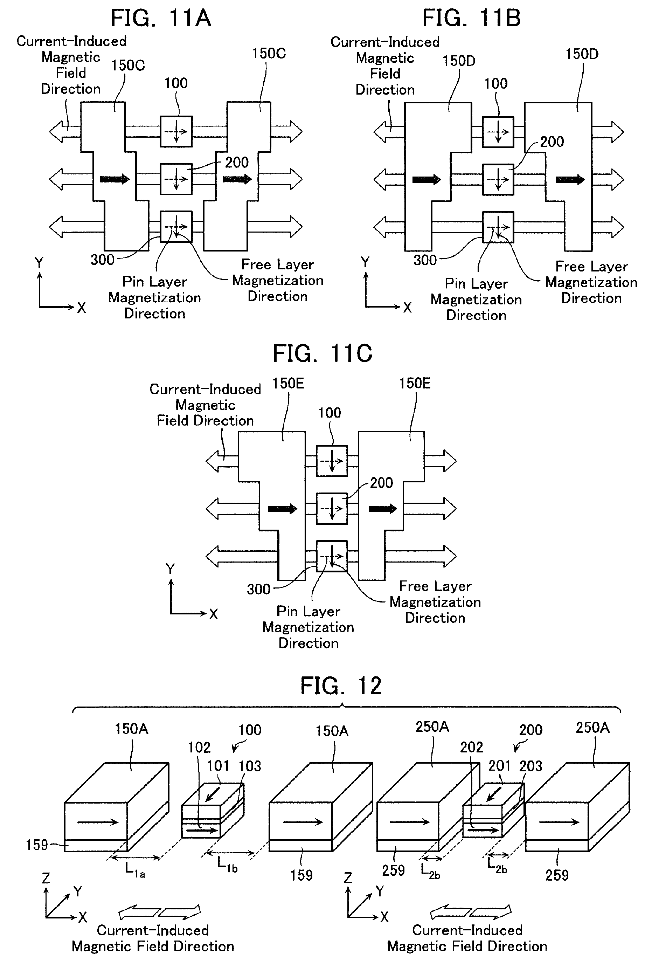

Figs. 11A to 11C are schematic views for explaining the cases where an offset magnetic field from a pair of first offset magnetic bodies 150C, 150D, or 150E is applied to a plurality of magneotresistance elements. The first offset magnetic bodies 150C, 150D, or 150E are other modes of the first offset magnetic body 150. Such configurations also make it possible to change the offset magnetic field of the magneotresistance elements. Note that Fig. 11A to 11C describe an example where the current sensor comprises a third magneotresistance element 300 in addition to the first magneotresistance element 100 and the second magneotresistance element 200, but the number of magneotresistance elements may be two, or may be four or more.

As shown in Fig. 11A, it is also possible to change the offset magnetic field of each of the magneotresistance elements by employing the pair of first offset magnetic bodies 150C on the plurality of magneotresistance elements. In Fig. 11A, widths of the first offset magnetic bodies 150C in the magnetization direction or direction of the current-induced magnetic field (X direction) are configured equally with respect to each of the magneotresistance elements, but distances between each of the plurality of magneotresistance elements and the pair of first offset magnetic bodies 150C are different. By employing the first offset magnetic body 150C of such a shape, the effective distances between the first offset magnetic body 150C and each of the magneotresistance elements, at its closest position to each of the magneotresistance elements, are different. Accordingly, it becomes possible to change the offset magnetic field of each of the magneotresistance elements as described in Fig. 10A.

As shown in Fig. 11B, it is also possible to change the offset magnetic field of each of the magneotresistance elements by employing the pair of first offset magnetic bodies 150D on the plurality of magneotresistance elements. In Fig. 11B, widths of the first offset magnetic bodies 150D in the magnetization direction or direction of the current-induced magnetic field (X direction)are different with respect to each of the magneotresistance elements, and distances between each of the plurality of magneotresistance elements and the pair of first offset magnetic bodies 150D are different. In the case of employing the first offset magnetic body 150D of such a shape, the effective distances between the first offset magnetic body 150D and each of the magneotresistance elements at its closest position to each of the magneotresistance elements and the effective areas of the first offset magnetic body 150D at the positions are different. Accordingly, it becomes possible to change the offset magnetic field of each of the magneotresistance elements as described in Figs. 10A and 10B.

In Fig. 11C, distances between each of the plurality of magneotresistance elements and the pair of first offset magnetic bodies 150E are equal, but widths in the magnetization direction or direction of the current-induced magnetic field (X direction) of the first offset magnetic bodies 150E differ according to Y coordinate positions where each of the magneotresistance elements are positioned. By employing the first offset magnetic body 150E of such a shape, the effective magnetic volumes of the first offset magnetic body 150E at its closest position to each of the magneotresistance elements are different. Accordingly, it becomes possible to change the offset magnetic field of each of the magneotresistance elements as described in Fig. 10B.

Each of the offset magnetic bodies 150A to 150E described heretofore may employ a hard ferromagnetic material of comparatively high magnetic anisotropy and coercivity such as Co-Pt, Fe-Pt, Co-Pd, Fe-Pd, and so on, and may employ the stacked structure of the offset magnetic body and the offset pinning layer. As a variation of Fig. 10A, Fig. 12 shows an example where offset pinning layers 159 and 259 respectively contacting lower surfaces of the first offset magnetic body 150A and the second offset magnetic body 250A are disposed. The pinning layers 159 and 259 are examples of the offset pinning layer. Note that Fig. 12 shows a modified example of Fig. 10A, but such a variation employing the offset magnetic body and the offset pinning layer may be applied also to any of the examples of Figs. 8A-8C to 11A-11C. Moreover, the offset pinning layer may be provided in a lower portion or an upper portion of the offset magnetic body.

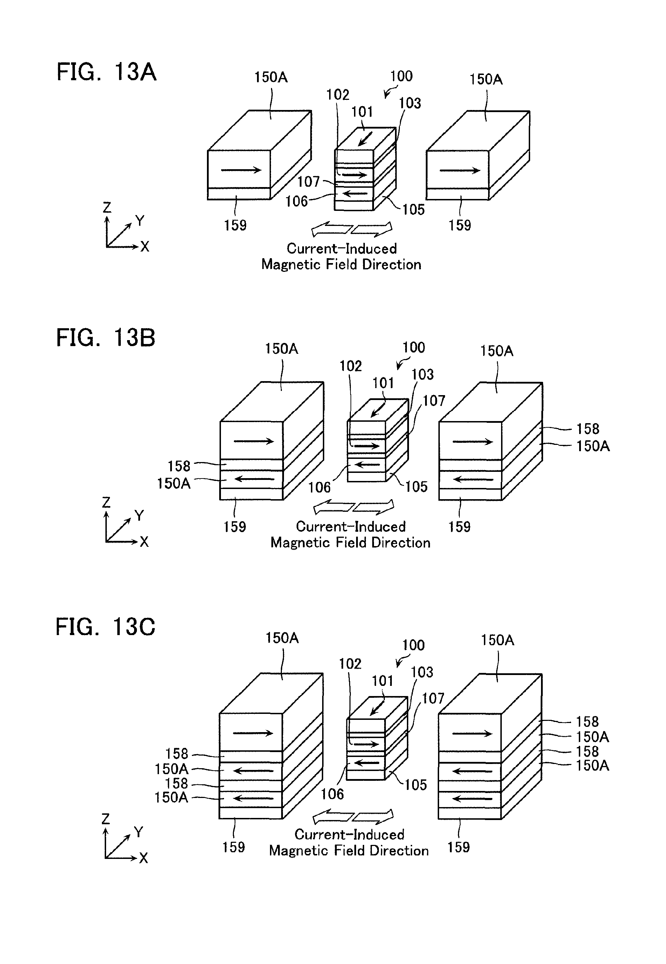

Fig. 13A to 13C are a schematic view showing an example of stacked configuration of the first offset magnetic body 150A and the offset pinning layer 159. When employing a stacked structure of the first offset magnetic body 150A and the offset pinning layer 159, it is possible to adopt not only the structure shown in Fig. 13A, but also a stacked structure of offset pinning layer 159/offset magnetic body 150A/offset magnetic coupling layer 158/offset magnetic body 150A, for example, as shown in Fig. 13B. Moreover, it is possible to stack three or more layers of offset magnetic bodies 150A via offset magnetic coupling layers 158, as shown in Fig. 13C. In the case of such a stacked structure, two offset magnetic bodies 150A mediated by the offset magnetic coupling layer 158 attain magnetization directions that are antiparallel to each other. In this case, the offset magnetic field is applied to the first magnetic layer 101 of the first magneotresistance element 100 in a direction of magnetization of the first offset magnetic body 150A that is closest thereto in distance.. Moreover, when such a structure is employed, the thickness of the offset magnetic body 150A whose distance is closest to the first magnetic layer 101 of the first magneotresistance element 100 is preferably set larger than the thickness of another offset magnetic body 150A included in the stacked structure. When the magnetization direction of the first offset magnetic body 150A is set parallel to the magnetization direction of the first magnetic layer 101 of the first magneotresistance element 100, their magnetization directions may be determined in a single- heat treatment in a magnetic field. For example, as shown in Figs. 13A, 13B, and 13C, the number of layers of the first offset magnetic bodies 150A mediated by the offset magnetic coupling layers 158 is set to an odd number or an even number. According to whether it is set to an odd number or an even number, it is possible to set the magnetization direction of the first offset magnetic body 150A that is the closest to the first magnetic layer 101 to either 0° and 180° with respect to the magnetization direction of the second magnetic layer 102.

In addition, a relationship of the inclination of magnetization of the first offset magnetic body 150A closest to the first magnetic layer 101 and the inclination of magnetization of the second magnetic layer 102 can be controlled also by a two-step heat treatment in a magnetic field performed changing the inclination of the magnetic field, without changing the number of layers of the first offset magnetic bodies 150A shown in Figs. 13A, 13B, and 13C. A method of the two-step heat treatment in a magnetic field will be described in an in-stack type offset magnetic body mentioned later.

When employing the stacked structure of the first offset magnetic body 150A and the offset pinning layer 159, the inclination of magnetization of the first offset magnetic body 150A can be easily maintained even when a large current flows instantaneously as the current to be measured and a large current-induced magnetic field is applied to the first offset magnetic body 150A.

### [1-7. Stacked Type Vertically-Positioned Offset Magnetic Body]

Next, a relationship between the magneotresistance element and the offset magnetic body when the offset magnetic body is disposed stacked on the magneotresistance element will be described. The description below takes as an example the first magneotresistance element 100 and the first offset magnetic body 150, but the likes of the second magneotresistance element 200 or second offset magnetic body 250, and so on, may also be similarly configured.

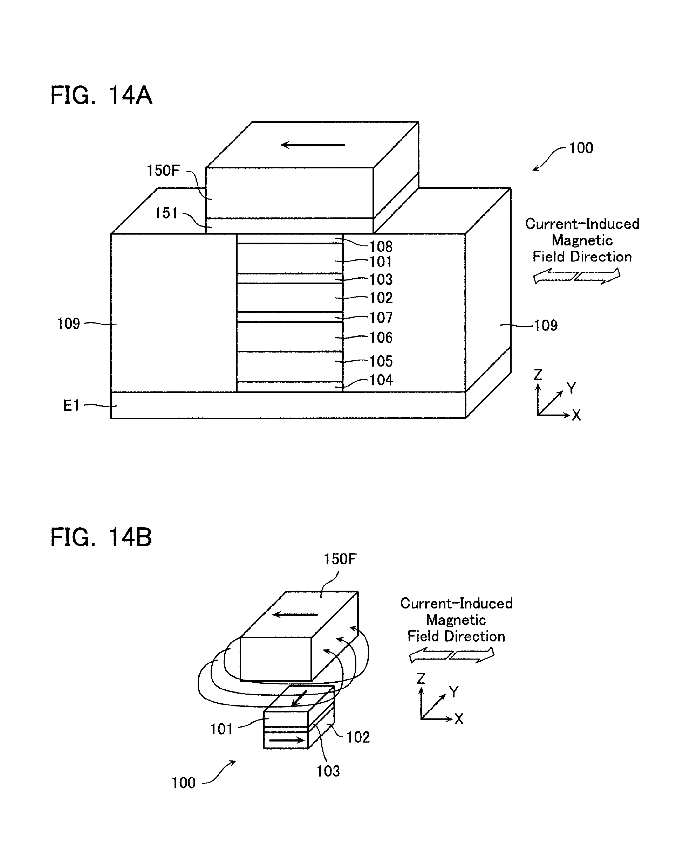

Fig. 14A and 14B show a schematic view of the first magneotresistance element 100 and a first offset magnetic body 150F that functions as the offset magnetic body. The first offset magnetic body 150F is another mode of the first offset magnetic body 150. Note that in Fig. 14A and 14B, the upper electrode E2 is omitted.

In the present embodiment, the first offset magnetic body 150F is provided in a stacking direction of the first magneotresistance element 100. For example, as shown in Fig. 14A, the first offset magnetic body 150F is provided above the cap layer 108 in the first magneotresistance element 100. However, the first offset magnetic body 150F may be provided below the under-layer 104, for example. However, when the first magnetic layer 101 functioning as a magnetization free layer is positioned above the second magnetic layer 102 functioning as a magnetization fixed layer, the first offset magnetic body 150F is more preferably disposed above the first magnetic layer 101. When the first magnetic layer 101 is positioned below the second magnetic layer 102, the first offset magnetic body 150F is more preferably disposed below the second magnetic layer 102.

In addition, as shown in Fig. 14A, a under-layer 151 dedicated to the first offset magnetic body 150F may be provided between the first offset magnetic body and the cap layer 108. In Fig. 14A and 14B, by providing an upper electrode, not illustrated, on the first offset magnetic body 150, a current that has passed between the upper electrode and the lower electrode E1 flows in the first offset magnetic body 150F and the magneotresistance element. Moreover, the upper electrode may be provided between the first offset magnetic body and the cap layer 108.

As shown in Fig. 14B, the current-induced magnetic field causing resistance change of the first magneotresistance element 100 can be offset by the magnetic field of the first offset magnetic body 150F. For example, by setting magnetization of the first offset magnetic body 150F in a substantially parallel direction to the current-induced magnetic field generated from the current to be measured, the current-induced magnetic field causing resistance change of the first magneotresistance element 100 can be offset as shown in Fig. 4A and 4B. Now, as shown in Fig. 14B, when the first offset magnetic body 150F is disposed directly above the first magneotresistance element 100, the direction of the offset magnetic field applied to the first magneotresistance element 100 is the in the opposite direction of the magnetization direction of the first offset magnetic body 150F.

Similar materials to those mentioned in the description of Fig. 8 can be used as materials employed in the first offset magnetic body 150F or the offset magnetic body-dedicated under-layer 151. In the first offset magnetic body disposed in the stacking direction as in Fig. 14A, a leakage magnetic field is generated from an end of the first offset magnetic body 150F. Therefore, if area of the first offset magnetic body 150F is made too large compared to area of the first magneotresistance element 100, the magnetic field from the first offset magnetic body 150F is not applied sufficiently to the first magneotresistance element 100. Therefore, area of the first offset magnetic body 150F must be appropriately set. For example, area of the first offset magnetic body 150F is preferably about not less than equal to and not more than 25 times area of the first magneotresistance element 100. Moreover, the first offset magnetic body 150F may also employ the previously mentioned stacked structure of the offset magnetic body and the offset pinning layer. In this case, the inclination of magnetization of the first offset magnetic body 150F can be easily maintained even when a large current flows instantaneously as the current to be measured and a large current-induced magnetic field is applied to the first offset magnetic body 150F.

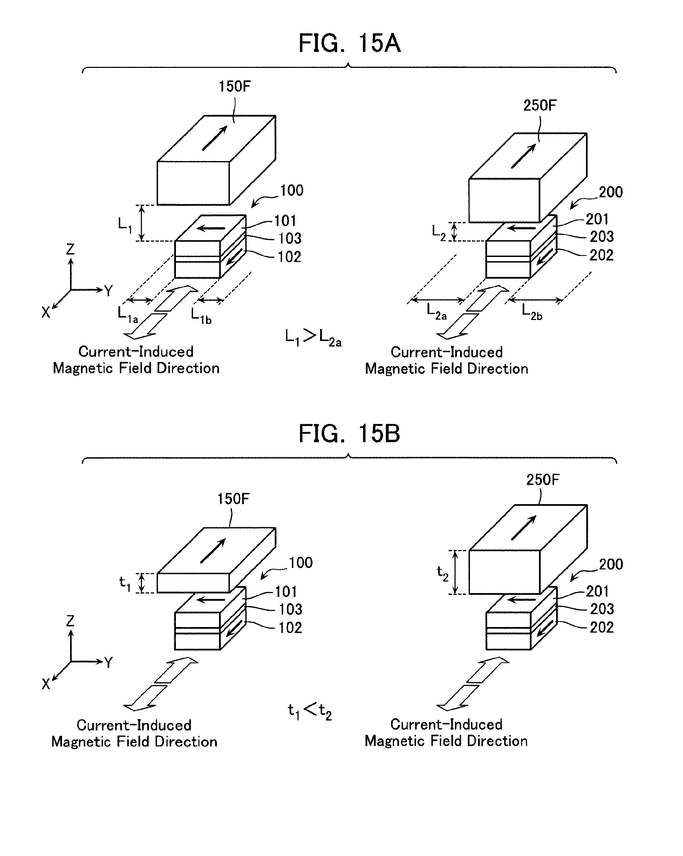

Now, the offset magnetic field H_{offset} of the magneotresistance element can be adjusted by configurations of the first offset magnetic body 150F, and so on. Figs. 15A and 15B show examples where a difference in configurations of the first offset magnetic body 150F and a second offset magnetic body 250F is provided to obtain different offset magnetic fields for two magneotresistance elements. Note that in Figs. 15A and 15B, two magneotresistance elements are taken as an example, but three or more magneotresistance elements may be adopted.

As shown in Fig. 15A, it is possible to change the offset magnetic field by changing a distance between the magneotresistance element and the first and second offset magnetic bodies 150F and 250F. A distance L₁ between the first magneotresistance element 100 and the first offset magnetic body 150F shown in Fig. 15A is set larger than a distance L₂ between the second magneotresistance element 200 and the second offset magnetic body 250F shown in Fig. 15A. In this case, the larger the distance from the first or second offset magnetic bodies 150F and 250F, the smaller becomes the magnetic field applied to the first or second magneotresistance elements 100 and 200. Accordingly, the offset magnetic field H_{offset} of the first or second magneotresistance elements 100 and 200 becomes smaller.

As shown in Fig. 15B, it is possible to change the offset magnetic field by changing film thickness of the first and second offset magnetic bodies 150F and 250F. A film thickness t₁ of the first offset magnetic body 150F shown in Fig. 15B is set smaller than a film thickness t₂ of the second offset magnetic body 250F shown in Fig. 15B. In this case, the larger the film thickness of the first or second offset magnetic bodies 150F and 250F, the larger becomes the magnetic volume of the first or second offset magnetic bodies 150F and 250F. Accordingly, the magnetic field applied to the first or second magneotresistance elements 100 and 200 becomes larger, and the offset magnetic field of the first or second magneotresistance elements 100 and 200 becomes larger.

Fig. 15B described the case where magnetic volume is changed by changing film thickness of the first and second offset magnetic bodies 150F and 250F, but magnetic volume can be changed also by changing a type of magnetic material employed in the first and second offset magnetic bodies 150F and 250F. For example, it is also possible to change magnetic volume and change the offset magnetic field of the first and second magneotresistance elements 100 and 200 by employing magnetic materials having a different saturation magnetization in each of the first offset magnetic body 150F and the second offset magnetic body 250F.

Moreover, as previously mentioned, it is possible to change the offset magnetic field by changing area of the first and second offset magnetic bodies 150F and 250F. When the first and second offset magnetic bodies 150F and 250F are disposed in the stacking direction with respect to the first and second magneotresistance elements 100 and 200, the greater a distance between ends of the first and second offset magnetic bodies 150F and 250F and ends of the first and second magneotresistance elements 100 and 200, the smaller becomes the magnetic field applied to the first and second magneotresistance elements 100 and 200, hence the smaller becomes the offset magnetic field of the first and second magneotresistance elements 100 and 200.

Moreover, similarly to the case of Figs. 11A to 11C where the first and second offset magnetic bodies 150 and 250 are adjoined in a planar surface direction, it is also possible that the first offset magnet body 150 is arranged in a stacking direction, and sensitivity of a plurality of magneotresistance elements may be adjusted by a single first offset magnetic body 150 having different shape in the stacking direction.

### [1-8. In-Stack Type Offset Magnetic Body]

Next, a relationship between the magneotresistance element and the offset magnetic body when the offset magnetic body is included in the magneotresistance element will be described. The description below takes as an example the first magneotresistance element 100 and the first offset magnetic body 150, but the likes of the second magneotresistance element 200 or second offset magnetic body 250, and so on, may also be similarly configured.

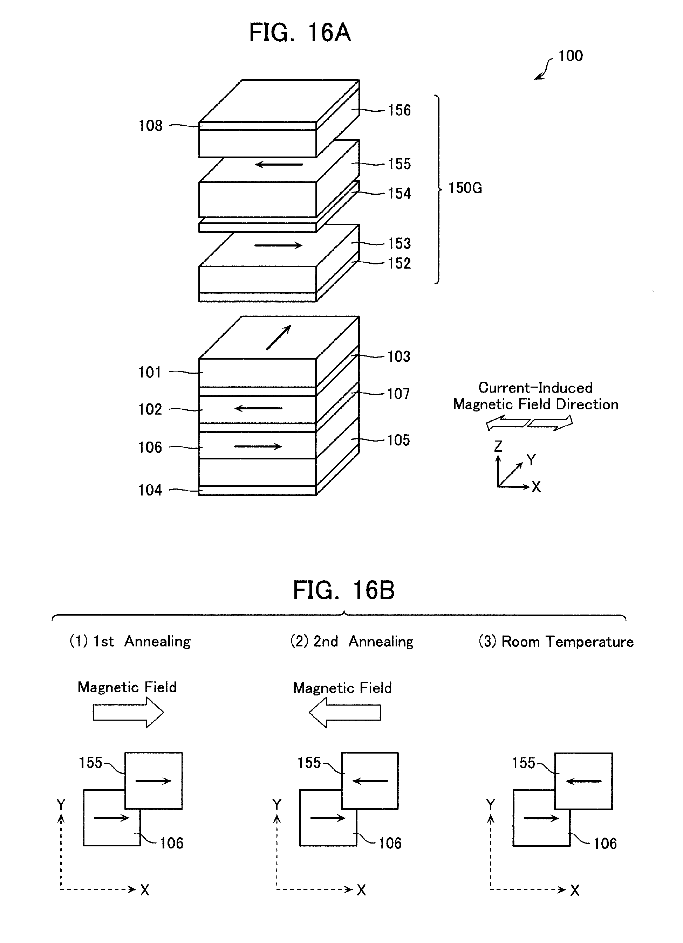

Fig. 16A shows a schematic view of the first magneotresistance element 100 and a first offset magnetic body 150G according to the present embodiment. The first offset magnetic body 150G is one mode of the first offset magnetic body 150.

In the present embodiment shown in Fig. 16A, the first magneotresistance element 100 includes the first offset magnetic body 150G. The first offset magnetic body 150G is configured as an in-stack offset layer configured from a stacked structure. Therefore, the first offset magnetic body 150G can offset the current-induced magnetic field causing resistance change of the first magneotresistance element 100, by an exchange coupling magnetic field between magnetization of an offset magnetic layer included inside the first offset magnetic body 150G and a magnetization free layer. For example, by setting a magnetization direction of the first offset magnetic body 150G substantially parallel to the current-induced magnetic field generated from the current to be measured, the current-induced magnetic field causing resistance change of the first magneotresistance element 100 can be offset as shown in Fig. 4A and 4B.

In the embodiment indicated in Fig. 16A, the first offset magnetic body 150G includes: an isolating layer 152; a first offset magnetic layer 153; an offset magnetic coupling layer 154; a second offset magnetic layer 155; and an offset pinning layer 156.

The first offset magnetic layer 153 and the second offset magnetic layer 155 are formed by a magnetic material, for example. Magnetization of the second offset magnetic layer 155 is fixed in one direction by the offset pinning layer 156. Magnetization of the first offset magnetic layer 153 is set oppositely to magnetization of the second offset magnetic layer 155 that neighbors the first offset magnetic layer 153 via the offset magnetic coupling layer 154. The first offset magnetic layer 153 whose magnetization is fixed in one direction applies an offset to the first magnetic layer 101 by magnetic coupling such as exchange coupling. When employing such a stacked structure of the offset magnetic layer and the offset pinning layer, the inclination of magnetization of the first offset magnetic body 150G can be easily maintained even when a large current flows instantaneously as the current to be measured and a large current-induced magnetic field is applied to the first offset magnetic body 150G.

The isolating layer 152 is formed from the likes of a nonmagnetic material, for example., By physically isolating the first offset magnetic layer 153 and the first magnetic layer 101, intensity of magnetic coupling between the first offset magnetic layer 153 and the first magnetic layer 101 is adjusted. Note that depending on a material of the first offset magnetic layer 153, the isolating layer 152 need not necessarily be provided. Setting magnetization of a plurality of offset magnetic layers to be antiparallel (180°) as in Fig. 16A makes it possible to suppress a leakage magnetic field from the offset magnetic layer to external and suppress magnetic interference other than offset application due to exchange coupling to the magnetization free layer.

As shown in Fig. 16A, the first offset magnetic body 150G includes first offset magnetic layer 153/offset magnetic coupling layer 154/second offset magnetic layer 155, but may be configured by providing only a single-layer first offset magnetic layer 153 between the isolating layer 152 and the offset pinning layer 156. Moreover, three or more layers of offset magnetic layers may be adopted, as in first offset magnetic layer/first magnetic coupling layer/second offset magnetic layer/second magnetic coupling layer/third offset magnetic layer.

Employed in the isolating layer 152 is, for example, Cu of 5 nm. Employed in the first offset magnetic layer 153 is, for example, Fe₅₀Co₅₀ of 3 nm. Employed in the offset magnetic coupling layer 154 is, for example, Ru of 0.9 nm. Employed in the second offset magnetic layer 155 is, for example, Fe₅₀Co₅₀ of 3 nm. Employed in the offset pinning layer 156 is, for example, IrMn of 7 nm.

Employable in the first offset magnetic layer 153 and the second offset magnetic layer 155 is, for example, at least one selected from the group configured by Co, Fe, and Ni. Also employable as the first offset magnetic layer 153 is an alloy including at least one material selected from the group configured by Co, Fe, and Ni. For example, employed in the first offset magnetic layer 153 is a CoₓFe₁₀₀₋ₓ alloy (where x is not less than 0 at. % and not more than 100 at. %), a NiₓFe₁₀₀₋ₓ alloy (where x is not less than 0 at. % and not more than 100 at. %), or a material having a nonmagnetic element added to these alloys. Employed as the first offset magnetic layer 153 is a (CoₓFe₁₀₀₋ₓ)_{100-y}B_{y} alloy (where x is not less than 0 at. % and not more than 100 at. %, and y is not less than 0 at. % and not more than 30 at. %).

Employed in the isolating layer 152 is, for example, a nonmagnetic material. Employable in the isolating layer 152 is, for example, a layer including at least one element selected from the group of Cu, Ru, Rh, Ir, V, Cr, Nb, Mo, Ta, W, Rr, Au, Ag, Pt, Pd, Ti, Zr, and Hf.

The offset pinning layer 156 gives unidirectional anisotropy to the second offset magnetic layer 155 formed contacting the offset pinning layer, and thereby fixes magnetization of the first offset magnetic layer 153. Employed in the offset pinning layer 156 is, for example, an antiferromagnetic layer. Employed in the offset pinning layer 156 is, for example, at least one selected from the group configured by Ir-Mn, Pt-Mn, Pd-Pt-Mn, Ru-Mn, Rh-Mn, Ru-Rh-Mn, Fe-Mn, Ni-Mn, Cr-Mn-Pt, and Ni-O. It is also possible to employ an alloy having an additional element further added to the Ir-Mn, Pt-Mn, Pd-Pt-Mn, Ru-Mn, Rh-Mn, Ru-Rh-Mn, Fe-Mn, Ni-Mn, Cr-Mn-Pt, and Ni-O. A thickness of the offset pinning layer 156 is appropriately set to give sufficiently strong unidirectional anisotropy.

When PtMn or PdPtMn is employed as the offset pinning layer 156, the thickness of the offset pinning layer 156 is preferably not less than 8 nm and not more than 20 nm. The thickness of the offset pinning layer 156 is more preferably not less than 10 nm and not more than 15 nm. When IrMn is employed as the offset pinning layer 156, unidirectional anisotropy may be given to the first offset magnetic layer 153 by an offset pinning layer 156 which is thinner than when PtMn is employed as the offset pinning layer 156. In this case, the thickness of the offset pinning layer 156 is preferably not less than 4 nm and not more than 18 nm. The thickness of the offset pinning layer 156 is more preferably not less than 5 nm and not more than 15 nm.

A hard magnetic layer (hard ferromagnetic material) may be employed as the offset pinning layer 156. For example, a hard magnetic material (hard ferromagnetic material) of comparatively high magnetic anisotropy and coercivity such as Co-Pt, Fe-Pt, Co-Pd, Fe-Pd, and so on, may be employed. Moreover, an alloy having an additional element further added to Co-Pt, Fe-Pt, Co-Pd, and Fe-Pd may be employed. Employable as the hard magnetic layer is, for example, CoPt (where a percentage of Co is not less than 50 at. % and not more than 85 at. %), (CoₓPt₁₀₀₋ₓ)_{100-y}Cr_{y} (where x is not less than 50 at. % and not more than 85 at. %, and y is not less than 0 at. % and not more than 40 at. %), or FePt (where a percentage of Pt is not less than 40 at. % and not more than 60 at. %), and so on.

The offset magnetic coupling layer 154 generates antiferromagnetic coupling between the first offset magnetic layer 153 and the second offset magnetic layer 155. The offset magnetic coupling layer 154 forms a synthetic pin structure. Employed as the offset magnetic coupling layer 154 is, for example, Ru. A thickness of the offset magnetic coupling layer 154 is preferably not less than 0.8 nm and not more than 1 nm. A material other than Ru may be employed as the offset magnetic coupling layer 154, provided it is a material generating sufficient antiferromagnetic coupling between the first offset magnetic layer 153 and the second offset magnetic layer 155. The thickness of the offset magnetic coupling layer 154 may be set to a thickness of not less than 0.8 nm and not more than 1 nm corresponding to a second peak of RKKY (Ruderman-Kittel-Kasuya-Yosida) coupling. Furthermore, the thickness of the offset magnetic coupling layer 154 may be set to a thickness of not less than 0.3 nm and not more than 0.6 nm corresponding to a first peak of RKKY coupling. Employed as the offset magnetic coupling layer 154 is, for example, Ru having a thickness of 0.9 nm. As a result, highly reliable coupling can be more stably obtained.

A thickness of the first offset magnetic layer 153 is preferably not less than 1.5 nm and not more than 5 nm, for example. A thickness of the second offset magnetic layer 155 is preferably not less than 1.5 nm and not more than 5 nm, for example. As a result, for example, intensity of the unidirectional anisotropic magnetic field due to the offset pinning layer 156 can be more greatly strengthened. Magnetic film thickness (product (Bs·t) of saturation magnetization Bs and thickness t) of the first offset magnetic layer 153 is preferably substantively equal to magnetic film thickness of the second offset magnetic layer 155.

A direction of the offset magnetic field applied to the first magnetic layer 101 from the first offset magnetic body 150G can be set to any direction with respect to the magnetization direction of the second magnetic layer 102.

Fig. 16B is a schematic view for explaining a setting method of the magnetization direction in the first offset magnetic body 150G. For example, it is also possible to set the direction of the offset magnetic field applied to the first magnetic layer 101 from the first offset magnetic body 150G to 180° with respect to the magnetization direction of the second magnetic layer 102. Such a setting of direction of the offset magnetic field is made possible by selecting two-step annealing in a magnetic field and selecting configuration of materials employed in the pinning layer 105 and configuration of materials employed in the offset pinning layer 156.

Regarding an antiferromagnetic material employed in the pinning layer 105 or offset pinning layer 156, a temperature at which magnetization fixing occurs differs according to composition of the antiferromagnetic material. For example, regarding a material that belongs to ordered alloys such as PtMn, the temperature at which magnetization fixing is performed therein is higher compared to a material that belongs to disordered alloys but causes magnetization fixing such as IrMn. For example, it is possible to employ PtMn in the pinning layer 105 and IrMn in the offset pinning layer 156.

Next, two-step heat treatment in a magnetic field such as shown in Fig. 16B is performed. For example, as indicated in (1) of Fig. 16B, annealing is performed for 10 hours at 320°C while applying an external magnetic field in a rightward direction of Fig. 16B. As a result, the magnetization direction of the second magnetization fixed layer 106 contacting the pinning layer 105 is fixed facing right. Moreover, the magnetization direction of the second offset magnetic layer 155 contacting the offset pinning layer 156 is once fixed facing right.

Next, for example, as indicated in (2) of Fig. 16B, annealing is performed for one hour at 250°C while applying an external magnetic field in a leftward direction of Fig. 16B. As a result, the magnetization direction of the second magnetization fixed layer 106 contacting the pinning layer 105 remains unchanged facing right, and the magnetization direction of the second offset magnetic layer 155 contacting the offset pinning layer 156 is fixed facing left. As shown in the diagram on the right of Fig. 16B, this orientation of magnetization is maintained at room temperature.

Selection of the method of annealing in a magnetic field and of configuration of the material of the pinning layer 105 and configuration of the material of the offset pinning layer 156 in this way makes it possible to set the direction of the offset magnetic field to the first magnetic layer 101 and the second magnetic layer 102 as desired. In addition, a temperature difference of magnetization fixing of the pinning layer 105 and the offset pinning layer 156 can also be set not only by selection of respective materials but also by a film thickness of the respective layers. For example, it is possible to perform the alignment of magnetization directions of the kind shown in Fig. 16A by performing the two-step annealing in a magnetic field shown in Fig. 16B, even when IrMn of 7 nm is employed in the pinning layer 105 and IrMn of 5 nm is employed in the offset pinning layer 156.

Now, the offset magnetic field applied to the magneotresistance element can be adjusted by the configuration of the in-stack offset layer. For example, the first magneotresistance element 100 and first offset magnetic body 150G are configured as shown in Fig. 16A, and the second magneotresistance element 200 and second offset magnetic body 250 are further configured similarly to these. However, in the second offset magnetic body 250, the isolating layer 152 is made thicker compared to in the first offset magnetic body 150G. As a result, the offset magnetic field for the first magneotresistance element 100 weakens relatively. In addition, it is possible to change the offset magnetic field also by differentiating thicknesses of the first offset magnetic layer 153 and the second offset magnetic layer 155 between the two magneotresistance elements. In this case, increasing the thicknesses of the first offset magnetic layer 153 and the second offset magnetic layer 155 causes the offset magnetic field applied to the first magnetic layer 101 to weaken.

Moreover, the direction of the offset magnetic field applied to the magneotresistance element can also be adjusted by the number of offset magnetic layers mediated by the offset magnetic coupling layer 154 included in the in-stack offset layer. For example, when the number of offset magnetic layers is an even number such as two as shown in Fig. 16A, the inclination of magnetization of the second offset magnetic layer 155 contacting the offset pinning layer 156 and the inclination of magnetization of the first offset magnetic layer 153 close to the first magnetic layer 101 are opposite. However, when the number of offset magnetic layers is set to an odd number, the inclination of magnetization of the offset magnetic layer contacting the offset pinning layer 156 and the inclination of magnetization of the offset magnetic layer close to the first magnetic layer 101 are in the same direction. Hence, when the offset direction due to the in-stack offset layer is substantially parallel to the magnetization direction of the pinning layer of the magneotresistance element, selection of positive/negative of the magnetization direction of the in-stack offset layer does not necessarily require the two-step annealing shown in Fig. 16B, and may be determined in a one-stage annealing, depending on the number of offset magnetic layers.

### [1-9. Manufacturing Method]

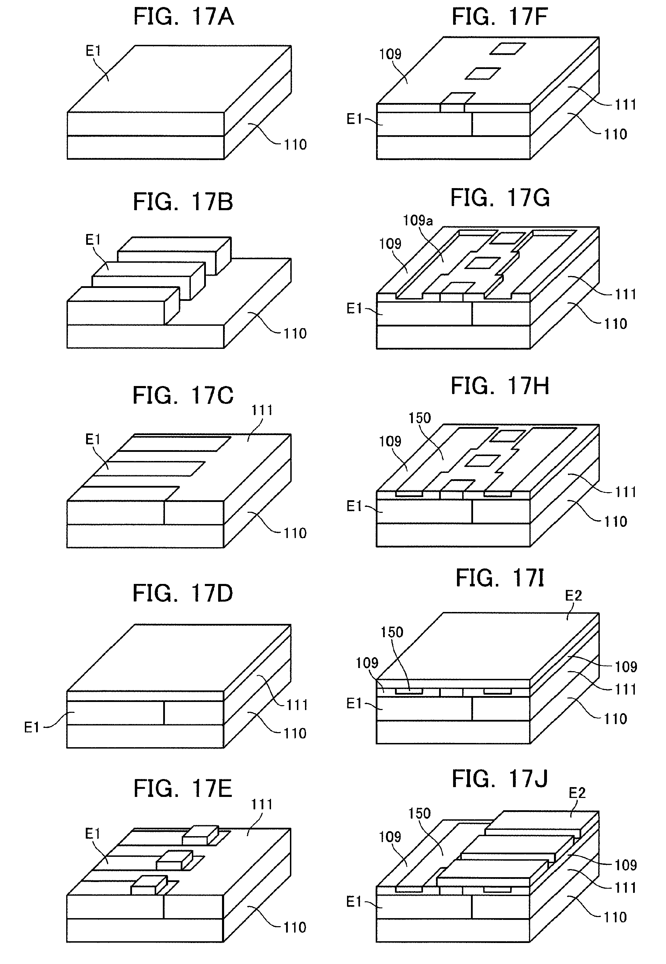

Next, a manufacturing method of the current sensor according to the present embodiment will be described. Figs. 17A to 17J are stepwise schematic perspective views illustrating the manufacturing method of the current sensor according to the present embodiment.

As indicated in Fig. 17A, the lower electrode E1 is formed on a substrate 110. For example, Ta(5 nm)/Cu(200 nm)/Ta(35 nm) is formed. After this, surface smoothing processing such as CMP processing is performed on an outermost surface of the lower electrode E1, and a configuration formed on the lower electrode E1 may be planarized.

Next, as shown in Fig. 17B, a planar shape of the lower electrode E1 is processed. In this step, resist undergoes patterning by photolithography, and then physical milling or chemical milling are implemented using a resist pattern not illustrated as a mask. For example, Ar ion milling is implemented.

Next, as shown in Fig. 17C, film formation filling a periphery of the lower electrode E1 with an insulating layer 111 is performed. In this step, for example, a lift-off step is performed. For example, the insulating layer 111 is formed on the entire surface in a state where the resist pattern formed by photolithography of Fig. 17B is left unchanged, and then the resist pattern is removed. Employable as the insulating layer 111 are, for example, SiOₓ, AlOₓ, SiNₓ, AlNₓ, and so on.

Next, inter-electrode configurations of the magneotresistance element are deposited on the lower electrode E1. For example, Ta (3 nm)/Ru(2 nm) is formed as the under-layer 104. IrMn(7 nm) is formed thereon as the pinning layer 105. Co₇₅Fe₂₅ (2.5 nm)/Ru(0.9 nm)/Co₄₀Fe₄₀B₂₀ (3 nm) is formed thereon as the second magnetic layer 102. MgO (2 nm) is formed thereon as the intermediate layer 103. Co₄₀Fe₄₀B₂₀ (2 nm)/Ta(0.4 nm) /Ni₈₀Fe₂₀ (6 nm) is formed thereon as the first magnetic layer 101. Cu(1 nm)/Ta(2 nm)/Ru(5 nm) is formed thereon as the cap layer 108.

Next, annealing in a magnetic field that fixes the magnetization direction of the second magnetic layer 102 is performed. For example, annealing for one hour at 300°C while applying an external magnetic field of 7 kOe is performed. For example, the annealing is performed applying the external magnetic field substantially parallel to a direction in which the current-induced magnetic field is applied(X direction). Now, when the previously-mentioned offset magnetic body (150G, Fig. 16A) provided with an in-stack bias layer is employed, for example, two-step annealing may be performed.

Next, as shown in Fig. 17E, a planar shape of the inter-electrode configurations of the magneotresistance element is processed. In this step, resist undergoes patterning by photolithography, and then physical milling or chemical milling are implemented using a resist pattern not illustrated as a mask. This step makes it possible to batch process a plurality of configurations as shown in Fig. 17E.

Next, as shown in Fig. 17F, film formation filling a periphery of the inter-electrode configurations of the magneotresistance element with an insulating layer 109 is performed. In this step, for example, a lift-off step is performed. For example, the insulating layer 109 is formed on the entire surface in a state where the resist pattern formed by photolithography of Fig. 17E is left unchanged, and then the resist pattern is removed. Employable as the insulating layer 109 are, for example, SiOₓ, AlOₓ, SiNₓ, AlNₓ, and so on.

Next, as shown in Fig. 17G, a hole 109a for embedding the first offset magnetic body 150 provided adjacent to the inter-electrode configurations of the magneotresistance element is formed. In this step, resist undergoes patterning by photolithography, and then physical milling or chemical milling are implemented using a resist pattern not illustrated as a mask. Fig. 17G takes as an example the case where a pair of first offset magnetic bodies 150E are formed with respect to a plurality of magneotresistance elements, but batch processing can be performed even when offset magnetic bodies are formed individually with respect to a plurality of magneotresistance elements. In this step, processing may be performed until the hole 109a penetrates the insulating layer 109, or may be stopped along the way. Fig. 17G illustrates the case where processing is stopped along the way. Although mentioned later, when the hole 109a is etched until it penetrates the insulating layer 109, an insulating layer not illustrated needs to be formed under the first offset magnetic body 150 in an embedding step of the first offset magnetic body 150 shown in Fig. 17H.

Next, as shown in Fig. 17H, the first offset magnetic body 150 is embedded in the hole 109a formed in Fig. 17G. In this step, for example, a lift-off step is performed. For example, the first offset magnetic body 150 is deposited on the entire surface in a state where a resist pattern formed by photolithography of Fig. 17H is left unchanged, and then the resist pattern is removed. Now, for example, Cr(5 nm) is formed as the first offset magnetic body 150-dedicated under-layer, and, for example, Co₈₀Pt₂₀(20 nm) is formed thereon as the first offset magnetic body 150. A cap layer not illustrated may be further formed thereon. Employable as this cap layer is the material mentioned above as a material usable in the cap layer 108 of the magneotresistance element, or an insulating layer of the likes of SiOₓ, AlOₓ, SiNₓ, and AlNₓ. In Fig. 17H, after the first offset magnetic body 150 has been embedded, an external magnetic field is applied at room temperature to perform setting of the magnetization direction of the hard magnetic layer (hard ferromagnetic material) included in the first offset magnetic body 150. For example, application of an external magnetic field in a substantially parallel direction to the direction of the current-induced magnetic field is performed. Setting of the magnetization direction of the first offset magnetic body 150 by this external magnetic field, provided it is performed after embedding of the first offset magnetic body 150, may be performed at timings such as before removal of the resist pattern, after removal of the resist pattern, after processing of the upper electrode shown in Fig. 17J, and so on.

Next, as shown in Fig. 17I, the upper electrode E2 is deposited. Next, as shown in Fig. 17J, a planar shape of the upper electrode E2 is processed. In this step, resist undergoes patterning by photolithography, and then physical milling or chemical milling are performed using a resist pattern not illustrated as a mask.

The manufacturing method according to such a mode makes it possible to manufacture the current sensor according to the present embodiment without increase in the number of steps. Note that although not illustrated in Figs. 17A to 17J, formation of a contact hole to the lower electrode E1 may be performed, or a protective film may be formed after processing of the upper electrode E2.

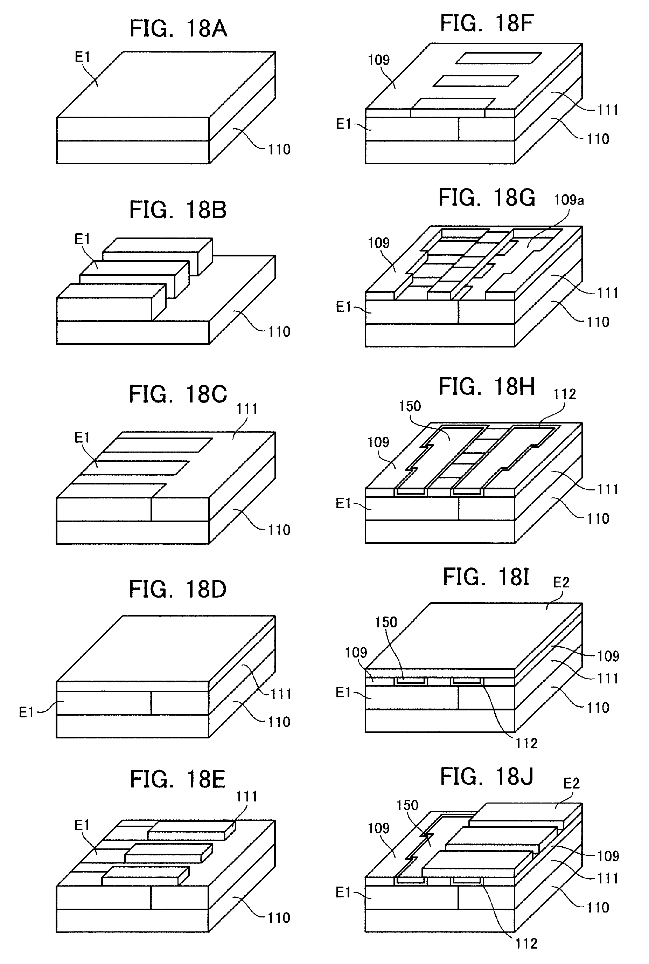

Next, another manufacturing method of the current sensor according to the present embodiment will be described. Figs. 18A to 18J are stepwise schematic perspective views illustrating the other manufacturing method of the current sensor according to the present embodiment. Note that steps shown in Figs. 18A to 18D are similar to steps shown in Figs. 17A to 17D, hence descriptions thereof will be omitted.

As shown in Fig. 18E, a planar shape of the inter-electrode configurations of the magneotresistance element is processed. This step is performed substantially similarly to the step shown in Fig. 17E, but differs in that a dimension in the Y direction of the stacked first magnetic layer 101, and so on, is made longer than a final dimension.

Next, as shown in Fig. 18F, film formation filling a periphery of the stacked body with an insulating layer is performed. This step is performed similarly to the step shown in Fig. 17F.

Next, as shown in Fig. 18G, a hole 109a for embedding the first offset magnetic body 150 provided adjacent to the inter-electrode configurations of the magneotresistance element is formed. In this step, resist undergoes patterning by photolithography, and then physical milling or chemical milling are implemented using a resist pattern not illustrated as a mask. Fig. 18G takes as an example the case where a pair of first offset magnetic bodies 150E are formed with respect to a plurality of magneotresistance elements, but batch processing can be performed even when offset magnetic bodies are formed individually with respect to a plurality of magneotresistance elements. Fig. 18G shows an example where etching is performed until the hole 109a penetrates the insulating layer 109. In the example shown in Fig. 18G, processing is performed such that a dimension in the X direction of the stacked first magnetic layer 101, and so on, attains the final dimension by this etching.

Next, as shown in Fig. 18H, the first offset magnetic body 150 is embedded in the hole 109a formed in Fig. 18G. In this step, for example, a lift-off step is performed. For example, the first offset magnetic body 150 is deposited on the entire surface in a state where a resist pattern formed by photolithography of Fig. 18H is left unchanged, and then the resist pattern is removed. Now, the hole 109a has penetrated the insulating layer 109, hence formation of an insulating layer 112 as a first layer of the embedding step of the first offset magnetic body 150 is performed. The insulating layer 112 is formed by, for example, depositing a 10 nm film of SiOₓ. Now, the formed insulating layer 112 is deposited also on a sidewall of the hole 109a. Therefore, the insulating layer 112 deposited on the sidewall enables the magneotresistance element and the first offset magnetic body 150 to be insulated and furthermore enables a distance between these to be adjusted in a preferred manner. Then, the first offset magnetic body 150 is embedded by a similar step to the step shown in Fig. 17H, for example. In Fig. 18H, after the first offset magnetic body 150 has been embedded, an external magnetic field is applied at room temperature to perform setting of the magnetization direction of the hard ferromagnetic material included in the first offset magnetic body 150. For example, application of an external magnetic field in a substantially parallel direction to the direction of the current-induced magnetic field is performed. Setting of the magnetization direction of the first offset magnetic body 150 by this external magnetic field, provided it is performed after embedding of the first offset magnetic body 150, may be performed at timings such as before removal of the resist pattern, after removal of the resist pattern, after processing of the upper electrode shown in Fig. 18J, and so on.

Next, as shown in Fig. 18I, the upper electrode E2 is formed. Next, as shown in Fig. 18J, a planar shape of the upper electrode E2 is processed. This step is performed similarly to the step described using Fig. 17J.

The manufacturing method according to such a mode also makes it possible to manufacture the current sensor according to the present embodiment without increase in the number of steps. Note that although not illustrated in Figs. 18A to 18J, formation of a contact hole to the lower electrode E1 may be performed, or a protective film may be formed after processing of the upper electrode E2.

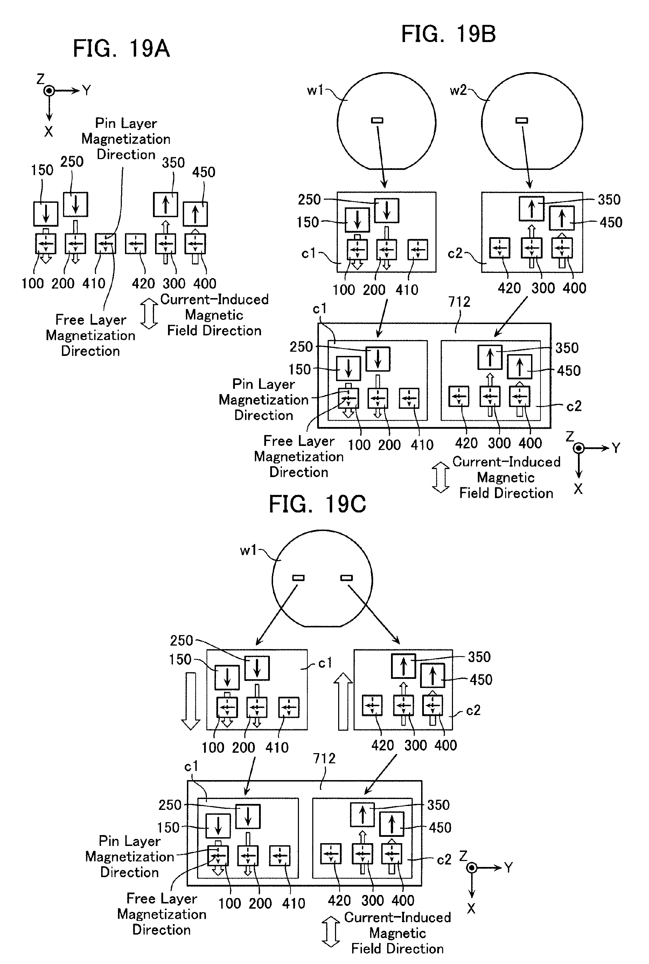

Fig. 19A and 19B show one example of the current sensor according to the present embodiment. Fig. 19A shows an example of arrangement of a current sensor including magneotresistance elements having reversely-directed offset magnetic fields applied thereto. When measuring positive/negative current-induced magnetic fields in such cases as when the current to be measured is an alternating current, it is desirable to employ a magneotresistance element group having inclinations of the offset magnetic fields configured to be reversely-directed. Such reversely-directed offset magnetic fields can be achieved by configuring the inclinations of magnetization of the offset magnetic bodies to be reversely-directed. Moreover, setting of the direction of magnetization of the offset magnetic bodies can be performed freely by the previously mentioned method.

That is, as shown in Fig. 19A, in the present embodiment, arranged in the Y direction on the substrate are a first magneotresistance element 100, a second magneotresistance element 200, a fifth magneotresistance element 410, a sixth magneotresistance element 420, a third magneotresistance element 300, and a fourth magneotresistance element 400. Moreover, respectively provided to X direction-facing surfaces of the first magneotresistance element 100, the second magneotresistance element 200, the third magneotresistance element 300, and the fourth magneotresistance element 400 are a first offset magnetic body 150, a second offset magnetic body 250, a third offset magnetic body 350, and a fourth offset magnetic body 450. Furthermore, the first offset magnetic body 150 and the fourth offset magnetic body 450 are disposed close to the first magneotresistance element 100 and the fourth magneotresistance element 400, respectively. On the other hand, the second offset magnetic body 250 and the third offset magnetic body 350 are disposed close to the second magneotresistance element 200 and the third magneotresistance element 300, respectively.

Note that the fourth through sixth magneotresistance elements 400, 410, and 420 have similar configurations to the first through third magneotresistance elements 100, 200, and 300. Furthermore, the third offset magnetic body 350 and the fourth offset magnetic body 450 are modes of the offset magnetic body and have similar configurations to the first offset magnetic body 150 and the second offset magnetic body 250.

In such a configuration, a strong offset magnetic field is applied in the X direction to the first magneotresistance element 100, and a weak offset magnetic field is applied in the X direction to the second magneotresistance element 200. Moreover, a strong offset magnetic field is applied in the -X direction to the fourth magneotresistance element 400, and a weak offset magnetic field is applied in the -X direction to the third magneotresistance element 300. Note that the number of magneotresistance elements is appropriately changeable, and, furthermore, it is also possible for the fifth magneotresistance element 410 or the sixth magneotresistance element 420 to be omitted.

The magneotresistance element group shown in Fig. 19A having inclinations of offset magnetic fields configured to be reversely-directed can be separately made on an identical substrate, using the previously-mentioned offset magnetic body configuration and two-step heat-treatment method. On the other hand, as shown in Fig. 19B, it is also possible that element group having inclination of magnetization of the offset magnetic body parallel to the inclination of magnetization of the second magnetic layer is made on a substrate w1, and element group having inclination of magnetization of the offset magnetic body antiparallel to the inclination of magnetization of the second magnetic layer is made on a different substrate w2. Thereafter, such substrates w1 and w2 are cut to chips c1 and c2. Then, these chips c1 and c2 are disposed aligned on a sensor substrate module 712. Such a manufacturing method is easier than when producing reversely-directed magnetic bodies on an identical substrate.

Moreover, as shown in Fig. 19C, it is also possible to produce a plurality of magneotresistance elements and offset magnetic bodies with identical configurations on an identical substrate w1, and then after cutting these out into chips c1, c2, and so on, apply external magnetic fields to the chips c1 and c2 to produce chips c1 and c2 in which directions of magnetization of the offset magnetic bodies are different. Chips produced in this way may be disposed aligned on the sensor substrate module 712.

The arrangements or manufacturing methods of the magneotresistance element groups having inclinations of offset magnetic fields configured to be reversely-directed of the kind shown in Fig. 19A may be applied to any embodiments of the offset magnetic body described in the present specification.

### [2. Current Sensor according to Second Embodiment]

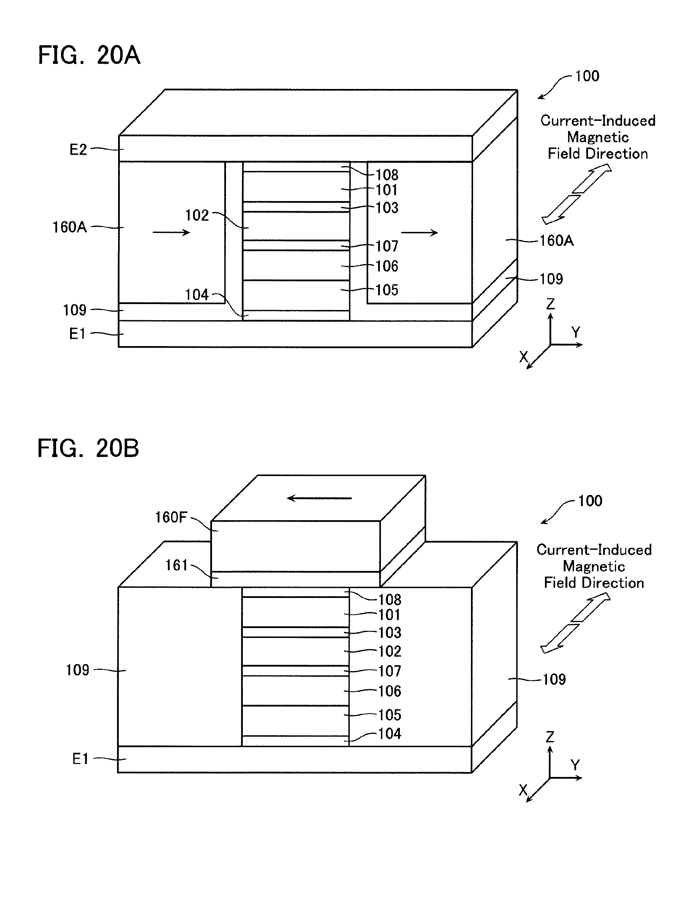

Next, a configuration of a current sensor according to a second embodiment will be described. The current sensor according to the present embodiment is configured substantially similarly to the current sensor according to the above-described embodiment, but differs in including a linear response magnetic body instead of the offset magnetic body. Fig. 20A is a schematic view of the first magneotresistance element 100 and a first linear response magnetic body 160A. The first linear response magnetic body 160A is one mode of the linear response magnetic body. The first linear response magnetic body 160A is configured substantially similarly to the first offset magnetic body 150A, but differs in applying a magnetic field to the first magneotresistance element 100 in a direction substantially perpendicular to the current magnetic field due to the current to be measured. Note that selection of a material of the linear response magnetic body is performed similarly to that of the offset magnetic body. Also, when a stacked body of the linear response magnetic body and a linear response magnetic body-dedicated pinning layer is employed, a similar configuration to the configuration described in the offset magnetic body may be employed. When employing such a stacked structure of the linear response magnetic body and the linear response magnetic body-dedicated pinning layer, the inclination of magnetization of the linear response magnetic body can be easily maintained even when a large current flows instantaneously as the current to be measured and a large current-induced magnetic field is applied to the linear response magnetic body.

The magnetization direction of the first magnetic layer 101 in a state where not applied with an external magnetic field can be set to a desired direction by the magnetic field of the first linear response magnetic body 160A. For example, setting the magnetization direction of the first linear response magnetic body 160A to an orthogonal direction to the magnetization direction of the second magnetic layer 102 makes it possible to orthogonalize the magnetization direction of the first magnetic layer 101 and the magnetization direction of the second magnetic layer 102, as shown in Fig. 3B. Intersecting (orthogonalizing) the magnetization direction of the first magnetic layer 101 and the magnetization direction of the second magnetic layer 102 enables linear responsiveness to positive/negative magnetic fields, as shown in Fig. 3D. Note that such a first linear response magnetic body 160A may be used in combination with the previously mentioned offset magnetic body.

Similar materials to those of the previously mentioned offset magnetic body may be employed in the first linear response magnetic body 160A and a under-layer not illustrated. Now, sensitivity ((dR/R)/2Hs) of the magneotresistance element can be adjusted by the configuration of the first linear response magnetic body 160A. The previously-mentioned method of adjusting magnitude of the offset magnetic field by means of layout of the offset magnetic body can be applied also in the case of the first linear response magnetic body 160A. In the case of the first linear response magnetic body 160A, if the offset magnetic field is increased by the previously-mentioned method, the magnetic field reaches a saturation magnetic field Hs. The larger the saturation magnetic field Hs is set, the lower the sensitivity is set.

Fig. 20B is a schematic view of the first magneotresistance element 100 and a first linear response magnetic body 160F. The first linear response magnetic body 160F is one mode of the linear response magnetic body. The first linear response magnetic body 160F is configured substantially similarly to the first offset magnetic body 150F, but differs from the first offset magnetic body 150F in applying a magnetic field to the first magneotresistance element 100 in a direction substantially perpendicular to the current magnetic field due to the current to be measured. Note that in Fig. 20B, the upper electrode E2 is omitted.

Employing the first linear response magnetic body 160F makes it possible to obtain similar advantages to when employing the above-mentioned first linear response magnetic body 160A. Now, the first linear response magnetic body 160F is provided in a stacking direction of the first magnetic layer 101, and so on, hence a leakage magnetic field from the first linear response magnetic body 160F to the first magnetic layer 101 is reversely-directed to the magnetization direction of the first linear response magnetic body 160F. Note that such a first linear response magnetic body 160F may be used in combination with the previously mentioned offset magnetic body.

Selection of material and adjustment of sensitivity of the first linear response magnetic body 160F may be performed similarly to those of the first linear response magnetic body 160A.

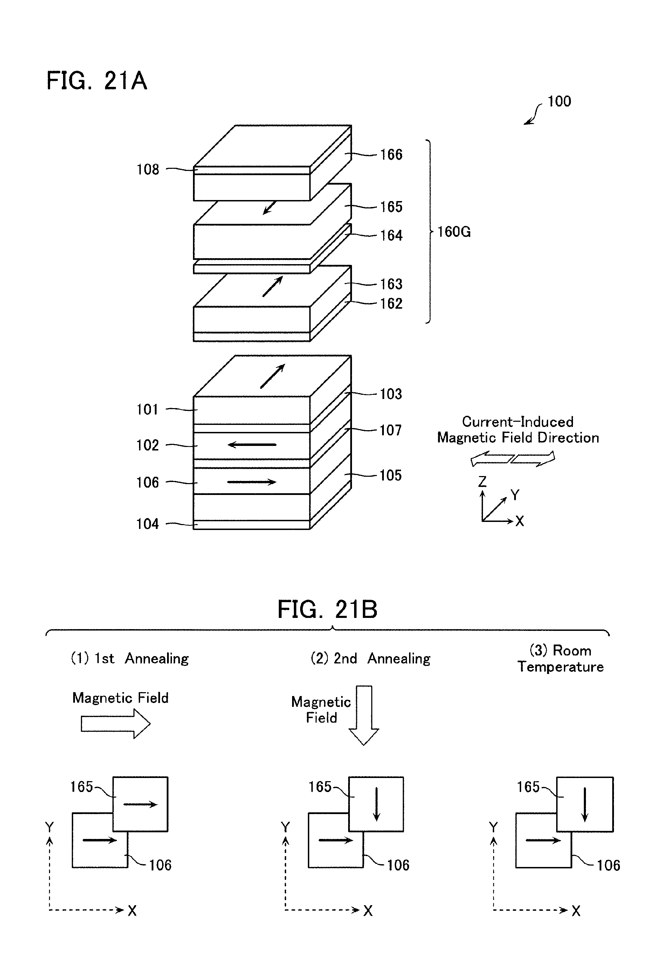

Fig. 21A shows a schematic view of the first magneotresistance element 100 and a first linear response magnetic body 160G according to another configuration. The first linear response magnetic body 160G is one mode of the first linear response magnetic body 160. The first linear response magnetic body 160G is configured substantially similarly to the first offset magnetic body 150G, but differs from the first offset magnetic body 150G in applying a magnetic field to the first magneotresistance element 100 in a direction substantially perpendicular to the current magnetic field due to the current to be measured.

Employing the first linear response magnetic body 160G makes it possible to obtain similar advantages to when employing the above-mentioned first linear response magnetic body 160A.

The first linear response magnetic body 160G indicated in Fig. 21 includes: an isolating layer 162; a first bias magnetic layer 163; a bias magnetic coupling layer 164; a second bias magnetic layer 165; and a bias pinning layer 166. Note that selection of material or adjustment of film thickness, and so on, of these layers is performed similarly to those of the isolating layer 152, the first offset magnetic layer 153, the offset magnetic coupling layer 154, the second offset magnetic layer 155, and the offset pinning layer 156, respectively.

The direction of the magnetic field applied to the first magnetic layer 101 from the first linear response magnetic body 160G can be set to any direction with respect to the magnetization direction of the second magnetic layer 102.

Fig. 21B is a schematic view for explaining a setting method of the magnetization direction in the first linear response magnetic body 160G. For example, it is also possible to set the direction of the magnetic field applied to the first magnetic layer 101 from the first linear response magnetic body 160G to 90° (or 270°) with respect to the magnetization direction of the second magnetic layer 102. Such a setting of direction of the magnetic field is made possible by a method substantially similar to the method described using Fig. 16B. However, as indicated in the diagram in the center of Fig. 21B, the method shown in the present embodiment differs in performing annealing while applying an external magnetic field in a downward direction of Fig. 21B. As a result, the magnetization direction of the second magnetization fixed layer 106 contacting the pinning layer 105 remains unchanged facing right, and the magnetization direction of the second bias magnetic layer 165 contacting the bias pinning layer 166 is fixed facing downward. As shown in the diagram on the right of Fig. 21B, this orientation of magnetization is maintained at room temperature.

Now, sensitivity ((dR/R)/2Hs) of the magneotresistance element in the present embodiment can be adjusted by adjusting film thicknesses of the isolating layer 162, the first bias magnetic layer 163, and the second bias magnetic layer 165, similarly to in the adjustment method of the offset magnetic field in the embodiment described using Fig. 16.

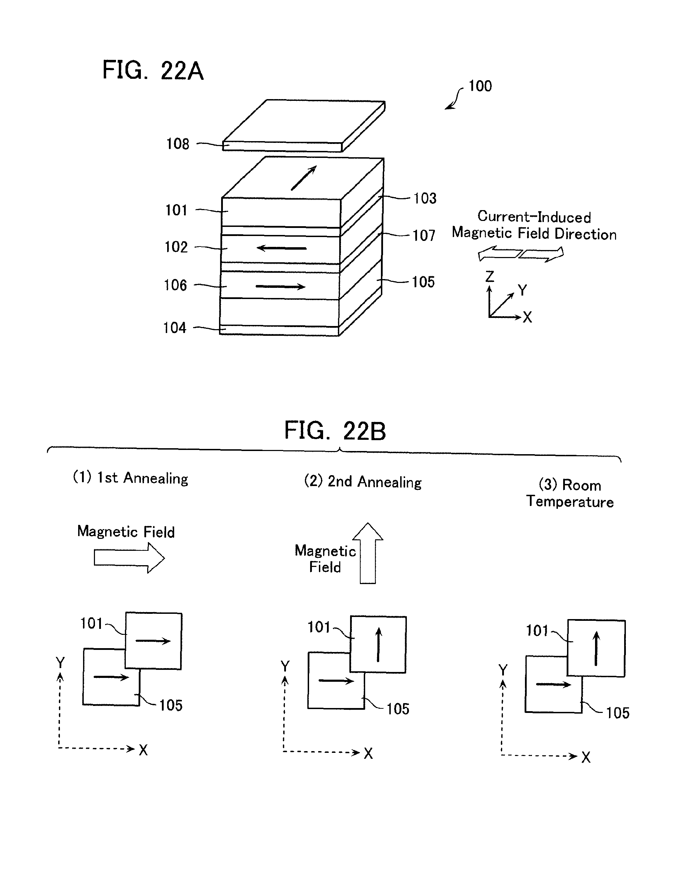

Note that the description heretofore described performing two-step annealing in a magnetic field for setting the respective magnetization directions of the first offset magnetic body 150G and the first linear response magnetic body 160G. Now, when employing such a two-step annealing in a magnetic field, it is also possible to set the magnetization direction of the first magnetic layer 101. Fig. 22A is a schematic view for explaining a method for this. Such a method enables the magnetization direction of a magnetization free layer to be orthogonalized with the magnetization direction of a magnetization fixed layer, as shown in Fig. 3B, for example, and enables linear responsiveness to positive/negative magnetic fields, as shown in Fig. 3D.

In order to set the magnetization direction of the first magnetic layer 101 and the magnetization direction of the second magnetic layer 102 to different directions, for example, a first heat treatment in a magnetic field is performed as shown in the diagram on the left of Fig. 22B. The first heat treatment in a magnetic field is performed by, for example, performing annealing for 10 hours at 320°C while applying an external magnetic field in a rightward direction of Fig. 22B. As a result, the magnetization direction of the second magnetization fixed layer 106 contacting the pinning layer 105 is fixed facing right.

Next, for example, a second heat treatment in a magnetic field is performed. The second heat treatment in a magnetic field is performed by, for example, performing annealing while applying an external magnetic field in an upward direction of Fig. 22B, as shown in the diagram in the center of Fig. 22B. A temperature at this time is a temperature lower than 320°C, and is set to a temperature lower than a magnetization fixing temperature of an antiferromagnetic body employed in the bias pinning layer 166. As a result, the magnetization direction of the first magnetic layer 101 can be set facing upward, with the magnetization direction of the second magnetization fixed layer 106 unchanged set facing right. That is, a direction of induction magnetic anisotropy of the first magnetic layer 101 can be set in an up/down direction.

Now, sensitivity ((dR/R)/2Hs) of the magneotresistance element can be adjusted by temperature or time of second heat treatment in a magnetic field among the two-step annealing. For example, after the first magneotresistance element 100 and the second magneotresistance element 200 is produced, a time of the second heat treatment in a magnetic field during manufacturing of the first magneotresistance element 100 is set longer than a time of the second heat treatment in a magnetic field during manufacturing of the second magneotresistance element 200. Due to this, the induction magnetic anisotropy of the first magnetic layer of the second magneotresistance element 200 becomes higher than that of the first magneotresistance element 100, hence Hs increases and sensitivity ((dR/R)/2Hs) is set low.

### [3. Current Sensor according to Third Embodiment]

Next, a current sensor according to a third embodiment will be described. The current sensor according to the present embodiment is configured substantially similarly to the current sensor according to the first embodiment, but differs in including both an offset magnetic body and a linear response magnetic body. Note that in the present embodiment, the previously mentioned offset magnetic body and linear response magnetic body can be employed in combination as far as it is possible from a structural viewpoint.

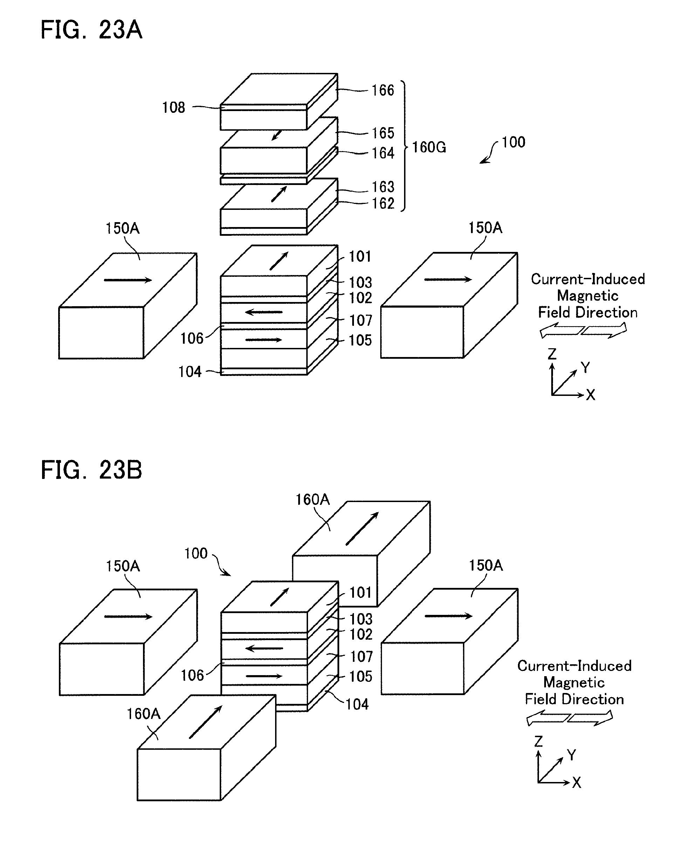

Fig. 23 is a schematic view showing a configuration of a current sensor using an offset magnetic body and a linear response magnetic body in combination. The example shown in Fig. 23A shows the case where the first offset magnetic body 150A is disposed laterally adjacent to the first magneotresistance element 100 and the first linear response magnetic body 160G employing the in-stack bias layer is provided in the first magneotresistance element 100. The first linear response magnetic body 160G makes it possible to improve linearity of resistance change with respect to the external magnetic field, and the first offset magnetic body 150A makes it possible to offset the current-induced magnetic field causing the resistance change.

The example shown in Fig. 23B shows the case where the first offset magnetic bodies 150A are provided laterally in a parallel direction to the current-induced magnetic field of the first magneotresistance element 100, and the first linear response magnetic bodies 160A are provided laterally in a perpendicular direction to the current-induced magnetic field of the first magneotresistance element 100. The combination in this case also enables similar advantages to those of the combination of Fig. 23A to be displayed.

Note that the combinations of offset magnetic bodies and linear response magnetic bodies shown in Figs. 23A and 23B are merely examples, and that each of the previously mentioned structures can be combined in a structurally achievable range.

### [4. Current Sensor according to Fourth Embodiment]

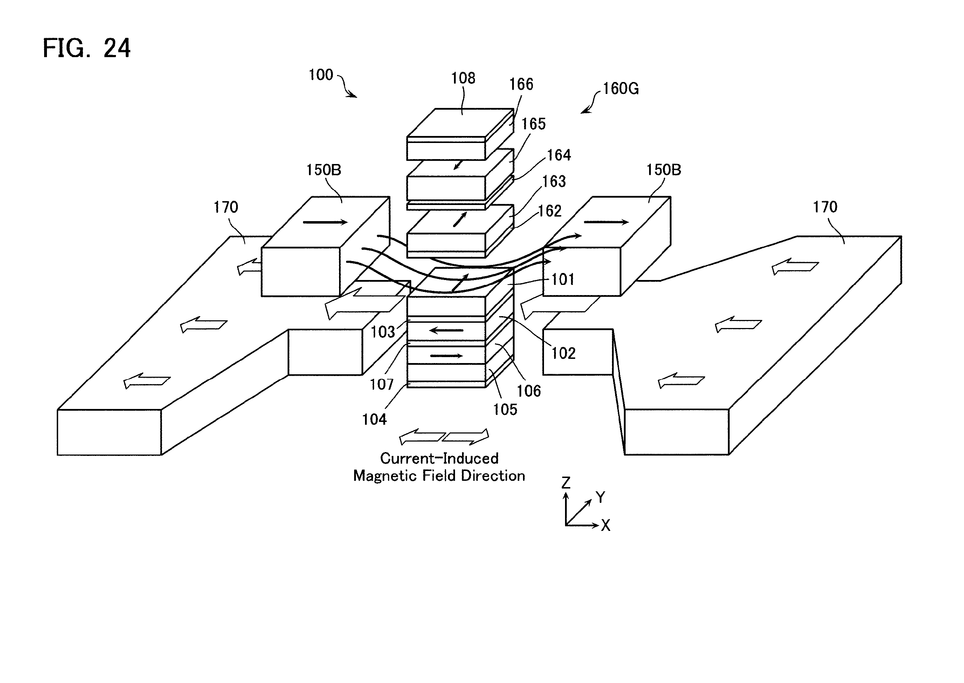

Next, a current sensor according to a fourth embodiment will be described. Fig. 24 is a schematic view showing a configuration of the current sensor according to the fourth embodiment. The current sensor according to the fourth embodiment is configured substantially similarly to the current sensor according to the third embodiment, but further includes a magnetic field guides 170.

The magnetic field guides 170 are provided adjacent to the side surfaces of the first magneotresistance element 100, the side surfaces being parallel to a direction in which the current-induced magnetic field of the first magneotresistance element 100 is applied. The magnetic field guides 170 converges the current-induced magnetic field to apply it to the first magneotresistance element 100. Providing such the magnetic field guides 170 makes it possible to measure the current-induced magnetic field with higher sensitivity. Now, in order to combine use of the magnetic field offset due to the first offset magnetic body 150B according to the present embodiment with such a magnetic field guide 170, employing the first offset magnetic body 150B provided diagonally to the side of the first magneotresistance element 100 shown in Fig. 9 may be conceivable. As a result, the magnetic field guide 170 and the first offset magnetic body 150B can be disposed without any structural interference. Moreover, the current sensor according to the present embodiment includes the linear response magnetic body 160G. Note that the magnetic field guide 170 may employ, for example, a ferromagnetic material configured from at least one of Fe, Co, and Ni, or an alloy including at least one kind thereof, and preferably employs a soft magnetic material. For example, the likes of Ni₈₀Fe₂₀ may be employed.

### [5. Current Sensor according to Fifth Embodiment]

Next, a current sensor according to a fifth embodiment will be described. As explained using Fig. 4, the current sensors according to the above-described embodiments select an optimal magneotresistance element from a plurality of magneotresistance elements having different magnetic field sensitivities, based on magnitude of the current-induced magnetic field, and calculate a selection output signal from an output voltage of the optimal magneotresistance element.

However, the plurality of magneotresistance elements are responsive to different ranges of current-induced magnetic fields. Accordingly, even if the magneotresistance elements are driven under the same output voltage, a value of the measured current-induced magnetic fields are different from one another. Therefore, unless it is possible to specify which one of the output voltages outputted from the magneotresistance elements is appropriate, the value of the current-induced magnetic field from the current to be measured cannot be measured.

Accordingly, in the current sensor according to the present embodiment, the output signals of a plurality of disposed magneotresistance elements are all inputted to a multiplexer, and an optimal output signal is selected based on a certain control signal. Note that the control signal includes data that selects one optimal sensor based on a range of the current-induced magnetic field.

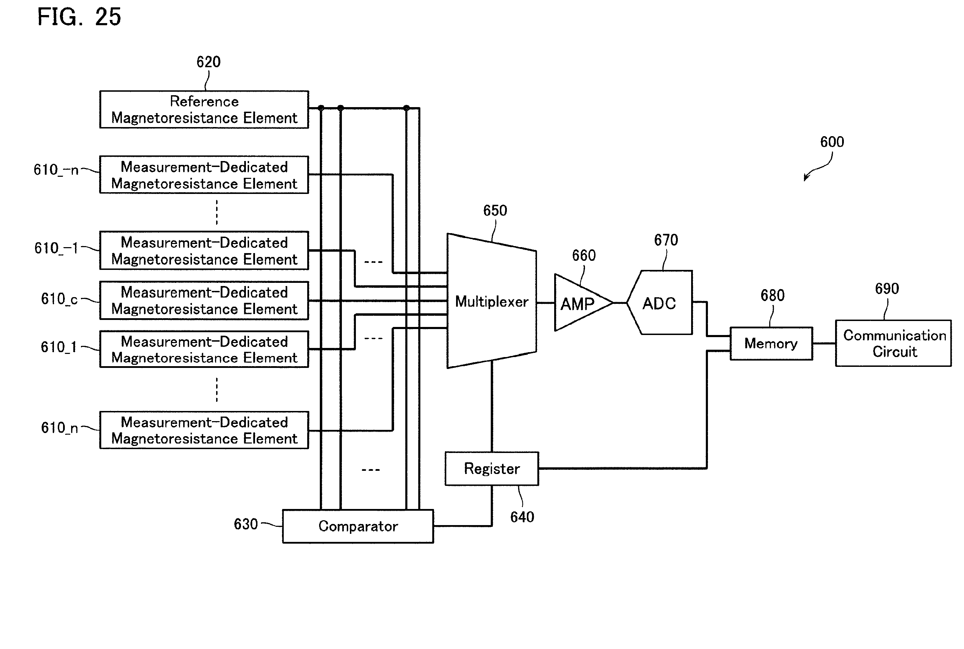

Fig. 25 is a circuit block diagram showing a configuration of a current sensor 600 according to the present embodiment. The current sensor 600 according to the present embodiment comprises: a plurality of measurement-dedicated magneotresistance elements 610_-n to 610_-1, 610_c, and 610_1 to 610_n; a reference magneotresistance element 620; a comparator 630; a register 640; a multiplexer 650; an amplifier 660; an A/D converter circuit 670; a memory 680; and a communication circuit 690.

The plurality of measurement-dedicated magneotresistance elements 610_-n to 610_-1, 610_c, and 610_1 to 610_n have sensitivities to different magnitudes of magnetic fields. The magneotresistance elements according to any of the first, third, and fourth embodiments can be applied as the plurality of measurement-dedicated magneotresistance elements 610_-n to 610_-1, 610_c, and 610_1 to 610_n. That is, an offset magnetic body is provided close to the measurement-dedicated magneotresistance elements 610_-n to 610_-1, 610_c, and 610_1 to 610_n. Moreover, they may also be provided with a linear response magnetic body, and so on.

The reference magneotresistance element 620 is a magneotresistance element that has sensitivity in a broader magnetic field range compared with the plurality of measurement-dedicated magneotresistance elements 610_-n to 610_-1, 610_c, and 610_1 to 610_n. Moreover, the magneotresistance elements according to any of the first through fourth embodiments may also be adopted as the reference magneotresistance element 620. That is, an offset magnetic body or linear response magnetic body, and so on, may also be provided close to the reference magneotresistance element 620.

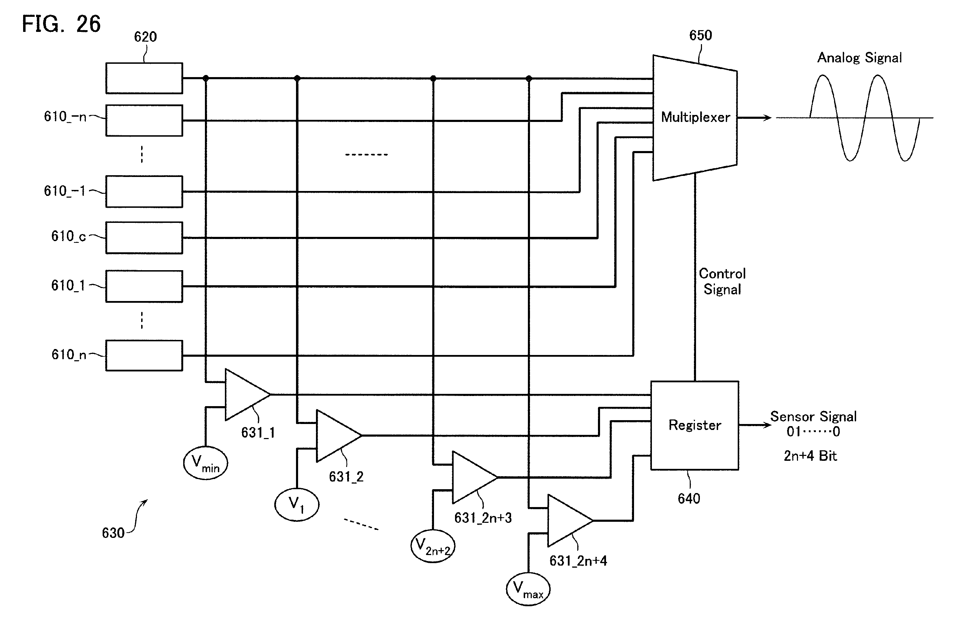

The comparator 630 generates a control signal indicating a rough magnitude of an external magnetic field, based on an output signal of the reference magneotresistance element 620. Fig. 26 is a circuit diagram showing a configuration of the comparator 630. The comparator 630 comprises a plurality of comparators 631_1 to 631_2n+4. The comparators 631_1 to 631_2n+4 compare the output signal of the reference magneotresistance element 620 with a reference voltage Vₘᵢₙ, V₁ ... V₂ₙ₊₂, and Vₘₐₓ, and output a result of the comparison. The voltage Vₘᵢₙ is an output voltage in a state where magnetization vectors of a free layer (first magnetic layer 101, and so on) and a pin layer (second magnetic layer 102, and so on) of the magneotresistance element in the present embodiment are directed in a 0° direction. The voltage Vₘₐₓ is an output voltage in a state where magnetization vectors of the free layer (first magnetic layer 101, and so on) and the pin layer (second magnetic layer 102, and so on) of the magneotresistance element in the present embodiment are directed in a 180° direction. Therefore, the plurality of comparators 631_1 to 631_2n+4 have one of their input terminals connected to the reference magneotresistance element 620. Moreover, the other of their input terminals are each applied with a different reference voltage. Furthermore, these plurality of comparators 631_1 to 631_2n+4 have their output terminal connected to the register 640.

Description will continue returning to Fig. 25. The register 640 stores output signals of the comparator 630 as a control signal. The multiplexer 650 selects one output signal from the output signals of the measurement-dedicated magneotresistance elements 610_-n to 610_-1, 610_c, and 610_1 to 610_n and the reference magneotresistance element 620, based on this control signal. The amplifier 660 amplifies an output signal of the multiplexer 650, and the A/D converter circuit 670 converts an output signal of the amplifier 660 to a digital output value. The memory 680 stores an output signal of the A/D converter circuit 670 and the control signal, and the communication circuit 690 outputs the signals stored in the memory 680 to external.

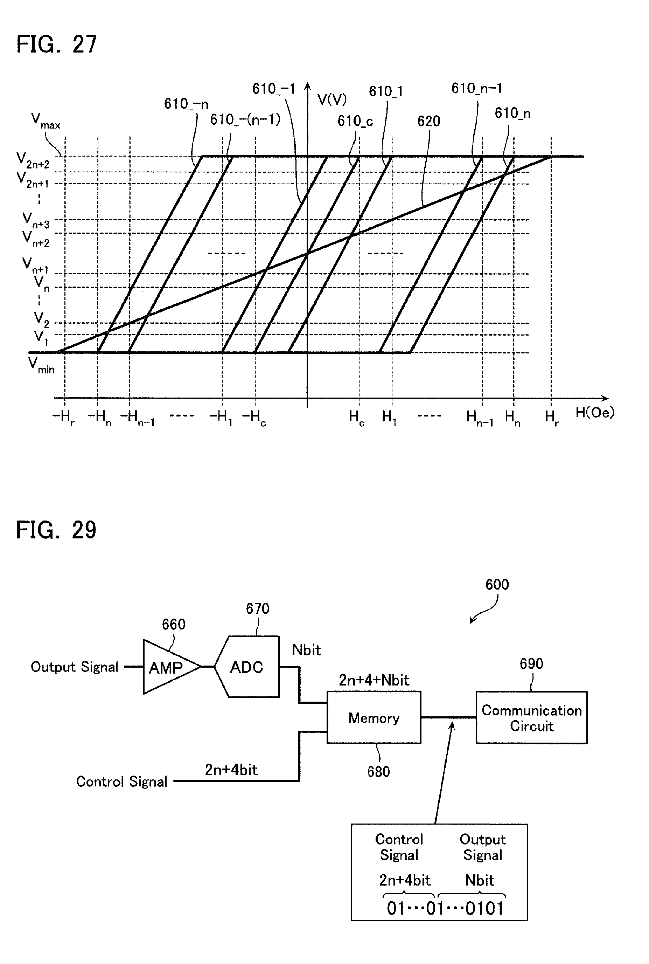

Fig. 27 is a graph showing characteristics of the plurality of measurement-dedicated magneotresistance elements 610_-n to 610_-1, 610_c, and 610_1 to 610_n and the reference magneotresistance element 620. The horizontal axis indicates magnitude of the current-induced magnetic field, and the vertical axis indicates output voltages of the measurement-dedicated magneotresistance elements 610_-n to 610_-1, 610_c, and 610_1 to 610_n and the reference magneotresistance element 620.

As shown in Fig. 27, the plurality of measurement-dedicated magneotresistance elements 610_-n to 610_-1, 610_c, and 610_1 to 610_n have characteristics where magnetic field sensitivities are the same, but values of the saturation magnetic field are offset. That is, the measurement-dedicated magneotresistance element 610_c has a magnetic field sensitivity in a region of -H_{c} to H_{c} centered around 0 Oe. Furthermore, the measurement-dedicated magneotresistance elements 610_1 to 610_n have their measurement ranges shifting in a positive direction. Note that an amount of shift in measurement range in the measurement-dedicated magneotresistance element 610_k (where k = 1 to n) is k-th smallest. Moreover, the measurement-dedicated magneotresistance elements 610_-1 to 610_-n have their measurement ranges shifting in a negative direction. Note that an amount of shift in measurement range in the measurement-dedicated magneotresistance element 610_-k (where k = 1 to n) is k-th smallest.

In Fig. 27, Vₘₐₓ and Vₘᵢₙ are the output voltages in a state of magnetization saturation of the measurement-dedicated magneotresistance elements 610_-n to 610_-1, 610_c, and 610_1 to 610_n and the reference magneotresistance element 620. When an external magnetic field having a certain magnitude is applied, the output signal of the measurement-dedicated magneotresistance element 610_k (where k = 1 to n) for which this external magnetic field is within its measurement range attains a magnitude between Vₘₐₓ and Vₘᵢₙ. On the other hand, the output signal of the measurement-dedicated magneotresistance element 610_k (where k = 1 to n) for which the external magnetic field is outside its measurement range attains Vₘₐₓ or Vₘᵢₙ. The reference magneotresistance element 620 has a magnetic field sensitivity which is lower compared to those of the measurement-dedicated magneotresistance elements 610_-n to 610_-1, 610_c, and 610_1 to 610_n. Moreover, the reference magneotresistance element 620 has a magnetic field sensitivity in a region of -Hᵣ to Hᵣ centered around 0 Oe, and this measurement range includes all of the measurement ranges of the plurality of measurement-dedicated magneotresistance elements 610_-n to 610_-1, 610_c, and 610_1 to 610_n.

A measurement-dedicated magneotresistance element 610_c whose resistance value becomes midway between a maximum value and a minimum value when the magnitude of the external magnetic field is 0 may be referred hereinbelow as a central magneotresistance element 610. If the number of measurement-dedicated magneotresistance elements 610 having measurement ranges shifted to + sides with respect to this central magneotresistance element 610 is identical to the number of measurement-dedicated magneotresistance elements 610 having measurement ranges shifted to - sides thereof (for example, n), it is possible to measure ± magnetic fields symmetrically also for an alternating magnetic field. The description below will be made assuming a current sensor having magnetic field-voltage characteristics as in Fig. 27.

V₁ to V₂ₙ₊₂ in Fig. 27 are the above-described reference voltages compared with the output voltage of the reference magneotresistance element 620. The reference voltages are respectively set for all of the measurement-dedicated magneotresistance elements 610_-n to 610_-1, 610_c, and 610_1 to 610_n. The reference voltages V₁ to Vₙ are set for the measurement-dedicated magneotresistance elements 610_-n to 610_-1 having measurement ranges shifted in a - (minus) direction. The reference voltages V₁ to Vₙ are the output voltages of the reference magneotresistance element 620 when the magnetic field is at saturation magnetic fields -Hₙ to -H₁. The output voltages of the measurement-dedicated magneotresistance elements 610_-n to 610_-1 attain Vₘᵢₙ when the magnetic field is at saturation magnetic fields -Hₙ to H₁. The reference voltages Vₙ₊₃ to V₂ₙ₊₂ are set for the measurement-dedicated magneotresistance elements 610_1 to 610_n having measurement ranges shifted in a + (plus) direction. The reference voltages Vₙ₊₃ to V₂ₙ₊₂ are the output voltages of the reference magneotresistance element 620 when the magnetic field is at the saturation magnetic fields H₁ to Hₙ. The output voltages of these measurement-dedicated magneotresistance elements 610_1 to 610_n attain Vₘₐₓ when the magnetic field is at saturation magnetic fields -H1 to Hn. Note that two reference voltages Vₙ₊₁ and Vₙ₊₂ are set for the central magneotresistance element 610_c by these two methods.

However, in an actual magnetic field sensor, a linear response-capable range is narrower than the range of Vₘᵢₙ to Vₘₐₓ, hence the previously mentioned Vₘᵢₙ may be set larger than the output voltage in the saturation magnetic field and Vₘₐₓ may be set smaller than the output voltage in the saturation magnetic field. When n measurement-dedicated magneotresistance elements are disposed on a - side, n measurement-dedicated magneotresistance elements are disposed on a + side, and one central magneotresistance element 610 is disposed, 2n+2 types of reference voltages must be set.

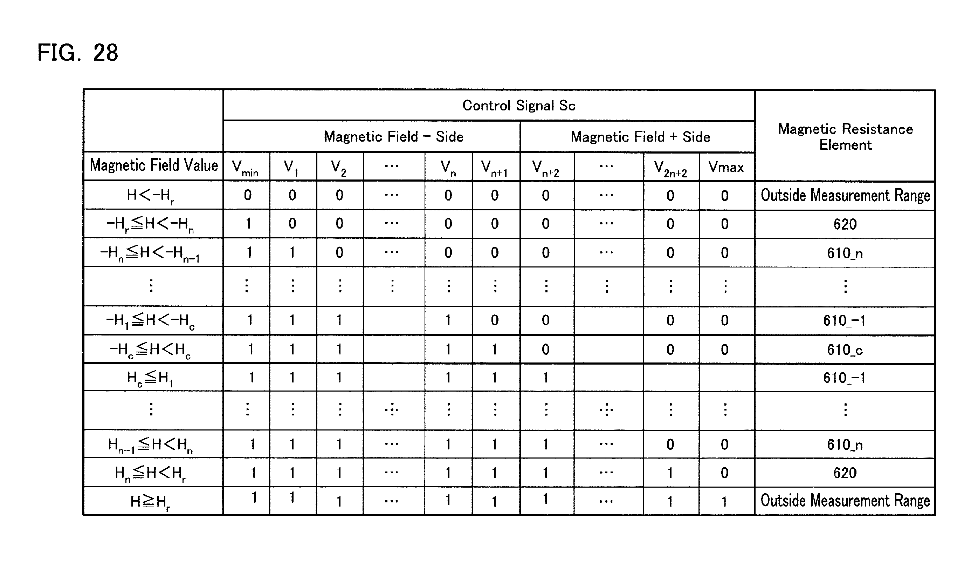

Fig. 28 is a table showing a relationship between magnitude of the current-induced magnetic field, a value of a control signal Sc, and the measurement-dedicated magneotresistance elements 610_-n to 610_-1, 610_c, and 610_1 to 610_n and the reference magneotresistance element 620 selected by the multiplexer 650. Magnitude of the current-induced magnetic field is shown in the left column of Fig. 28, the control signal Sc is shown in the middle column of Fig. 28, and the selected magneotresistance element is shown in the right column of Fig. 28. Note that the control signal Sc is configured from the output signals of the 2n+4 comparators 631_1 to 631_2n+4 (Fig. 26), hence Fig. 28 describes data of each of the output signals of the comparators 631_1 to 631_2n+4.

When magnitude H of the current-induced magnetic field in Fig. 28 is -Hₖ ≤ H < -Hₖ₋₁ (where k = 1 to n), the output voltage of the reference magneotresistance element 620 is not less than Vₙ₋ₖ₊₁, and is smaller than Vₙ₋ₖ₊₂. Therefore, the output signals of the comparators 631_1 to 631_n-k+1 are 1 (High), and the output signals of the comparators 631_n-k+2 to 631_2n+4 are 0 (Low). When magnitude H of the current-induced magnetic field is -H_{c} ≦ H < H_{c}, the output voltage of the reference magneotresistance element 620 is not less than Vₙ₊₁, and is smaller than Vₙ₊₂. Therefore, the output signals of the comparators 631_1 to 631_n are 1 (High), and the output signals of the comparators 631_n+1 to 631_2n+4 are 0 (Low). When magnitude H of the current-induced magnetic field is Hₖ₋₁ ≦ H < Hₖ (where k = 1 to n), the output voltage of the reference magneotresistance element 620 is not less than Vₙ₊ₖ₊₁, and is smaller than Vₙ₊ₖ₊₂. Therefore, the output signals of the comparators 631_1 to 631_n+k+1 are 1 (High), and the output signals of the comparators 631_n+k+2 to 631_2n+4 are 0 (Low). The comparator 630 receives the control signal Sc configured from these output signals to select and output the output signal of the measurement-dedicated magneotresistance element 610_k.

Next, operation of the memory 680 will be described. Fig. 29 is a circuit block diagram for explaining operation of the memory 680. The output signal outputted from the multiplexer 650 is converted to N bit digital data by the A/D converter circuit 670. Moreover, the control signal is 2n+4 bit digital data. The current sensor 600 according to the present embodiment specifies the measurement-dedicated magneotresistance element 610 selected by the control signal. Therefore, the memory 680 stores N+2n+4 bit digital data as one unit.

### [6. Current Sensor according to Sixth Embodiment]

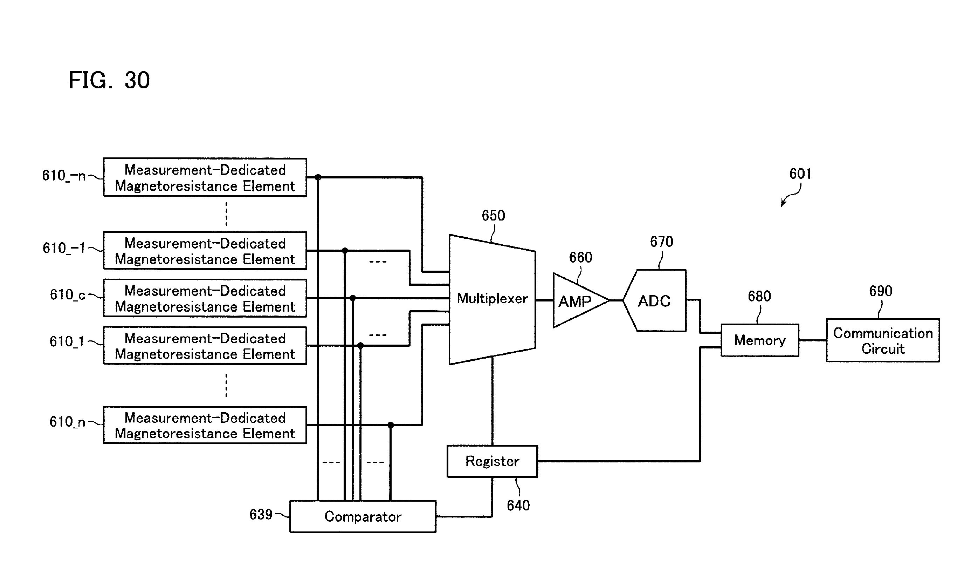

Next, a current sensor according to a sixth embodiment will be described. Fig. 30 is a circuit block diagram showing a configuration of a current sensor 601 according to the present embodiment. The current sensor 601 according to the present embodiment is configured substantially similarly to the current sensor 600 according to the fifth embodiment, but differs in not including the reference magneotresistance element 620, in a configuration of a comparator 639, and in a generating method of the control signal.

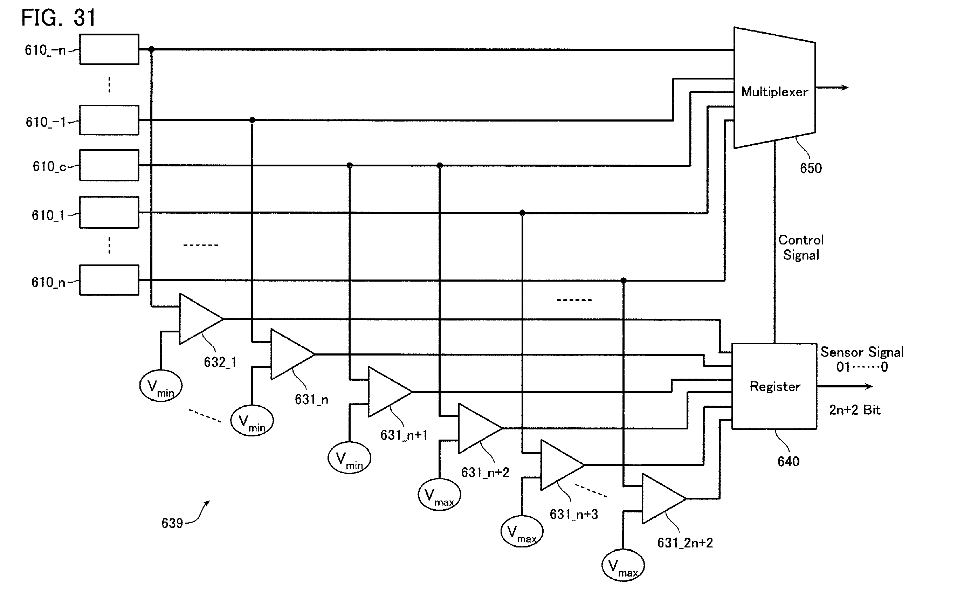

Fig. 31 is a circuit diagram showing the configuration of the comparator 639 according to the present embodiment. The comparator 639 comprises a plurality of comparators 632_1 to 632_2n+2. The plurality of comparators 632_1 to 632_2n+2 have one of their input terminals respectively connected to the plurality of measurement-dedicated magneotresistance elements 610_-n to 610_-1, 610_c, and 610_1 to 610_n. Now, each of the measurement-dedicated magneotresistance elements 610_-n to 610_-1 and 610_1 to 610_n have the comparators 632_1 to 632_n and 632_n+3 to 632_2n+2 respectively connected thereto, but the central measurement-dedicated magneotresistance element 610_c has two comparators 632_n+1 and 632_n+2 connected thereto. Moreover, the comparators 632_1 to 632_2n+2 have the other of their input terminals each applied with a different reference voltage. Furthermore, these plurality of comparators 632_1 to 632_2n+2 have their output terminal connected to the register 640.

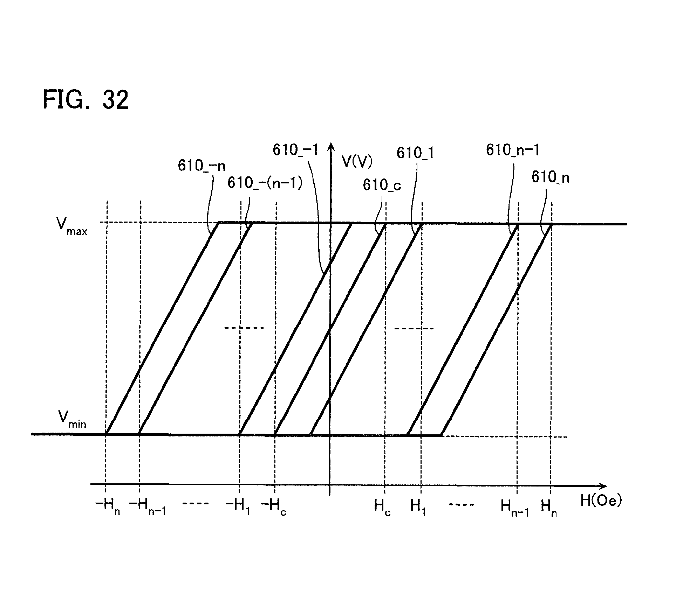

Fig. 32 is a graph showing characteristics of the plurality of measurement-dedicated magneotresistance elements 610_-n to 610_-1, 610_c, and 610_1 to 610_n. The reference voltages are respectively set for all of the measurement-dedicated magneotresistance elements 610_-n to 610_-1, 610_c, and 610_1 to 610_n. The reference voltage that is set for the measurement-dedicated magneotresistance elements 610_-n to 610_-1 having measurement ranges shifted in a - direction is Vₘᵢₙ. The reference voltage that is set for the measurement-dedicated magneotresistance elements 610_1 to 610_n having measurement ranges shifted in a + direction is Vₘₐₓ. Note that Vₘᵢₙ and Vₘₐₓ are set as reference voltages for the central magneotresistance element 610_c.

However, in an actual magnetic field sensor, a linear response-capable range is narrower than the range of Vₘᵢₙ to Vₘₐₓ, hence the previously mentioned Vₘᵢₙ may be set larger than the output voltage in the saturation magnetic field and Vₘₐₓ set smaller than the output voltage in the saturation magnetic field. When n measurement-dedicated magneotresistance elements are disposed on a - side, n measurement-dedicated magneotresistance elements are disposed on a + side, and one central magneotresistance element 610 is disposed, 2n+2 types of reference voltages must be set.

Consequently, the control signal outputted from the comparator 639 is similar to the control signal in the fifth embodiment. Therefore, the multiplexer 650 selects the measurement-dedicated magneotresistance element 610 similarly to in the fifth embodiment.

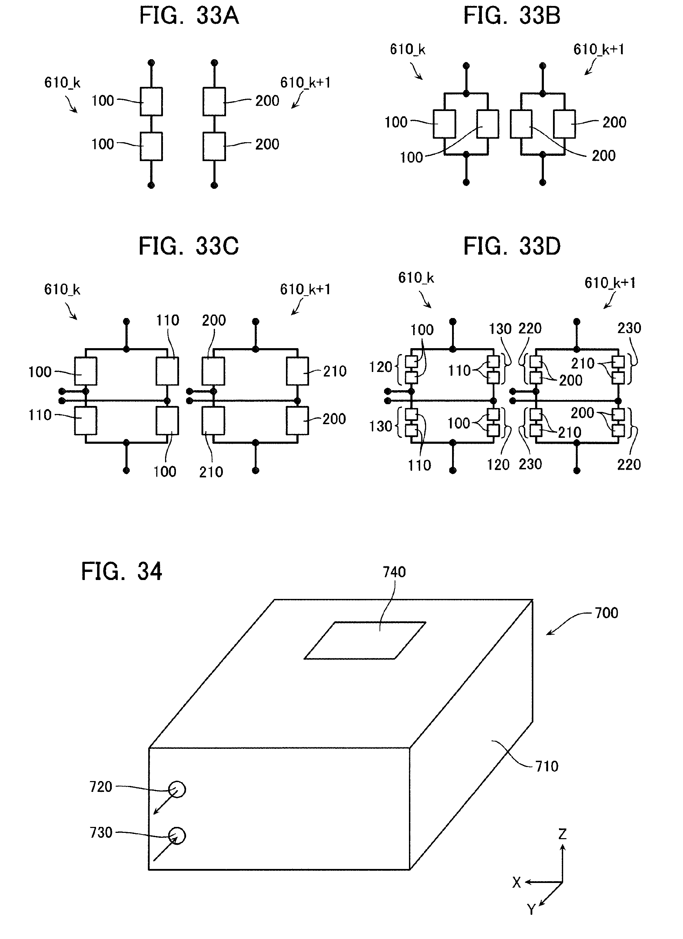

Note that a plurality of the first magneotresistance elements 100 or second magneotresistance elements 200 connected in series or parallel may also be employed as the above-described measurement-dedicated magneotresistance elements 610_-n to 610_-1, 610_c, and 610_1 to 610_n and the reference magneotresistance element 620. Fig. 33A to 33D are a schematic view illustrating a current sensor according to such an embodiment. Note that in such an embodiment, the plurality of first magneotresistance elements 100 are applied with an equal offset magnetic field. Similarly, the plurality of second magneotresistance elements 200 are also applied with an equal offset magnetic field.

As indicated in Fig. 33A, it is possible, for example, to electrically connect the plurality of first magneotresistance elements 100 in series to configure the measurement-dedicated magneotresistance element 610_k (where k = 1 to n-1), and electrically connect the plurality of second magneotresistance elements 200 in series to configure the measurement-dedicated magneotresistance element 610_k+1. When the number of magneotresistance elements connected in series is assumed to be N, an obtained electrical signal is N times the case where the number of magneotresistance elements is 1. On the other hand, heat noise and Schottky noise are N^{1/2} times. That is, SNR (signal-noise ratio) is N^{1/2} times. Increasing the number N of magneotresistance elements connected in series enables SNR to be improved.

The bias voltage applied to one magneotresistance element is, for example, not less than 50 mV and not more than 150 mV. When N magneotresistance elements are connected in series, the bias voltage becomes not less than 50 mV x N and not more than 150 mV x N. For example, when the number N of magneotresistance elements connected in series is 25, the bias voltage becomes not less than 1 V and not more than 3.75 V.

When a value of the bias voltage is 1 V or more, design of electrical circuits handling the electrical signal obtained from the magneotresistance elements is made easy, which is preferable practically.

When the bias voltage (inter-terminal voltage) exceeds 10 V, it is undesirable for electrical circuits handling the electrical signal obtained from the magneotresistance elements. In the embodiment, the number N of magneotresistance elements connected in series and the bias voltage are set to obtain a suitable voltage range.

For example, the voltage when a plurality of magneotresistance elements are electrically connected in series is preferably not less than 1 V and not more than 10 V. For example, the voltage applied between terminals (between a terminal at one end and a terminal at the other end) of the plurality of magneotresistance elements electrically connected in series is not less than 1 V and not more than 10 V.

As indicated in Fig. 33B, in a current sensor according to another embodiment, it is possible, for example, to electrically connect the plurality of first magneotresistance elements 100 in parallel to configure the measurement-dedicated magneotresistance element 610_k (where k = 1 to n), and electrically connect the plurality of second magneotresistance elements 200 in parallel to configure the measurement-dedicated magneotresistance element 610_k+1.

As indicated in Fig. 33C, in a current sensor according to another embodiment, it is possible, for example, to connect a plurality of first magneotresistance elements 100 and magneotresistance elements 110 having identical resistance values and showing reverse polarity to the first magneotresistance elements so as to form a Wheatstone bridge circuit and thereby configure the measurement-dedicated magneotresistance element 610_k (where k = 1 to n), and to connect a plurality of second magneotresistance elements 200 and magneotresistance elements 210 having identical resistance values and showing reverse polarity to the second magneotresistance elements so as to form a Wheatstone bridge circuit and thereby configure the measurement-dedicated magneotresistance element 610_k+1. This makes it possible to perform temperature compensation of detection characteristics, for example.

Moreover, in the circuit indicated in Fig. 33C, it is possible to adopt a fixed resistance having a resistance value identical to that of the first magneotresistance element 100 in place of the previously mentioned magneotresistance element 110, and to adopt a fixed resistance having a resistance value identical to that of the second magneotresistance element 200 in place of the previously mentioned magneotresistance element 210 (half Wheatstone bridge circuit).

As indicated in Fig. 33D, in a current sensor according to another embodiment, it is possible, for example, to form a Wheatstone bridge circuit by a magneotresistance element 120 having a plurality of the first magneotresistance elements 100 connected in series therein and a magneotresistance element 130 having the previously mentioned magneotresistance elements 110 connected in series therein, and adopt this Wheatstone bridge circuit as the measurement-dedicated magneotresistance element 610_k (where k = 1 to n). In addition, it is possible to form a Wheatstone bridge circuit by a magneotresistance element 220 having a plurality of the second magneotresistance elements 200 connected in series therein and a magneotresistance element 230 having the previously mentioned magneotresistance elements 210 connected in series therein, and adopt this Wheatstone bridge circuit as the measurement-dedicated magneotresistance element 610_k+1.

Moreover, in the circuit indicated in Fig. 33D, it is possible to adopt a fixed resistance having a resistance value identical to that of the magneotresistance element 120 in place of the previously mentioned magneotresistance element 130, and to adopt a fixed resistance having a resistance value identical to that of the magneotresistance element 220 in place of the previously mentioned magneotresistance element 230 (half Wheatstone bridge circuit).

### [7. Example of Application to Smart Meter]

Next, an example where the above-described current sensors according to the first through sixth embodiments are applied to a smart meter will be described. In the case of a smart meter, voltage and current must be measured, but voltage can be voltage monitored in a conventional semiconductor element, hence by adding the current sensor of the present embodiment, it functions as a smart meter and not only as a current sensor. Described below is an example where the current sensor 600 according to the fifth embodiment is applied to a smart meter, but a current sensor according to another embodiment may also be applied.

Fig. 34 is a schematic view showing outer appearance of a smart meter 700 according to the present embodiment. As shown in Fig. 34, the smart meter 700 comprises: a housing 710 for housing a sensor unit; and a first terminal unit 720, a second terminal unit 730, and a display unit 740 externally displaying electrical energy, that are provided in the housing 710. The housing 710 houses each of configurations of the smart meter 700 according to the present embodiment. The first terminal unit 720 and the second terminal unit 730 electrically connect each of configurations of the smart meter 700 and a measurement target via a probe not illustrated. The display unit 740 displays a result of measurement by the smart meter 700, and so on. Generally, an alternating current of about 50 to 60 Hz is measured, but depending on an application, the current may be a direct current. In Fig. 34, directionality of the current is illustrated, but this is indicating a unique direction of a current like a direct current for explaining the direction of a current magnetic field, and in the case of an alternating current, the current direction changes in polarity with time. Moreover, this Fig. 34 shows the case of a single-phase alternating current of about 100 to 200 V, but there is no substantive change even in the case of a three-phase alternating current. The state where there is one pair of current lines connected from external as in Fig. 34 simply becomes a state where there are three pairs. Note that the various configurations of the smart meter housed in the housing 710 are called a current measuring module.

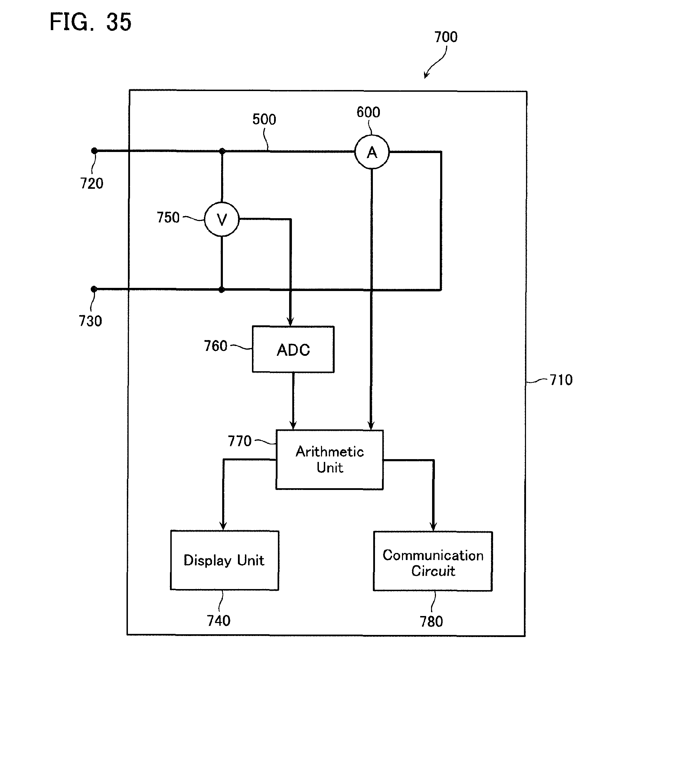

Fig. 35 is a functional block diagram showing a schematic configuration of the smart meter 700. As shown in Fig. 35, in addition to the above-described configurations, the smart meter 700 further comprises: the wiring line 500; the current sensor 600; a voltmeter 750; an A/D converter circuit 760; an arithmetic unit 770; and a communication circuit 780.

The current sensor 600 is the current sensor 600 according to the fifth embodiment. However, the memory 680 or communication circuit 690 may be omitted. The current sensor 600 is disposed close to the wiring line 500 and measures a current flowing in the wiring line 500. The wiring line 500 is connected to the first terminal unit 720 and second terminal unit 730, and is connected to the measurement target via the probe not illustrated.

A variety of voltmeters may be applied as the voltmeter 750. The voltmeter 750 measures a voltage between the first terminal unit 720 and the second terminal unit 730. The A/D converter circuit 760 converts a voltage value measured by the voltmeter 750 into a digital signal.

The arithmetic unit 770 acquires a current value from the current sensor 600 and the voltage value from the A/D converter circuit 760, and performs a calculation of electric power, and so on. The display unit 740 acquires the current value, the voltage value, a magnitude of electric power, and so on, from the arithmetic unit 770, and displays these. The communication circuit 780 similarly acquires the current value, the voltage value, the magnitude of electric power, and so on, and outputs these to outside of the smart meter 700.

Examples of arrangement of the current sensor 600 inside the housing 710 of the smart meter 700 will be indicated below.

### [7-1. Horizontally-Mounted Case 1]

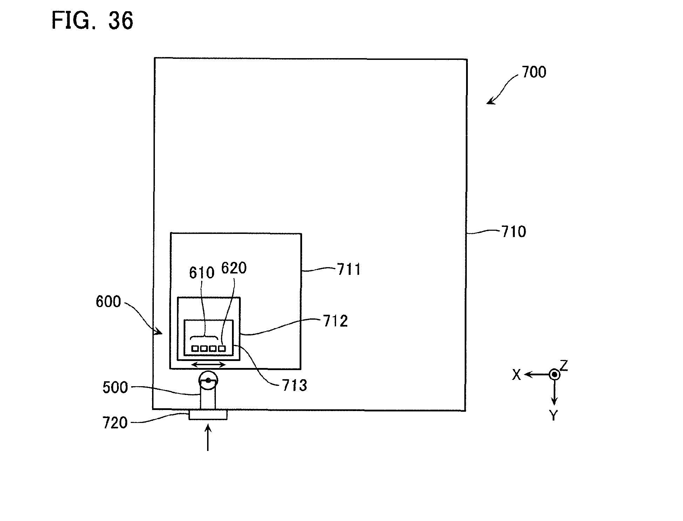

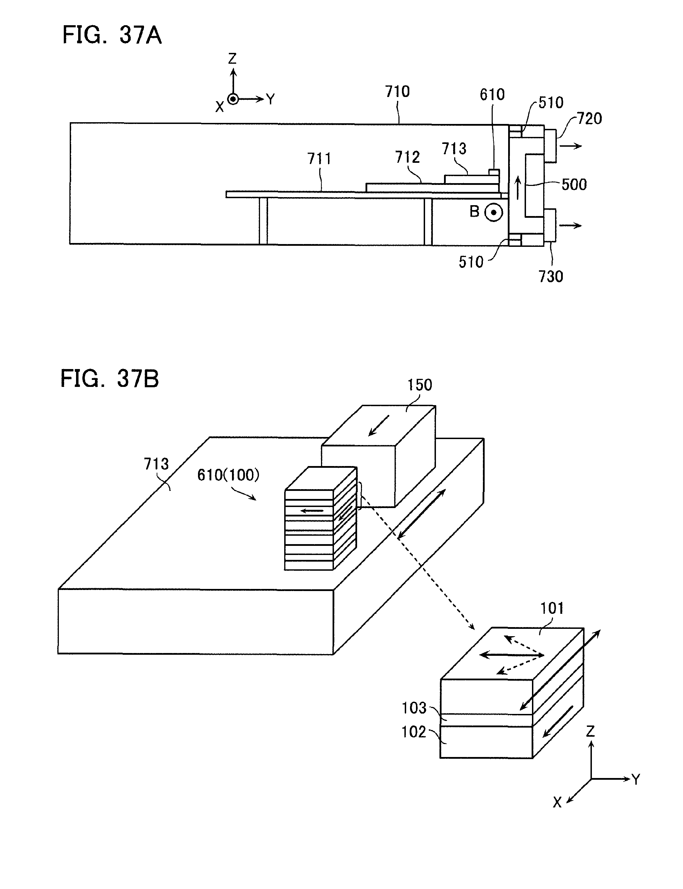

Figs. 36, 37A and 37B are schematic views showing an example of arrangement of the current sensor 600 inside the housing 710 of the smart meter 700. As shown in Fig. 37A, in the present embodiment, the current sensor 600 is disposed such that current flows in an up-down direction (z direction) of the housing 710. The wiring line 500 inside the housing 710 is fixed to the housing 710 via an insulated current line fixing support portion 510 to prevent a position of the wiring line 500 from changing. In addition, the current sensor 600 that detects the current-induced magnetic field from this fixed wiring line 500 is also fixed to the housing 710 in order to prevent a distance of the current sensor 600 from the wiring line 500 from changing over time. It is important for the distance of the wiring line 500 from the current sensor 600 to be fixed as the sensor substrate module 712 so as not to change, in order to accurately detect the current value.

In order to fix the current sensor 600 to the housing 710, there is a configuration where an electronic substrate module 711 is fixed to the housing 710, and the sensor substrate module 712 is fixed to that electronic substrate module 711. As a result of doing so, the current sensor 600 becomes positionally fixed to the housing 710, and the distance of the current sensor 600 from the similarly fixed wiring line 500 is configured not to change.

In this embodiment, the sensor substrate module 712 is disposed, with respect to a direction of flow (z direction) of the current of the wiring line 500 fixed inside the housing 710, on a planar surface vertically cutting a cross-section of the direction. Moreover, the electronic substrate module 711 fixing the sensor substrate module 712 is also set in an identical planar surface.

As shown in Fig. 37A, a direction of the current-induced magnetic field close to the sensor substrate module 712 is a direction parallel to a perpendicular direction of the plane of paper (x direction).

As shown in Fig. 37B, in order to detect the previously described current-induced magnetic field, a substrate 713 on which the current sensor 600 is formed configures a planar surface (xy planar surface) parallel to the planar surface of the sensor substrate module 712. An initial magnetization direction (magnetization direction when the current is zero) of the first magnetic layer 101 of the current sensor 600 formed on the substrate 713 has a magnetization direction in the above-described planar surface and is in a direction perpendicular to the wiring line 500. Doing so makes it possible to detect any polarity of current of an alternating current with good linearity.

The structure shown in Fig. 37A and 37B makes it possible for magnetization alignment to be suitably performed and effects of external noise to be suitably reduced. That is, when an external magnetic field is applied from a surface of the current sensor 601 where external magnetic field noise is most easily applied, a magnetic field is applied in a direction (z direction) orthogonal to that surface (xy planar surface). However, the magnetization direction of the current sensor 601 (magnetization direction of the first magnetic layer 101) is parallel to that surface (xy planar surface), hence almost no noise is generated, even if a magnetic field in a direction (z direction) orthogonal to that surface is applied. This magnetization alignment makes it possible to reduce effects of an external magnetic field without adding unnecessary structure. Note that a magnetic shield may be provided in a cross-sectional direction of the current sensor 601. This magnetic shield has a smallest cross-sectional area in the current measuring module. Therefore, an increase in cost accompanying addition of the magnetic shield can be suppressed to a minimum. Moreover, a substrate of the current sensor 601 can be attached to the electronic substrate module 711 as is, hence effects due to error in arrangement, and so on, can be reduced, and manufacturing costs required for maintaining accuracy of arrangement at a high level can be suppressed. Hence, the configuration of the kind shown in Figs. 36 and 37 makes it possible for magnetization alignment of the current sensor 601 with the current-induced magnetic field due to the wiring line 500 to be suitably performed.

Furthermore, arranging as in Fig. 36 makes it possible for a plurality of current sensors to be disposed on an identical substrate. Therefore, a reduction in manufacturing costs can be achieved.

As shown in Fig. 36, in the smart meter 700 according to the present embodiment, a plurality of measurement-dedicated magneotresistance elements 610 are disposed at a substantially constant distance from the wiring line 500. Moreover, the plurality of measurement-dedicated magneotresistance elements 610 each have different offset magnetic fields. Therefore, the smart meter 700 according to the present embodiment is capable of measuring a broad current range. In addition, as shown in Fig. 37B, the reference magneotresistance element 620 described in Figs. 25 and 27 may be provided. Moreover, in order to measure an alternating current, the magneotresistance element group having inclinations of offset magnetic fields reversely-directed shown in Fig. 19 is preferably employed.

### [7-2. Horizontally-Mounted Case 2]

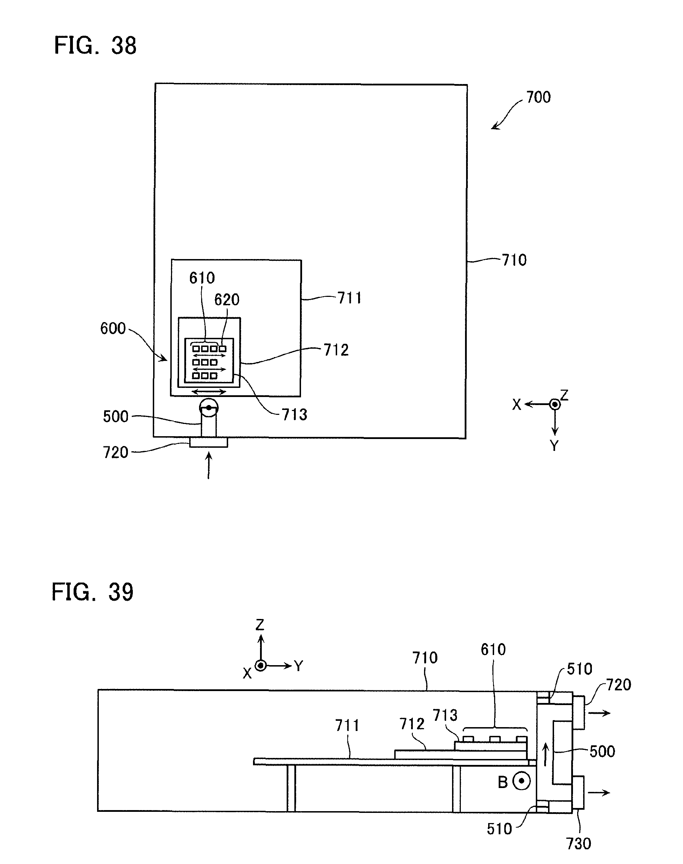

Figs. 38 and 39 are schematic views showing another example of arrangement of the current sensor 600 inside the housing 710 of the smart meter 700. Figs. 38 and 39 show a configuration where the plurality of measurement-dedicated magneotresistance elements 610 are disposed at positions having different distances from the wiring line 500. That is, in order to enable a current range of broad dynamic range to be detected, differences in distance from the wiring line 500 are provided, and magnitudes of the current-induced magnetic field when a certain magnitude of current flows are made to differ depending on the measurement-dedicated magneotresistance elements 610. Moreover, if attention is focused on, for example, two measurement-dedicated magneotresistance elements 610 having different distances from the wiring line 500, then, even supposing measurement ranges of these measurement-dedicated magneotresistance elements 610 are similar, the measurement-dedicated magneotresistance element 610 disposed in a place far from the wiring line 500 can detect the current-induced magnetic field in a state where a large current is flowing, and the measurement-dedicated magneotresistance element 610 disposed close to the wiring line 500 can detect the current-induced magnetic field in a state where a weak current is flowing. Therefore, arranging the measurement-dedicated magneotresistance elements 610 in this way enables an even broader measurement range to be detected, in addition to the increase in measurement range due to changing the offset magnetic fields. As shown in Figs. 38 and 39, a relationship of magnetization directions with the housing 710 is similar to in the case described using Figs. 36 and 37.

### [7-3. Vertically-Mounted Case 1]

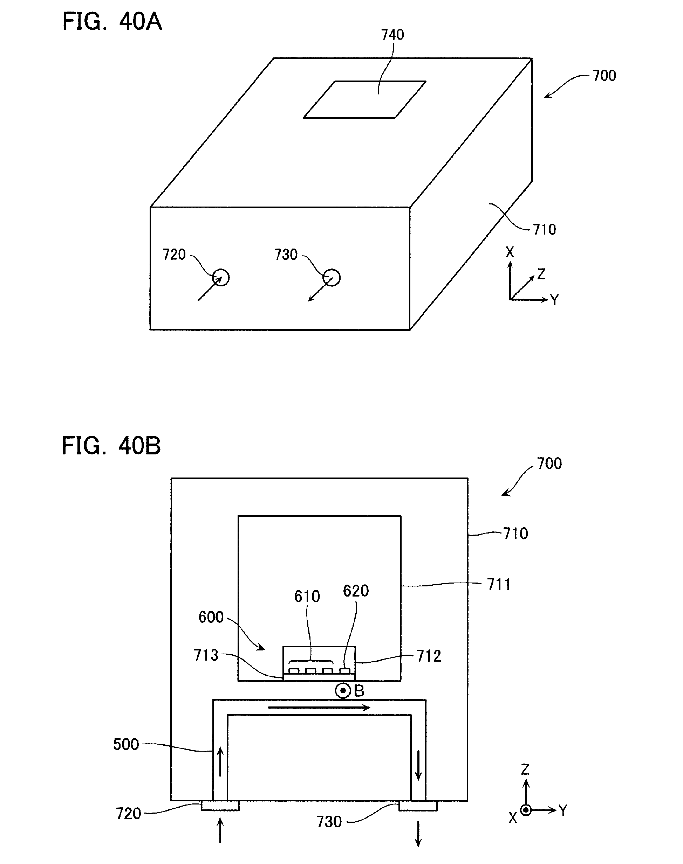

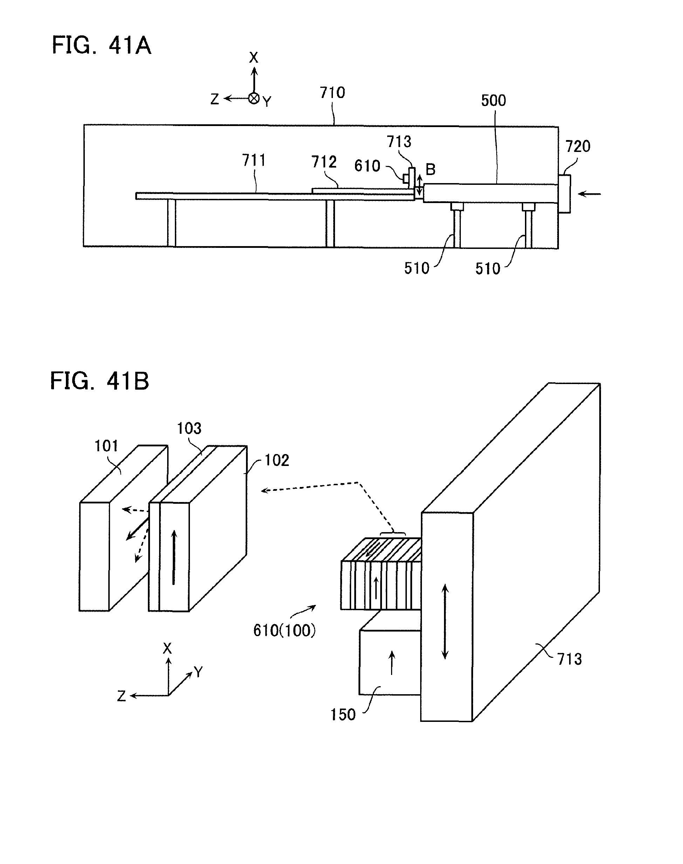

Figs. 40A, 40B and 41 are schematic views showing another example of arrangement of the current sensor 600 inside the housing 710 of the smart meter 700. In the present embodiment, the first terminal unit 720 and the second terminal unit 730 are disposed in a lateral direction (y direction) with respect to the housing 710 of the smart meter 700, and the wiring line 500 inside the housing 710 is disposed such that current flows parallel to a display surface of the housing 710.

The example of arrangement shown in Figs. 40A, 40B and 41A and 41B is substantially similar to the example of arrangement shown in Figs. 36,37A and 37B, but as shown in Figs. 40 and 41A and 41B, the present example of arrangement differs from the example of arrangement shown in Figs. 36, 37A and 37B in having attachment of the current sensor 600 configured vertically with respect to the sensor substrate module 712. That is, the substrate 713 on which the current sensor 600 is formed is disposed in a planar surface (xy planar surface) parallel to a long axis direction (y direction) of the wiring line 500, and is disposed such that the measurement-dedicated magneotresistance elements 610 stand perpendicularly with respect to the electronic substrate module 711. As shown in Fig. 41B, the initial magnetization direction of the first magnetic layer 101 is directed in a parallel direction to the long axis direction (y direction) of the wiring line 500. Arranging in this way makes it possible to detect an alternating magnetic field due to an alternating current whatever its polarity.

### [7-4. Vertically-Mounted Case 2]

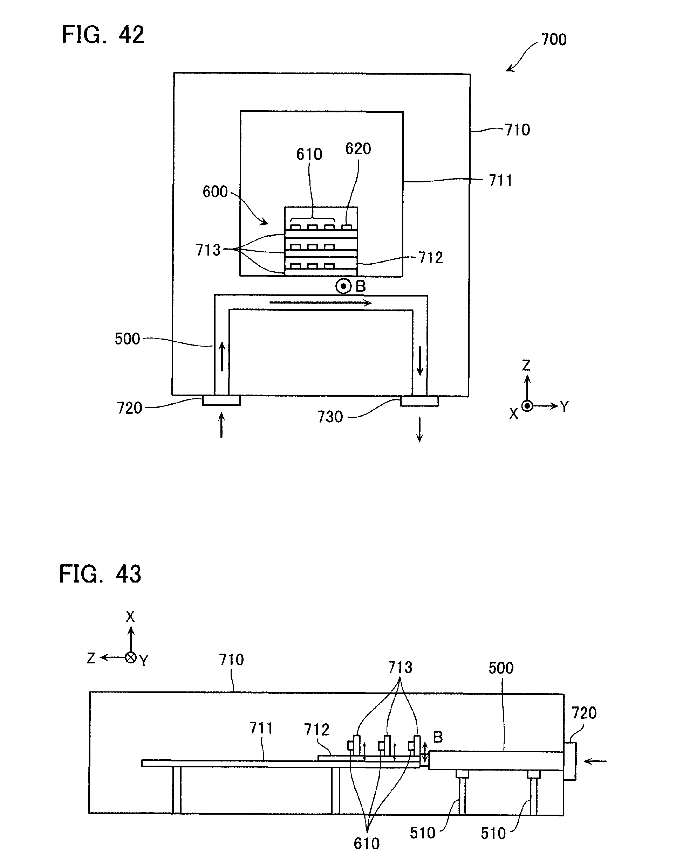

Figs. 42 and 43 are schematic views showing another example of arrangement of the current sensor 600 inside the housing 710 of the smart meter 700. The present example of arrangement is substantially similar to the example of arrangement described using Figs. 40, 41A, 41B, but in Fig. 43, there is a configuration where the plurality of measurement-dedicated magneotresistance elements 610 are disposed at positions having different distances from the wiring line 500. That is, in order to enable a current range of broad dynamic range to be detected, differences in distance from the wiring line 500 are provided, and magnitudes of the current-induced magnetic field when a certain magnitude of current flows are made to differ depending on the measurement-dedicated magneotresistance elements 610. Moreover, if attention is focused on, for example, two measurement-dedicated magneotresistance elements 610 having different distances from the wiring line 500, then, even supposing measurement ranges of these measurement-dedicated magneotresistance elements 610 are similar, the measurement-dedicated magneotresistance element 610 disposed in a place far from the wiring line 500 can detect the current-induced magnetic field in a state where a large current is flowing, and the measurement-dedicated magneotresistance element 610 disposed close to the wiring line 500 can detect the current-induced magnetic field in a state where a weak current is flowing. Therefore, arranging the measurement-dedicated magneotresistance elements 610 in this way enables an even broader measurement range to be detected, in addition to the increase in measurement range due to changing the offset magnetic fields. Moreover, in order to measure an alternating current, the magneotresistance element group having inclinations of offset magnetic fields reversely-directed shown in Fig. 19 is preferably employed. As shown in Fig. 43, a relationship of magnetization directions with the housing 710 is similar to in the case described using Figs. 40, 41A and 41B.

### [8. Installing of Current Sensor to Inside of Household Electrical Appliance]

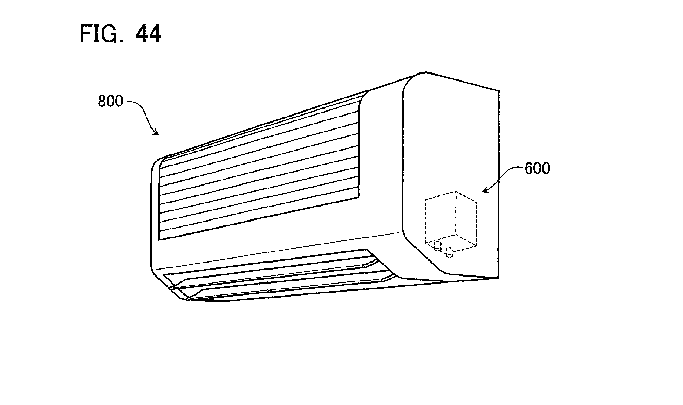

The current sensors according to each of the above-described embodiments may be applied not only to a use of high precision and broad dynamic range such as a smart meter, but also to a use of measuring electrical power of a household electrical appliance. This means they can be utilized for the purpose of a HEMS (Home Energy Management System). Fig. 44 shows an embodiment in the case where the current sensor 600 is applied to a household electrical appliance 800 and a HEMS use. The household electrical appliance 800 also preferably has the measurement-target wiring line 500 and the current sensor 600 in a fixed positioned module configuration. That module configuration can be made similar to those described in Figs. 36 to 43.

### [9. Other Embodiments]

That concludes description of embodiments, but the present invention may be implemented also by the following kinds of modes.

### [Mode 1]

A current sensor, comprising:
a plurality of magneotresistance elements whose resistance value changes by application of an current-induced magnetic field from a current to be measured,
an intermediate value of a range of the current-induced magnetic field at which the magneotresistance element is responsive differing according to the magneotresistance element.

### [Mode 2]

A current sensor, comprising:
a plurality of magneotresistance elements whose resistance value changes by application of an current-induced magnetic field from a current to be measured,
the current-induced magnetic field at which the resistance value of the magneotresistance element attains an intermediate value differing according to the magneotresistance element.

### [Mode 3]

A current sensor, comprising:
a plurality of magneotresistance elements whose resistance value changes by application of an current-induced magnetic field from a current to be measured; and
a first magnetic body that applies a first offset magnetic field substantially parallel to the current-induced magnetic field applied to a first magneotresistance element of the plurality of magneotresistance elements.

### [Mode 4]

The current sensor according to mode 3, further comprising:
a second magnetic body that applies a second offset magnetic field substantially parallel to the current-induced magnetic field applied to a second magneotresistance element different from the first magneotresistance element of the plurality of magneotresistance elements,
wherein the first offset magnetic field and the second offset magnetic field are different.

### [Mode 5]

The current sensor according to mode 4, wherein
a distance of the first magnetic body from the first magneotresistance element is different from a distance of the second magnetic body from the second magneotresistance element.

### [Mode 6]

The current sensor according to mode 4, wherein
a magnetic volume of the first magnetic body is different from a magnetic volume of the second magnetic body.

### [Mode 7]

The current sensor according to mode 4, wherein
area of the first magnetic body is different from area of the second magnetic body.

### [Mode 8]

The current sensor according to mode 3, wherein
the first magnetic body applies a second offset magnetic field substantially parallel to the current-induced magnetic field applied to a second magneotresistance element different from the first magneotresistance element of the plurality of magneotresistance elements, and
the first offset magnetic field and the second offset magnetic field are different.

### [Mode 9]

The current sensor according to mode 8, wherein
a distance of the first magnetic body from the first magneotresistance element is different from a distance of the first magnetic body from the second magneotresistance element.

### [Mode 10]

The current sensor according to mode 8, wherein
a dimension of the first magnetic body adjacent to the first magneotresistance element in a direction of the current-induced magnetic field applied to the first magneotresistance element is different from a dimension of the first magnetic body adjacent to the second magneotresistance element in a direction of the current-induced magnetic field applied to the second magneotresistance element.

### [Mode 11]

The current sensor according to any of mode 3 or modes 8 to 10, wherein
the first magnetic body is disposed adjacently to the first magneotresistance element.

### [Mode 12]

The current sensor according to any of mode 3 or modes 8 to 10, wherein
the first magnetic body is disposed stacked on the first magneotresistance element.

### [Mode 13]

The current sensor according to any of modes 4 to 7, wherein
the first magnetic body and the second magnetic body are disposed adjacently to the first magneotresistance element and the second magneotresistance element, respectively.

### [Mode 14]

The current sensor according to any of modes 4 to 7, wherein
the first magnetic body and the second magnetic body are disposed stacked on the first magneotresistance element and the second magneotresistance element, respectively.

### [Mode 15]

The current sensor according to any of modes 1 to 14, wherein
the plurality of magneotresistance elements each include: a first magnetic layer; a second magnetic layer; a first intermediate layer provided between the first magnetic layer and the second magnetic layer; and a pair of electrode layers.

### [Mode 16]

The current sensor according to any of modes 1 to 14, wherein
the plurality of magneotresistance elements each include: a nonmagnetic body matrix having a plurality of magnetic particles included therein; and a pair of electrode layers.

### [Mode 17]

The current sensor according to mode 3, wherein
the plurality of magneotresistance elements each include: a first magnetic layer whose magnetization direction changes with respect to the current-induced magnetic field; a second magnetic layer; a first intermediate layer provided between the first magnetic layer and the second magnetic layer; and a pair of electrode layers,
the first magnetic body is provided between one of the electrode layers and the first magnetic layer in the first magneotresistance element, and
the first offset magnetic field is offset by exchange coupling.

### [Mode 18]

The current sensor according to mode 17, further comprising:
a second magnetic body that applies a second offset magnetic field substantially parallel to the current-induced magnetic field applied to a second magneotresistance element different from the first magneotresistance element of the plurality of magneotresistance elements,
wherein the first offset magnetic field and the second offset magnetic field are different, and
the second magnetic body is provided between one of the electrode layers and the intermediate layer in the second magneotresistance element.

### [Mode 19]

The current sensor according to mode 18, wherein
the first magneotresistance element further includes a first isolating layer provided between the first magnetic layer and the first magnetic body,
the second magneotresistance element further includes a second isolating layer provided between the first magnetic layer and the second magnetic body, and
film thicknesses of the first isolating layer and the second isolating layer are different.

### [Mode 20]

The current sensor according to any of modes 1 to 19, wherein
of a plurality of different output signals obtained from the plurality of magneotresistance elements with respect to the current-induced magnetic field, an output signal indicating an appropriate output signal is selected and outputted.

### [Mode 21]

The current sensor according to mode 20, wherein
the plurality of output signals are inputted to a multiplexer and one output signal is selected and outputted based on a control signal of the multiplexer.

### [Mode 22]

A smart meter in which the current sensor of any of modes 1 to 21 is installed.

## Claims

1. A current sensor, comprising:
a plurality of magneotresistance elements (100, 200) whose resistance value changes by application of an current-induced magnetic field from a current to be measured; and
a first magnetic body (150) that applies a first offset magnetic field substantially parallel to the current-induced magnetic field applied to a first magneotresistance element of the plurality of magneotresistance elements.

2. The current sensor according to claim 1, wherein
magnetization of the first magnetic body is fixed substantially parallel to the current-induced magnetic field.

3. The current sensor according to claim 1 or 2, further comprising:
a second magnetic body (250) that applies a second offset magnetic field substantially parallel to the current-induced magnetic field applied to a second magneotresistance element different from the first magneotresistance element of the plurality of magneotresistance elements,
wherein the first offset magnetic field and the second offset magnetic field are different.

4. The current sensor according to claim 3, wherein
a distance of the first magnetic body from the first magneotresistance element is different from a distance of the second magnetic body from the second magneotresistance element.

5. The current sensor according to claim 3 or 4, wherein
a magnetic volume of the first magnetic body is different from a magnetic volume of the second magnetic body.

6. The current sensor according to one of claims 3 to 5, wherein
area of the first magnetic body is different from area of the second magnetic body.

7. The current sensor according to one of claims 1 to 6, wherein
the first magnetic body applies a second offset magnetic field substantially parallel to the current-induced magnetic field applied to a second magneotresistance element different from the first magneotresistance element of the plurality of magneotresistance elements, and
the first offset magnetic field and the second offset magnetic field are different.

8. The current sensor according to claim 7, wherein
a distance of the first magnetic body from the first magneotresistance element is different from a distance of the first magnetic body from the second magneotresistance element.

9. The current sensor according to claim 7 or 8, wherein
a dimension of the first magnetic body adjacent to the first magneotresistance element in a direction of the current-induced magnetic field applied to the first magneotresistance element is different from a dimension of the first magnetic body adjacent to the second magneotresistance element in a direction of the current-induced magnetic field applied to the second magneotresistance element.

10. The current sensor according to one of claims 1 to 9, wherein
the plurality of magneotresistance elements each include: a first magnetic layer whose magnetization direction changes with respect to the current-induced magnetic field; a second magnetic layer; a first intermediate layer provided between the first magnetic layer and the second magnetic layer; and a pair of electrode layers, and
the first magnetic body is provided between one of the electrode layers and the first magnetic layer in the first magneotresistance element.

11. The current sensor according to one of claims 1 to 10, wherein
the first magnetic body includes a hard ferromagnetic material.

12. The current sensor according to claim 11, wherein
the hard ferromagnetic material is configured from a first alloy which is any alloy selected from Co-Pt, Fe-Pt, Co-Pd, and Fe-Pd, or a material that has an additional element added to the first alloy.

13. The current sensor according to one of claims 1 to 12, wherein
a direction of magnetization of the first magnetic body is fixed by an antiferromagnetic layer.

14. The current sensor according to claim 13, wherein
the antiferromagnetic layer is configured from a second alloy which is any alloy selected from Ir-Mn, Pt-Mn, Pd-Pt-Mn, Ru-Mn, Rh-Mn, Ru-Rh-Mn, Fe-Mn, Ni-Mn, and Cr-Mn-Pt, or a material that has an additional element added to the second alloy.

15. The current sensor according to one of claims 1 to 14, wherein
of a plurality of different output signals obtained from the plurality of magneotresistance elements with respect to the current-induced magnetic field, an output signal indicating an appropriate output signal is selected and outputted.

16. A current measuring module, comprising:
an electronic substrate module (712); a current sensor fixed on the electronic substrate module; and
a wiring line (500) whose relative position to the electronic substrate module is fixed,
a current to be measured flowing in the wiring line,
the current sensor further comprising:
a plurality of magneotresistance elements (100, 200) whose resistance value changes by application of an current-induced magnetic field from a current to be measured; and
a first magnetic body (150) that applies a first offset magnetic field substantially parallel to the current-induced magnetic field applied to a first magneotresistance element of the plurality of magneotresistance elements.

17. A smart meter in which the current measuring module is installed,
the current measuring module comprising:
an electronic substrate module;
a current sensor fixed on the electronic substrate module; and
a wiring line whose relative position to the electronic substrate module is fixed,
a current to be measured flowing in the wiring line,
the current sensor further comprising:
a plurality of magneotresistance elements whose resistance value changes by application of an current-induced magnetic field from a current to be measured; and
a first magnetic body that applies a first offset magnetic field substantially parallel to the current-induced magnetic field applied to a first magneotresistance element of the plurality of magneotresistance elements.
